# EUROPEAN PATENT SPECIFICATION

(11) **EP 4 539 045 B1**
(45) Date of publication and mention of the grant of the patent: **25.11.2026**
(21) Application number: 23844947.4
(22) Date of filing: 04.05.2023
(51) Int. Cl.: H03M 7/30, G10L 19/24, H03M 7/40, G10L 19/008

(54) **AUDIO ENCODING AND DECODING METHOD AND APPARATUS**
VERFAHREN UND VORRICHTUNG ZUR AUDIOCODIERUNG UND -DECODIERUNG
PROCÉDÉ ET APPAREIL DE CODAGE ET DE DÉCODAGE AUDIO

(30) Priority: 27.07.2022 CN 202210892837; 19.09.2022 CN 202211139716
(43) Date of publication of application: 16.04.2025
(73) Proprietor: Huawei Technologies Co., Ltd., Shenzhen, Guangdong 518129 (CN)
(72) Inventor: WANG, Zhuo, Shenzhen, Guangdong 518129 (CN); FENG, Bin, Shenzhen, Guangdong 518129 (CN); DU, Chunhui, Shenzhen, Guangdong 518129 (CN); FAN, Fan, Shenzhen, Guangdong 518129 (CN)
(74) Representative: Eisenführ Speiser
(86) International application number: PCT/CN2023/092051
(87) International publication number: WO 2024/021732

(56) References cited:
- CN-A- 1 218 334
- CN-A- 101 572 088
- CN-A- 102 014 262
- CN-A- 112 489 666
- US-A1- 2021 027 794
- US-B1- 8 483 699
- US-B2- 11 393 482

## Description

This application claims priority to Chinese Patent Application No. 202210892837.6, filed on July 27, 2022 and entitled "AUDIO ENCODING/DECODING METHOD AND APPARATUS, STORAGE MEDIUM, AND COMPUTER PROGRAM PRODUCT", and to Chinese Patent Application No. 202211139716.0, filed on September 19, 2022 and entitled "AUDIO ENCODING/DECODING METHOD AND APPARATUS, STORAGE MEDIUM, AND COMPUTER PROGRAM PRODUCT".

### TECHNICAL FIELD

This application relates to the audio encoding/decoding field, and in particular, to an audio encoding/decoding method and apparatus, a storage medium, and a computer program product.

### BACKGROUND

As quality of life improves, people have increasing requirements on high-quality audio. To better transmit an audio signal on a limited bandwidth, data compression usually needs to be performed on the audio signal at an encoder side, to obtain a bitstream. Then, the bitstream is transmitted to a decoder side. The decoder side decodes the received bitstream, to reconstruct the audio signal. The reconstructed audio signal is used for playback. However, resources at some decoder sides, for example, some Bluetooth headsets and smart speakers, are limited. How to reduce power consumption at the decoder side in a decoding process becomes an urgent technical problem to be resolved. An audio compression method addressing this problem is presented, for example, in patent literature US 2021/027794 A1.

### SUMMARY

This application provides an audio encoding/decoding method and apparatus, a storage medium, and a computer program product, to reduce power consumption at a decoder side. The technical solutions are as follows.

According to a first aspect, an audio decoding method is provided. The method includes:
if a to-be-decoded audio signal meets a first condition, obtaining a channel decoding mode, where the first condition includes that the audio signal is a dual-channel signal, an encoding bit rate of the audio signal is not less than a bit rate threshold, and a sampling rate of the audio signal is not less than a sampling rate threshold; if the channel decoding mode is a left-channel decoding mode, decoding a left-channel bitstream in a bitstream, to obtain left-channel data of the audio signal; and duplicating the left-channel data to a right channel; and if the channel decoding mode is a right-channel decoding mode, decoding a right-channel bitstream in the bitstream, to obtain right-channel data of the audio signal; and duplicating the right-channel data to a left channel.

Optionally, the method further includes: if the channel decoding mode is neither the left-channel decoding mode nor the right-channel decoding mode, decoding the left-channel bitstream and the right-channel bitstream, to obtain the left-channel data and the right-channel data.

Optionally, the method further includes: if the audio signal does not meet the first condition, when the audio signal is a dual-channel signal, decoding a dual-channel interleaved bitstream in the bitstream, to obtain the left-channel data and the right-channel data.

Optionally, the method further includes: if the audio signal does not meet the first condition, when the audio signal is a mono-channel signal, decoding a mono-channel bitstream in the bitstream, to obtain mono-channel data of the audio signal.

Optionally, the method further includes: obtaining a total data amount of the bitstream; decoding a packet header of the bitstream, to obtain a channel number, the sampling rate, and a frame length of the audio signal; and determining, based on the total data amount, the channel number, the sampling rate, and the frame length, whether the audio signal meets the first condition.

Optionally, the method further includes: decoding a bitstream of side information in the bitstream, to obtain the side information, where the side information includes an encoding codebook identifier; and determining, based on the encoding codebook identifier, a target decoding codebook for decoding from a plurality of decoding codebooks.

Optionally, the plurality of decoding codebooks are as follows:
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
   };
{{11, 0, 5}, {15, 1, 5}, {13, 2, 4}, {13, 3, 4}, {0, 4, 3}, {0, 5, 3}, {0, 6, 3}, {0, 7, 3},
{9, 8, 4}, {9, 9, 4}, {5, 10, 4}, {5, 11, 4}, {14, 12, 4}, {14, 13, 4}, {7, 14, 4}, {7, 15, 4}, {6, 16, 4}, {6, 17, 4}, {3, 18, 4}, {3, 19, 4}, {10, 20, 4}, {10, 21, 4}, {12, 22, 4}, {12, 23, 4}, {2, 24, 4}, {2, 25, 4}, {1, 26, 4}, {1, 27, 4}, {8, 28, 4}, {8, 29, 4}, {4, 30, 41, {4, 31, 4}
   };
{{2, 0, 4}, {2, 1, 4}, {2, 2, 4}, {2, 3, 4}, {1, 4, 4}, {1, 5, 4}, {1, 6, 4}, {1, 7, 4},
{8, 8, 4}, {8, 9, 4}, {8, 10, 4}, {8, 11, 4}, {4, 12, 4}, {4, 13, 4}, {4, 14, 4}, {4, 15, 4}, {0, 16, 2}, {0, 17, 2}, {0, 18, 2}, {0, 19, 2}, {0, 20, 2}, {0, 21, 2}, {0, 22, 2}, {0, 23, 2},
{0, 24, 2}, {0, 25, 2}, {0, 26, 2}, {0, 27, 2}, {0, 28, 2}, {0, 29, 2}, {0, 30, 2}, {0, 31, 2}, {11, 32, 6}, {15, 33, 6}, {14, 34, 5}, {14, 35, 5}, {7, 36, 5}, {7, 37, 5}, {13, 38, 5},
{13, 39, 5}, {12, 40, 41, {12, 41, 4}, {12, 42, 4}, {12, 43, 4}, {6, 44, 41, {6, 45, 4},
{6, 46, 4}, {6, 47, 4}, {3, 48, 4}, {3, 49, 4}, {3, 50, 4}, {3, 51, 4}, {5, 52, 4}, {5, 53, 4}, {5, 54, 4}, {5, 55, 4}, {10, 56, 4}, {10, 57, 4}, {10, 58, 4}, {10, 59, 4}, {9, 60, 4}, {9, 61, 4}, {9, 62, 4}, {9, 63, 4}

   };
{{11, 0, 7}, {15, 1, 7}, {14, 2, 6}, {14, 3, 6}, {7, 4, 6}, {7, 5, 6}, {13, 6, 6}, {13, 7, 6}, {12, 8, 5}, {12, 9, 5}, {12, 10, 5}, {12, 11, 5}, {6, 12, 5}, {6, 13, 5}, {6, 14, 5}, {6, 15, 5}, {3, 16, 5}, {3, 17, 5}, {3, 18, 5}, {3, 19, 5}, {5, 20, 5}, {5, 21, 5}, {5, 22, 5}, {5, 23, 5}, {10, 24, 5}, {10, 25, 5}, {10, 26, 5}, {10, 27, 5}, {9, 28, 5}, {9, 29, 5}, {9, 30, 5}, {9, 31, 5}, {2, 32, 4}, {2, 33, 4}, {2, 34, 4}, {2, 35, 4}, {2, 36, 4}, {2, 37, 4}, {2, 38, 4}, {2, 39, 4}, {1, 40, 4}, {1, 41, 4}, {1, 42, 4}, {1, 43, 4}, {1, 44, 4}, {1, 45, 4}, {1, 46, 4}, {1, 47, 4}, {8, 48, 4}, {8, 49, 4}, {8, 50, 4}, {8, 51, 4}, {8, 52, 4}, {8, 53, 4}, {8, 54, 4}, {8, 55, 4}, {4, 56, 4}, {4, 57, 4}, {4, 58, 4}, {4, 59, 4}, {4, 60, 4}, {4, 61, 4}, {4, 62, 4}, {4, 63, 4}, {0, 64, 1}, {0, 65, 1}, {0, 66, 1}, {0, 67, 1}, {0, 68, 1}, {0, 69, 1}, {0, 70, 1}, {0, 71, 1}, {0, 72, 1}, {0, 73, 1}, {0, 74, 1}, {0, 75, 1}, {0, 76, 1}, {0, 77, 1}, {0, 78, 1}, {0, 79, 1}, {0, 80, 1}, {0, 81, 1}, {0, 82, 1}, {0, 83, 1}, {0, 84, 1}, {0, 85, 1}, {0, 86, 1}, {0, 87, 1}, {0, 88, 1}, {0, 89, 1}, {0, 90, 1}, {0, 91, 1}, {0, 92, 1}, {0, 93, 1}, {0, 94, 1}, {0, 95, 1}, {0, 96, 1}, {0, 97, 1}, {0, 98, 1}, {0, 99, 1}, {0, 100, 1}, {0, 101, 1}, {0, 102, 1}, {0, 103, 1}, {0, 104, 1}, {0, 105, 1}, {0, 106, 1}, {0, 107, 1}, {0, 108, 1}, {0, 109, 1}, {0, 110, 1}, {0, 111, 1}, {0, 112, 1}, {0, 113, 1}, {0, 114, 1}, {0, 115, 1}, {0, 116, 1}, {0, 117, 1}, {0, 118, 1}, {0, 119, 1}, {0, 120, 1}, {0, 121, 1}, {0, 122, 1}, {0, 123, 1}, {0, 124, 1},
{0, 125, 1}, {0, 126, 1}, {0, 127, 1}
   };
{{11, 0, 5}, {15, 1, 5}, {14, 2, 4}, {14, 3, 4}, {0, 4, 3}, {0, 5, 3}, {0, 6, 3}, {0, 7, 3}, {7, 8, 4}, {7, 9, 4}, {9, 10, 4}, {9, 11, 4}, {10, 12, 4}, {10, 13, 4}, {13, 14, 4}, {13, 15, 4}, {3, 16, 4}, {3, 17, 4}, {8, 18, 4}, {8, 19, 4}, {6, 20, 4}, {6, 21, 4}, {12, 22, 4}, {12, 23, 4}, {4, 24, 4}, {4, 25, 4}, {1, 26, 4}, {1, 27, 4}, {2, 28, 4}, {2, 29, 4}, {5, 30, 4}, {5, 31, 4}
   };
{{2, 0, 4}, {2, 1, 4}, {5, 2, 4}, {5, 3, 4}, {0, 4, 3}, {0, 5, 3}, {0, 6, 3}, {0, 7, 3}, {10, 8, 5}, {13, 9, 5}, {7, 10, 5}, {14, 11, 5}, {12, 12, 4}, {12, 13, 4}, {3, 14, 4}, {3, 15, 4}, {8, 16, 4}, {8, 17, 4}, {9, 18, 4}, {9, 19, 4}, {6, 20, 4}, {6, 21, 4}, {11, 22, 5}, {15, 23, 5}, {4, 24, 3}, {4, 25, 3}, {4, 26, 3}, {4, 27, 3}, {1, 28, 3}, {1, 29, 3}, {1, 30, 3}, {1, 31, 3}
   };
{{4, 0, 4}, {4, 1, 4}, {1, 2, 4}, {1,3,4}, {2, 4, 4}, {2, 5, 4}, {5, 6, 4}, {5, 7, 4}, {0, 8, 2}, {0, 9, 2}, {0, 10, 2}, {0, 11, 2}, {0, 12, 2}, {0, 13, 2}, {0, 14, 2}, {0, 15, 2}, {10, 16, 5}, {13, 17, 5}, {7, 18, 5}, {14, 19, 5}, {12, 20, 4}, {12, 21, 4}, {3, 22, 4}, {3, 23, 4}, {8, 24, 4}, {8, 25, 4}, {9, 26, 4}, {9, 27, 4}, {6, 28, 4}, {6, 29, 4}, {11, 30, 5}, {15, 31, 5},
   };
{{10, 0, 6}, {13, 1, 6}, {7, 2, 6}, {14, 3, 6}, {12, 4, 5}, {12, 5, 5}, {3, 6, 5}, {3, 7, 5}, {8, 8, 5}, {8, 9, 5}, {9, 10, 5}, {9, 11, 5}, {6, 12, 5}, {6, 13, 5}, {11, 14, 6}, {15, 15, 6}, {4, 16, 4}, {4, 17, 4}, {4, 18, 4}, {4, 19, 4}, {1, 20, 4}, {1, 21, 4}, {1, 22, 4}, {1, 23, 4}, {2, 24, 4}, {2, 25, 4}, {2, 26, 4}, {2, 27, 4}, {5, 28, 4}, {5, 29, 4}, {5, 30, 4}, {5, 31, 4}, {0, 32, 1}, {0, 33, 1}, {0, 341}, {0, 35, 1}, {0, 36, 1}, {0, 37, 1}, {0, 38, 1}, {0, 39, 1}, {0, 40, 1}, {0, 41, 1}, {0, 42, 1}, {0, 43, 1}, {0, 44, 1}, {0, 45, 1}, {0, 46, 1}, {0, 47, 1}, {0, 48, 1}, {0, 49, 1}, {0, 50, 1}, {0, 51, 1}, {0, 52, 1}, {0, 53, 1}, {0, 54, 1}, {0, 55, 1}, {0, 56, 1}, {0, 57, 1}, {0, 58, 1}, {0, 59, 1}, {0, 60, 1}, {0, 61, 1}, {0, 62, 1}, {0, 63, 1}
   };
{{4, 0, 4}, {4, 1, 4}, {4, 2, 4}, {4, 3, 4}, {6, 4, 6}, {7, 5, 6}, {5, 6, 5}, {5, 7, 5}, {3, 8, 3}, {3, 9, 3}, {3, 10, 3}, {3, 11, 3}, {3, 12, 3}, {3, 13, 3}, {3, 14, 3}, {3, 15, 3}, {2, 16, 2}, {2, 17, 2}, {2, 18, 2}, {2, 19, 2}, {2, 20, 2}, {2, 21, 2}, {2, 22, 2}, {2, 23, 2}, {2, 24, 2}, {2, 25, 2}, {2, 26, 2}, {2, 27, 2}, {2, 28, 2}, {2, 29, 2}, {2, 30, 2}, {2, 31, 2}, {1, 32, 2}, {1, 33, 2}, {1, 34, 2}, {1, 35, 2}, {1, 36, 2}, {1, 37, 2}, {1, 38, 2}, {1, 39, 2}, {1, 40, 2}, {1, 41, 2}, {1, 42, 2}, {1, 43, 2}, {1, 44, 2}, {1, 45, 2}, {1, 46, 2}, {1, 47, 2}, {0, 48, 2}, {0, 49, 2}, {0, 50, 2}, {0, 51, 2}, {0, 52, 2}, {0, 53, 2}, {0, 54, 2}, {0, 55, 2}, {0, 56, 2}, {0, 57, 2}, {0, 58, 2}, {0, 59, 2}, {0, 60, 2}, {0, 61, 2}, {0, 62, 2}, {0, 63,2}
   };
{{2, 0, 3}, {2, 1, 3}, {2, 2, 3}, {2, 3, 3}, {3, 4, 3}, {3, 5, 3}, {3, 6, 3}, {3, 7, 3}, {5, 8, 4}, {5, 9, 4}, {6, 10, 5}, {7, 11, 5}, {4, 12, 3}, {4, 13, 3}, {4, 14, 3}, {4, 15, 3}, {1, 16, 2}, {1, 17, 2}, {1, 18, 2}, {1, 19, 2}, {1, 20, 2}, {1, 21, 2}, {1, 22, 2}, {1, 23, 2}, {0, 24, 2}, {0, 25, 2}, {0, 26, 2}, {0, 27, 2}, {0, 28, 2}, {0, 29, 2}, {0, 30, 2}, {0, 31, 2}
   };
{{0, 0, 1}, {0, 1, 1}, {0, 2, 1}, {0, 3, 1}, {0, 4, 1}, {0, 5, 1}, {0, 6, 1}, {0, 7, 1}, {0, 8, 1}, {0, 9, 1}, {0, 10, 1}, {0, 11, 1}, {0, 12, 1}, {0, 13, 1}, {0, 14, 1}, {0, 15, 1}, {0, 16, 1}, {0, 17, 1}, {0, 18, 1}, {0, 19, 1}, {0, 20, 1}, {0, 21, 1}, {0, 22, 1}, {0, 23, 1}, {0, 24, 1}, {0, 25, 1}, {0, 26, 1}, {0, 27, 1}, {0, 28, 1}, {0, 29, 1}, {0, 30, 1}, {0, 31, 1}, {5, 32, 5}, {5, 33, 5}, {6, 34, 6}, {7, 35, 6}, {4, 36, 4}, t4, 37, 41, {4, 38, 41, {4, 39, 41, {1, 40, 3}, {1, 41, 3}, {1, 42, 3}, {1, 43, 3}, {1, 44, 3}, {1, 45, 3}, {1, 46, 3}, {1, 47, 3}, {2, 48, 3}, {2, 49, 3}, {2, 50, 3}, {2, 51, 3}, {2, 52, 3}, {2, 53, 3}, {2, 54, 3}, {2, 55, 3}, {3, 56, 3}, {3, 57, 3}, {3, 58, 3}, {3, 59, 3}, {3, 60, 3}, {3, 61, 3}, {3, 62, 3}, {3, 63, 3}
   }; and
{{0, 0, 3}, {1, 1, 3}, {2, 2, 3}, {3, 3, 3}, {4, 4, 3}, {5, 5, 3}, {6, 6, 3}, {7, 7, 3}
   }.

According to a second aspect, an audio encoding method is provided. The method includes:
if a to-be-encoded audio signal meets a first condition, encoding left-channel data of the audio signal into a bitstream, and encoding right-channel data of the audio signal into the bitstream, where the first condition includes that the audio signal is a dual-channel signal, an encoding bit rate of the audio signal is not less than a bit rate threshold, and a sampling rate of the audio signal is not less than a sampling rate threshold.

Optionally, the method further includes: if the audio signal does not meet the first condition, when the audio signal is a dual-channel signal, encoding the left-channel data and the right-channel data into the bitstream in a dual-channel interleaving encoding scheme.

Optionally, the method further includes: if the audio signal does not meet the first condition, when the audio signal is a mono-channel signal, encoding mono-channel data of the audio signal into the bitstream.

Optionally, the encoding the left-channel data of the audio signal into the bitstream includes:
obtaining a quantization level measurement factor of each of a plurality of sub-bands, where the quantization level measurement factor indicates an average number of bits for encoding each spectral value in a corresponding sub-band, and the plurality of sub-bands are a plurality of sub-bands to which quantized spectrum data included in the left-channel data is allocated;
grouping the plurality of sub-bands into a plurality of groups of sub-bands based on the quantization level measurement factors of the plurality of sub-bands, where quantization level measurement factors of sub-bands in a same group are the same;
determining, from a plurality of encoding codebooks based on a quantization level measurement factor of each group of sub-bands, a target encoding codebook corresponding to each group of sub-bands, and determining a bitstream of spectral values in each group of sub-bands, where the target encoding codebook is an encoding codebook used to encode spectral values in a corresponding group of sub-bands; and
encoding, as a type of side information of the left-channel data, an identifier of the target encoding codebook corresponding to each group of sub-bands into the bitstream.

Optionally, the determining, from a plurality of encoding codebooks based on a quantization level measurement factor of each group of sub-bands, a target encoding codebook corresponding to each group of sub-bands, and determining a bitstream of spectral values in each group of sub-bands includes:
for any one of the plurality of groups of sub-bands, if a quantization level measurement factor of the any group of sub-bands is a first value, separately encoding spectral values in the any group of sub-bands by using a plurality of first encoding codebooks in the plurality of encoding codebooks, to obtain a plurality of first candidate spectral bitstreams that one-to-one correspond to the plurality of first encoding codebooks; and
determining, as a bitstream of the spectral values in the any group of sub-bands, a first candidate spectral bitstream with a minimum total number of bits in the plurality of first candidate spectral bitstreams, and determining, as a target encoding codebook corresponding to the any group of sub-bands, a first encoding codebook corresponding to the first candidate spectral bitstream with the minimum total number of bits.

Optionally, the first value is 1.

The separately encoding spectral values in the any group of sub-bands by using a plurality of first encoding codebooks in the plurality of encoding codebooks includes:
combining every four spectral values in the any group of sub-bands into a binary number; and
separately encoding, by using the plurality of first encoding codebooks, a decimal number represented by the binary number.

The plurality of first encoding codebooks are as follows:
{{0, 0, 4}, {1, 1, 4}, {2, 2, 4}, {3, 3, 4}, {4, 4, 4}, t5, 5, 41, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
   };
{{0, 1, 3}, {1, 13, 4}, {2, 12, 4}, {3, 9, 4}, {4, 15, 4}, {5, 5, 4}, {6, 8, 4}, {7, 7, 4},
{8, 14, 4}, {9, 4, 4}, {10, 10, 4}, {11, 0, 5}, {12, 11, 4}, {13, 1, 4}, {14, 6, 4}, {15, 1, 5}
   };
{{0, 1, 2}, {1, 1, 4}, {2, 0, 4}, {3, 12, 4}, {4, 3, 4}, {5, 13, 4}, {6, 11, 4}, {7, 18, 5},
{8, 2, 4}, {9, 15, 4}, {10, 14, 4}, {11, 32, 6}, {12, 10, 4}, {13, 19, 5}, {14, 17, 5}, {15, 33, 6}
   }; and
{{0, 1, 1}, {1, 5, 4}, {2, 4, 4}, {3, 4, 5}, {4, 7, 4}, {5, 5, 5}, {6, 3, 5}, {7, 2, 6},
{8, 6, 4}, {9, 7, 5}, {10, 6, 5}, {11, 0, 7}, {12, 2, 5}, {13, 3, 6}, {14, 1, 6}, {15, 1, 7}
   }.

Optionally, the determining, from a plurality of encoding codebooks based on a quantization level measurement factor of each group of sub-bands, a target encoding codebook corresponding to each group of sub-bands, and determining a bitstream of spectral values in each group of sub-bands includes:
for any one of the plurality of groups of sub-bands, if a quantization level measurement factor of the any group of sub-bands is a second value, separately encoding spectral values in the any group of sub-bands by using a plurality of second encoding codebooks in the plurality of encoding codebooks, to obtain a plurality of second candidate spectral bitstreams that one-to-one correspond to the plurality of second encoding codebooks; and
determining, as a bitstream of the spectral values in the any group of sub-bands, a second candidate spectral bitstream with a minimum total number of bits in the plurality of second candidate spectral bitstreams, and determining, as a target encoding codebook corresponding to the any group of sub-bands, a second encoding codebook corresponding to the second candidate spectral bitstream with the minimum total number of bits.

Optionally, the second value is 2.

The separately encoding spectral values in the any group of sub-bands by using a plurality of second encoding codebooks in the plurality of encoding codebooks includes:
combining every two spectral values in the any group of sub-bands into a binary number; and
separately encoding, by using the plurality of second encoding codebooks, a decimal number represented by the binary number.

The plurality of second encoding codebooks are as follows:
{{0, 1, 3}, {1, 13, 4}, {2, 14, 4}, {3, 8, 4}, {4, 12, 4}, {5, 15, 4}, {6, 10, 4}, {7, 4, 4}, {8, 9, 4}, {9, 5, 4}, {10, 6, 4}, {11, 0, 5}, {12, 11, 4}, {13, 7, 4}, {14, 1, 4}, {15, 1, 5}
   };
{{0, 1, 3}, {1, 7, 3}, {2, 0, 4}, {3, 7, 4}, {4, 6, 3}, {5, 1, 4}, {6, 10, 4}, {7, 10, 5},
{8, 8, 4}, {9, 9, 4}, {10, 8, 5}, {11, 22, 5}, {12, 6, 4}, {13, 9, 5}, {14, 11, 5}, {15, 23, 5}
   };
{{0, 1, 2}, {1, 1, 4}, {2, 2, 4}, {3, 11, 4}, {4, 0, 4}, {5, 3, 4}, {6, 14, 4}, {7, 18, 5},
{8, 12, 4}, {9, 13, 4}, {10, 16, 5}, {11, 30, 5}, {12, 10, 4}, {13, 17, 5}, {14, 19, 5}, {15, 31, 5}
   }; and
{{0, 1, 1}, {1, 5, 4}, {2, 6, 4}, {3, 3, 5}, {4, 4, 4}, {5, 7, 4}, {6, 6, 5}, {7, 2, 6},
{8, 4, 5}, {9, 5, 5}, {10, 0, 6}, {11, 14, 6}, {12, 2, 5}, {13, 1, 6}, {14, 3, 6}, {15, 15, 6}
   }.

Optionally, the determining, from a plurality of encoding codebooks based on a quantization level measurement factor of each group of sub-bands, a target encoding codebook corresponding to each group of sub-bands, and determining a bitstream of spectral values in each group of sub-bands includes:
for any one of the plurality of groups of sub-bands, if a quantization level measurement factor of the any group of sub-bands is a third value, separately encoding spectral values in the any group of sub-bands by using a plurality of third encoding codebooks in the plurality of encoding codebooks, to obtain a plurality of third candidate spectral bitstreams that one-to-one correspond to the plurality of third encoding codebooks; and
determining, as a bitstream of the spectral values in the any group of sub-bands, a third candidate spectral bitstream with a minimum total number of bits in the plurality of third candidate spectral bitstreams, and determining, as a target encoding codebook corresponding to the any group of sub-bands, a third encoding codebook corresponding to the third candidate spectral bitstream with the minimum total number of bits.

Optionally, the determining, from a plurality of encoding codebooks based on a quantization level measurement factor of each group of sub-bands, a target encoding codebook corresponding to each group of sub-bands, and determining a bitstream of spectral values in each group of sub-bands includes:
for any one of the plurality of groups of sub-bands, if a quantization level measurement factor of the any group of sub-bands is a fourth value, separately encoding a first part of bits in each spectral value in the any group of sub-bands by using the plurality of third encoding codebooks, to obtain a plurality of first-part candidate bitstreams that one-to-one correspond to the plurality of third encoding codebooks;
determining, as a bitstream of the first part of bits, a first-part candidate bitstream with a minimum total number of bits in the plurality of first-part candidate bitstreams, and determining, as a target encoding codebook corresponding to the any group of sub-bands, a third encoding codebook corresponding to the first-part candidate bitstream with the minimum total number of bits; and
performing uniform quantization encoding on a second part of bits other than the first part of bits in each spectral value in the any group of sub-bands, to obtain a bitstream of the second part of bits.

Optionally, the first part of bits are N high-order bits in the spectral value, and the second part of bits are M low-order bits in the spectral value, where M is equal to the quantization level measurement factor of the any group of sub-bands minus the third value.

Optionally, the third value is 3.

The separately encoding spectral values in the any group of sub-bands by using a plurality of third encoding codebooks in the plurality of encoding codebooks includes:
separately encoding all of the spectral values in the any group of sub-bands by using the plurality of third encoding codebooks.

The plurality of third encoding codebooks are as follows:
{{0, 3, 2}, {1, 2, 2}, {2, 1, 2}, {3, 1, 3}, {4, 0, 4}, {5, 3, 5}, {6, 4, 6}, {7, 5, 6}
   };
{{0, 3, 2}, {1, 2, 2}, {2, 0, 3}, {3, 1, 3}, {4, 3, 3}, {5, 4, 4}, {6, 10, 5}, {7, 11, 5}
   };
{{0, 0, 1}, {1, 5, 3}, {2, 6, 3}, {3, 7, 3}, {4, 9, 4}, {5, 16, 5}, {6, 34, 6}, {7, 35, 6}
   }; and
{{0, 0, 3}, {1, 1, 3}, {2, 2, 3}, {3, 3, 3}, {4, 4, 3}, {5, 5, 3}, {6, 6, 3}, {7, 7, 3}
   }.

In the audio encoding/decoding method provided in this application, when the audio signal is a dual-channel signal, even if the bitstream includes the left-channel bitstream and the right-channel bitstream, based on the channel decoding mode, the left-channel bitstream is decoded but the right-channel bitstream is not decoded, or the right-channel bitstream is decoded but the left-channel bitstream is not decoded in a decoding process. Therefore, power consumption at a decoder side is reduced when resources at the decoder side are limited. Correspondingly, an encoder side can also sequentially encode the left-channel data and the right-channel data based on the condition met by the audio signal, rather than performing encoding in the dual-channel interleaving encoding scheme or a dual-channel deinterleaving encoding scheme. It can be learned that a coding scheme in this solution is more flexible.

According to a third aspect, an audio decoding apparatus is provided. The audio decoding apparatus has a function of implementing the audio decoding method in the first aspect. The audio decoding apparatus includes one or more modules, and the one or more modules are configured to implement the audio decoding method in the first aspect.

According to a fourth aspect, an audio encoding apparatus is provided. The audio encoding apparatus has a function of implementing the audio encoding method in the second aspect. The audio encoding apparatus includes one or more modules, and the one or more modules are configured to implement the audio encoding method in the second aspect.

According to a fifth aspect, an audio decoding device is provided. The audio decoding device includes a processor and a memory. The memory is configured to store a program used to perform the audio decoding method in the first aspect, and store data used to implement the audio decoding method in the first aspect. The processor is configured to execute the program stored in the memory. The audio decoding device may further include a communication bus, and the communication bus is configured to establish a connection between the processor and the memory.

According to a sixth aspect, an audio encoding device is provided. The audio encoding device includes a processor and a memory. The memory is configured to store a program used to perform the audio encoding method in the second aspect, and store data used to implement the audio encoding method in the second aspect. The processor is configured to execute the program stored in the memory. The audio decoding device may further include a communication bus, and the communication bus is configured to establish a connection between the processor and the memory.

According to a seventh aspect, a computer-readable storage medium is provided. The computer-readable storage medium stores instructions. When the instructions are run on a computer, the computer is enabled to perform the audio decoding method in the first aspect or the audio encoding method in the second aspect.

According to an eighth aspect, a computer program product including instructions is provided. When the instructions are run on a computer, the computer is enabled to perform the audio decoding method in the first aspect or the audio encoding method in the second aspect.

Technical effect achieved in the second aspect to the eighth aspect is similar to technical effect achieved by corresponding technical means in the first aspect. Details are not described herein again.

### BRIEF DESCRIPTION OF DRAWINGS

FIG. 1 is a diagram of a Bluetooth interconnection scenario according to an embodiment of this application;
FIG. 2 is a diagram of a system architecture related to an audio encoding/decoding method according to an embodiment of this application;
FIG. 3A and FIG. 3B are a diagram of an audio encoding/decoding overall framework according to an embodiment of this application;
FIG. 4 is a diagram of a structure of a codec device according to an embodiment of this application;
FIG. 5 is a flowchart of an audio encoding method according to an embodiment of this application;
FIG. 6 is a diagram of a structure of a bitstream according to an embodiment of this application;
FIG. 7 is a diagram of another format of a bitstream according to an embodiment of this application;
FIG. 8 is a flowchart of another audio encoding method according to an embodiment of this application;
FIG. 9 is a flowchart of an audio decoding method according to an embodiment of this application;
FIG. 10 is a flowchart of another audio decoding method according to an embodiment of this application;
FIG. 11 is a diagram of a structure of an audio decoding apparatus according to an embodiment of this application; and
FIG. 12 is a diagram of a structure of an audio encoding apparatus according to an embodiment of this application.

### DESCRIPTION OF EMBODIMENTS

To make objectives, technical solutions, and advantages of embodiments of this application clearer, the following further describes implementations of this application in detail with reference to accompanying drawings.

A network architecture and a service scenario that are described in embodiments of this application are intended to describe technical solutions in embodiments of this application more clearly, and do not constitute any limitation on the technical solutions provided in embodiments of this application. A person of ordinary skill in the art may learn that the technical solutions provided in embodiments of this application are also applicable to a similar technical problem as the network architecture evolves and a new service scenario emerges.

First, an implementation environment and background knowledge related to embodiments of this application are described.

As wireless Bluetooth devices like true wireless stereo (true wireless stereo, TWS) headsets, smart speakers, and smart watches are widely popularized and used in people's daily life, people's requirements for high-quality audio playing experience in various scenarios become increasingly urgent, especially in environments where Bluetooth signals are vulnerable to interference, for example, subways, airports, and railway stations. In a Bluetooth interconnection scenario, because a Bluetooth channel connecting an audio sending device and an audio receiving device limits a size of transmitted data. An audio encoder in the audio sending device performs data compression on an audio signal, and then transmits the audio signal to the audio receiving device. The compressed audio signal can be played only after being decoded by an audio decoder in the audio receiving device. It can be learned that, while the wireless Bluetooth devices are popularized, various audio codecs are also promoted to flourish.

Currently, Bluetooth audio codecs include a sub-band encoder (sub-band coding, SBC), an advanced audio encoder (advanced audio coding, AAC), an aptX series encoder, a low-latency high-definition audio codec (low-latency hi-definition audio codec, LHDC), a low-energy low-latency LC3 audio codec, LC3plus, and the like.

It should be understood that an audio encoding/decoding method provided in embodiments of this application may be applied to the audio sending device (namely, an encoder side) and the audio receiving device (namely, a decoder side) in the Bluetooth interconnection scenario.

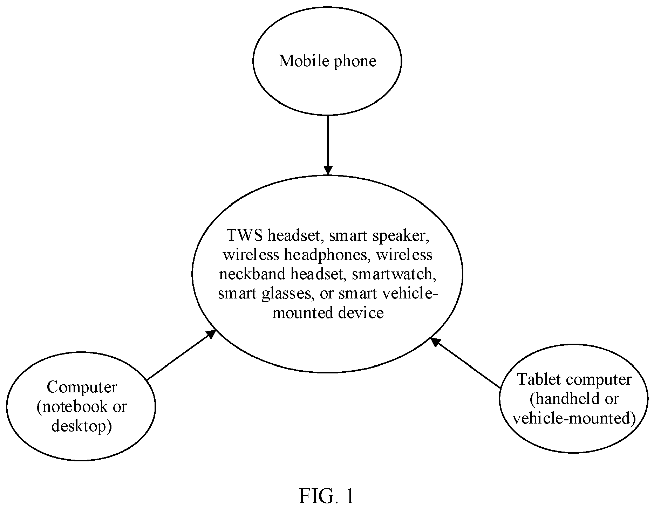

FIG. 1 is a diagram of a Bluetooth interconnection scenario according to an embodiment of this application. Refer to FIG. 1. An audio sending device in the Bluetooth interconnection scenario may be a mobile phone, a computer, a tablet computer, or the like. The computer may be a notebook computer, a desktop computer, or the like, and the tablet computer may be a handheld tablet computer, a vehicle-mounted tablet computer, or the like. An audio receiving device in the Bluetooth interconnection scenario may be a TWS headset, a smart speaker, wireless headphones, a wireless neckband headset, a smartwatch, smart glasses, a smart vehicle-mounted device, or the like. In some other embodiments, the audio receiving device in the Bluetooth interconnection scenario may alternatively be a mobile phone, a computer, a tablet computer, or the like.

It should be noted that, in addition to the Bluetooth interconnection scenario, the audio encoding/decoding method provided in embodiments of this application may also be applied to another device interconnection scenario. In other words, a system architecture and a service scenario that are described in embodiments of this application are intended to describe the technical solutions in embodiments of this application more clearly, and do not constitute a limitation on the technical solutions provided in embodiments of this application. A person of ordinary skill in the art may learn that the technical solutions provided in embodiments of this application are also applicable to a similar technical problem as the system architecture evolves and a new service scenario emerges.

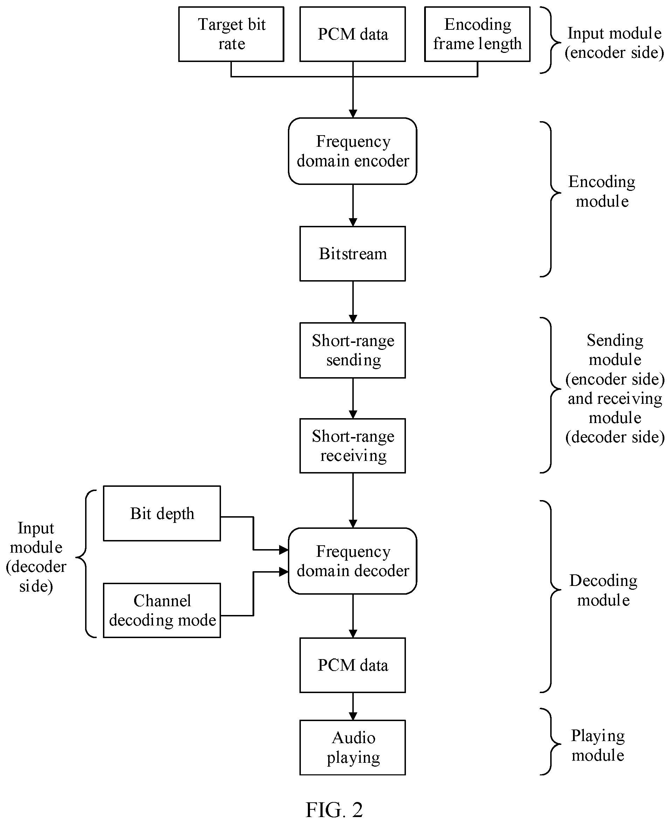

FIG. 2 is a diagram of a system architecture related to an audio encoding/decoding method according to an embodiment of this application. Refer to FIG. 2. The system includes an encoder side and a decoder side. The encoder side includes an input module, an encoding module, and a sending module. The decoder side includes a receiving module, an input module, a decoding module, and a playing module.

At the encoder side, a user determines one encoding mode from two encoding modes based on a usage scenario, where the two encoding modes are a low-latency encoding mode and a high-sound-quality encoding mode. Encoding frame lengths of the two encoding modes are 5 ms and 10 ms respectively. For example, when the usage scenario is playing a game, live broadcasting, or making a call, the user may select the low-latency encoding mode; or when the usage scenario is enjoying music through a headset or a speaker, the user may select the high-sound-quality encoding mode. The user further needs to provide a to-be-encoded audio signal (pulse code modulation (pulse code modulation, PCM) data shown in FIG. 2) to the encoder side. In addition, the user further needs to set a target bit rate of a bitstream obtained through encoding, namely, an encoding bit rate of the audio signal. A higher target bit rate indicates better sound quality, but poorer anti-interference performance of a bitstream in a short-range transmission process. A lower target bit rate indicates poorer sound quality, but better anti-interference performance of a bitstream in a short-range transmission process. In brief, the input module at the encoder side obtains the encoding frame length, the encoding bit rate, and the to-be-encoded audio signal that are submitted by the user.

The input module at the encoder side inputs data submitted by the user into a frequency domain encoder of the encoding module.

The frequency domain encoder of the encoding module performs encoding based on the received data, to obtain a bitstream. A frequency domain encoder side analyzes the to-be-encoded audio signal, to obtain signal characteristics (including a mono/dual-channel signal, a stable/non-stable signal, a full-bandwidth/narrow-bandwidth signal, a subjective/objective signal, and the like). The audio signal enters a corresponding encoding processing submodule based on the signal characteristics and a bit rate level (namely, the encoding bit rate). The encoding processing submodule encodes the audio signal, and packages a packet header (including a sampling rate, a channel number, an encoding mode, a frame length, and the like) of the bitstream, to finally obtain the bitstream.

The sending module at the encoder side sends the bitstream to the decoder side. Optionally, the sending module is a short-range sending module shown in FIG. 2 or another type of sending module. This is not limited in embodiments of this application.

At the decoder side, after receiving the bitstream, the receiving module at the decoder side sends the bitstream to a frequency domain decoder of the decoding module, and notifies the input module at the decoder side to obtain a configured bit depth, a configured channel decoding mode, or the like. Optionally, the receiving module is a short-range receiving module shown in FIG. 2 or another type of receiving module. This is not limited in embodiments of this application.

The input module at the decoder side inputs obtained information such as the bit depth and the sound channel decoding mode into the frequency domain decoder of the decoding module.

The frequency domain decoder of the decoding module decodes the bitstream based on the bit depth, the channel decoding mode, and the like, to obtain required audio data (the PCM data shown in FIG. 2), and sends the obtained audio data to the playing module. The playing module plays audio. The sound channel decoding mode indicates a channel that needs to be decoded.

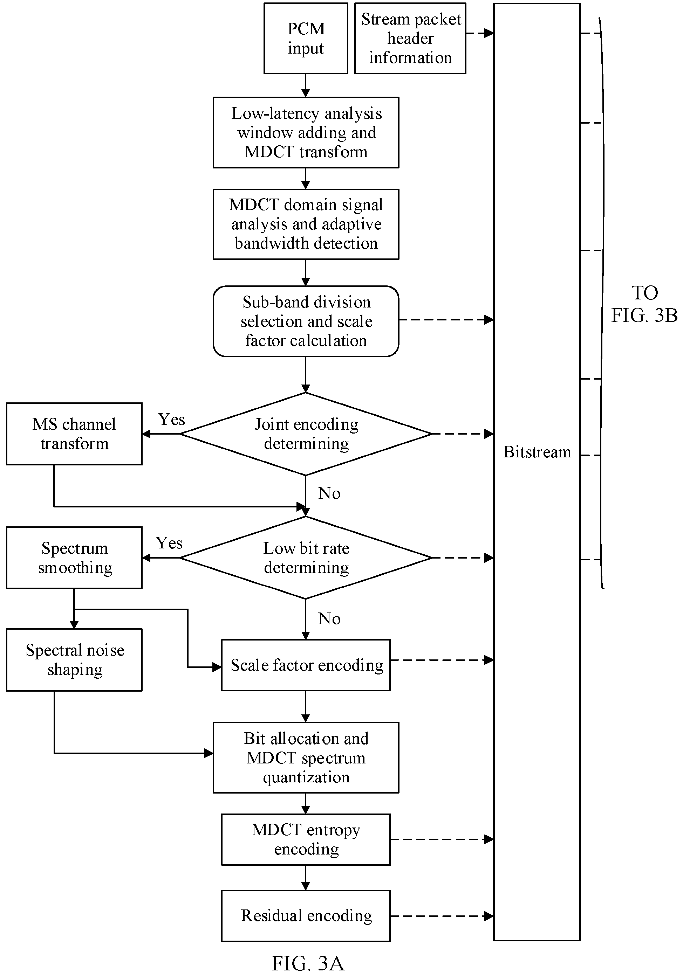

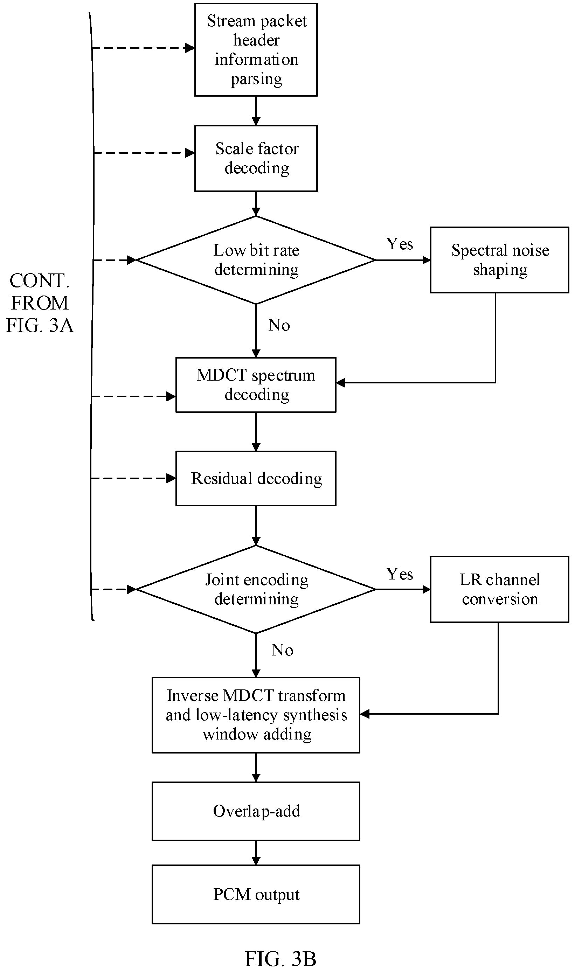

FIG. 3A and FIG. 3B are a diagram of an audio encoding/decoding overall framework according to an embodiment of this application. Refer to FIG. 3A and FIG. 3B. An encoding procedure at an encoder side includes the following steps.

### (1) PCM input module

PCM data is input. The PCM data is mono-channel data or dual-channel data, and a bit depth may be 16 bits (bits), 24 bits, a 32-bit floating point number, or a 32-bit fixed point number. Optionally, the PCM input module converts the input PCM data to a same bit depth, for example, a bit depth of 24 bits, performs deinterleaving on the PCM data, and then places the deinterleaved PCM data on a left channel and a right channel.

### (2) Low-latency analysis window adding module and modified discrete cosine transform (modified discrete cosine transform, MDCT) transform module

A low-latency analysis window is added to and MDCT transform is performed on the PCM data processed in step (1), to obtain spectrum data in an MDCT domain. The window is added to prevent spectrum leakage.

### (3) MDCT domain signal analysis module and adaptive bandwidth detection module

The MDCT domain signal analysis module takes effect in a full bit rate scenario, and the adaptive bandwidth detection module is activated at a low bit rate (for example, a bit rate<150 kbps/channel). First, bandwidth detection is performed on the spectrum data in the MDCT domain obtained in step (2), to obtain a cut-off frequency or an effective bandwidth. Then, signal analysis is performed on spectrum data within the effective bandwidth, that is, whether frequency distribution is centralized or even is analyzed, to obtain an energy concentration, and a flag (flag) indicating whether the to-be-encoded audio signal is an objective signal or a subjective signal (the flag of the objective signal is 1, and the flag of the subjective signal is 0) is obtained based on the energy concentration. If the audio signal is the objective signal, spectral noise shaping (spectral noise shaping, SNS) processing and MDCT spectrum smoothing are not performed on a scale factor at a low bit rate, because this reduces encoding effect of the objective signal. Then, whether to perform a sub-band cut-off operation in the MDCT domain is determined based on a bandwidth detection result and the flag of the subjective signal and the flag of the objective signal. If the audio signal is the objective signal, the sub-band cut-off operation is not performed; or if the audio signal is the subjective signal and the bandwidth detection result is identified as 0 (in a full bandwidth), the sub-band cut-off operation is determined based on a bit rate; or if the audio signal is the subjective signal and the bandwidth detection result is not identified as 0 (that is, a bandwidth is less than half of a limited bandwidth of a sampling rate), the sub-band cut-off operation is determined based on the bandwidth detection result.

### (4) Sub-band division selection and scale factor calculation module

Based on a bit rate level, and the flag of the subjective signal and the flag of objective signal and the cut-off frequency that are obtained in step (3), an optimal sub-band division manner is selected from a plurality of sub-band division manners, and a total number of sub-bands for encoding the audio signal is obtained. In addition, an envelope of a spectrum is obtained through calculation, that is, a scale factor corresponding to the selected sub-band division manner is calculated.

### (5) MS channel transform module

For the dual-channel PCM data, joint encoding determining is performed based on the scale factor calculated in step (4), that is, whether to perform MS channel transform on the left-channel data and the right-channel data is determined.

### (6) Spectrum smoothing module and scale factor-based spectral noise shaping module

The spectrum smoothing module performs MDCT spectrum smoothing based on a setting of the low bit rate (for example, the bit rate<150 kbps/channel), and the spectral noise shaping module performs, based on the scale factor, spectral noise shaping on data on which spectrum smoothing is performed, to obtain an adjustment factor, where the adjustment factor is used to quantize a spectral value of the audio signal. The setting of the low bit rate is controlled by a low bit rate determining module. When the setting of the low bit rate is not met, spectrum smoothing and spectral noise shaping do not need to be performed.

### (7) Scale factor encoding module

Differential encoding or entropy encoding is performed on scale factors of a plurality of sub-bands based on distribution of the scale factors.

### (8) Bit allocation and MDCT spectrum quantization and entropy encoding module

Based on the scale factor obtained in step (4) and the adjustment factor obtained in step (6), encoding is controlled to be in a constant bit rate (constant bit rate, CBR) encoding mode according to a bit allocation strategy of rough estimation and precise estimation, and quantization and entropy encoding are performed on an MDCT spectral value.

### (9) Residual encoding module

If bit consumption in step (8) does not reach a target bit, importance sorting is further performed on sub-bands that are not encoded, and a bit is preferably allocated to encoding of an MDCT spectral value of an important sub-band.

### (10) Stream packet header information packaging module

Packet header information includes an audio sampling rate (for example, 44.1 kHz/48 kHz/88.2 kHz/96 kHz), channel information (for example, mono channel and dual channel), an encoding frame length (for example, 5 ms and 10 ms), an encoding mode (for example, a time domain mode, a frequency domain mode, a time domain-to-frequency domain mode, or a frequency domain-to-time domain mode), and the like.

### (11) Bitstream (namely, bitstream) sending module

The bitstream includes the packet header, side information, payload, and the like. The packet header carries the packet header information, and the packet header information is as described in step (10). The side information includes information such as the encoded bitstream of the scale factor, information about the selected sub-band division manner, cut-off frequency information, a low bit rate flag, joint encoding determining information (namely, an MS transform flag), and a quantization step. The payload includes the encoded bitstream and a residual encoded bitstream of the MDCT spectrum.

A decoding procedure at a decoder side includes the following steps.

### (1) Stream packet header information parsing module

The stream packet header information parsing module parses the packet header information from the received bitstream, where the packet header information includes information such as the sampling rate, the channel information, the encoding frame length, and the encoding mode of the audio signal; and obtains the encoding bit rate through calculation based on a bitstream size, the sampling rate, and the encoding frame length, that is, obtains bit rate level information.

### (2) Scale factor decoding module

The scale factor decoding module decodes the side information from the bitstream. The side information includes information, such as the information about the selected sub-band division manner, the cut-off frequency information, the low bit rate flag, the joint encoding determining information, the quantization step, and the scale factors of the sub-bands.

### (3) Scale factor-based spectral noise shaping module

At the low bit rate (for example, the encoding bit rate less than 300 kbps, namely, 150 kbps/channel), spectral noise shaping further needs to be performed based on the scale factor, to obtain the adjustment factor. The adjustment factor is used to dequantize a code value of the spectral value. The setting of the low bit rate is controlled by the low bit rate determining module. When the setting of the low bit rate is not met, spectral noise shaping does not need to be performed.

### (4) MDCT spectrum decoding module and residual decoding module

The MDCT spectrum decoding module decodes the MDCT spectrum data in the decoded bitstream based on the information about the sub-band division manner, the quantization step information, and the scale factors obtained in step (2). Hole padding is performed at a low bit rate level, and if a bit obtained through calculation is still remaining, the MDCT spectrum decoding module performs residual decoding, to obtain MDCT spectrum data of another sub-band, so as to obtain final MDCT spectrum data.

### (5) LR channel conversion module

Based on the side information obtained in step (2), if it is determined, through joint encoding determining, that a dual-channel joint encoding mode rather than a decoding low-energy mode (for example, the encoding bit rate is greater than or equal to 300 kbps/channel and the sampling rate is greater than 88.2 kHz) is used, LR channel conversion is performed on the MDCT spectrum data obtained in step (4).

### (6) Inverse MDCT transform module, low-latency synthesis window adding module, and overlap-add module

On the basis of step (4) and step (5), an inverse MDCT transform module performs MDCT inverse transform on the obtained MDCT spectrum data to obtain a time-domain aliased signal. Then, the low-latency synthesis window module adds a low-latency synthesis window to the time-domain aliased signal. The overlap-add module superimposes time-domain aliased buffer signals of a current frame and a previous frame to obtain a PCM signal, that is, obtains the final PCM data based on an overlap-add method.

### (7) PCM output module

The PCM output module outputs PCM data of a corresponding channel based on a configured bit depth and channel decoding mode.

It should be noted that the audio encoding/decoding framework shown in FIG. 3A and FIG. 3B is merely used as an example of a terminal in embodiments of this application, and is not intended to limit embodiments of this application. A person skilled in the art may obtain another encoding/decoding framework on the basis of FIG. 3A and FIG. 3B.

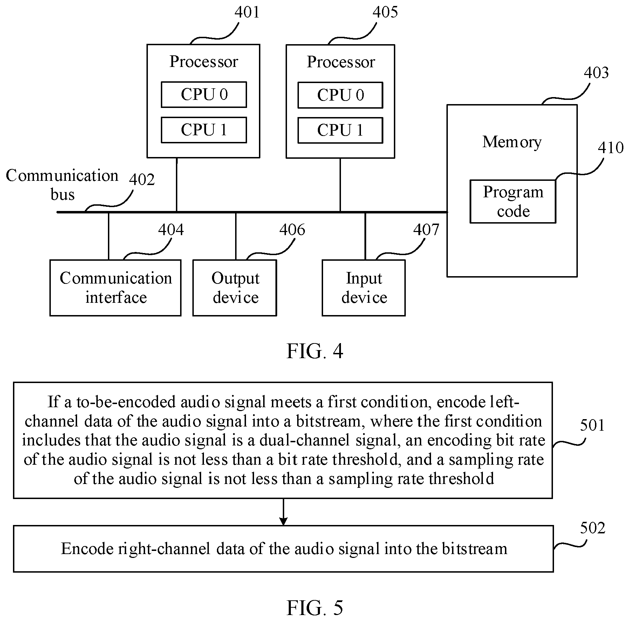

FIG. 4 is a diagram of a structure of a codec device according to an embodiment of this application. Optionally, the codec device is any device shown in FIG. 1, and includes one or more processors 401, a communication bus 402, a memory 403, and one or more communication interfaces 404.

The processor 401 is a general-purpose central processing unit (central processing unit, CPU), a network processor (network processor, NP), a microprocessor, or one or more integrated circuits configured to implement the solutions of this application, for example, an application-specific integrated circuit (application-specific integrated circuit, ASIC), a programmable logic device (programmable logic device, PLD), or a combination thereof. Optionally, the PLD is a complex programmable logic device (complex programmable logic device, CPLD), a field-programmable gate array (field-programmable gate array, FPGA), generic array logic (generic array logic, GAL), or any combination thereof.

The communication bus 402 is configured to transfer information between the foregoing components. Optionally, the communication bus 402 may be classified into an address bus, a data bus, a control bus, or the like. For ease of representation, only one thick line is used to represent the bus in the figure, but this does not mean that there is only one bus or only one type of bus.

Optionally, the memory 403 is a read-only memory (read-only memory, ROM), a random access memory (random access memory, RAM), an electrically erasable programmable read-only memory (electrically erasable programmable read-only memory, EEPROM), an optical disc (including a compact disc read-only memory (compact disc read-only memory, CD-ROM), a compact disc, a laser disc, a digital versatile disc, a Blu-ray disc, or the like), a magnetic disk storage medium or another magnetic storage device, or any other medium that can be used to carry or store expected program code in a form of instructions or a data structure and that is accessible to a computer. However, this is not limited hereto. The memory 403 exists independently, and is connected to the processor 401 through the communication bus 402, or the memory 403 is integrated with the processor 401.

The communication interface 404 is configured to communicate with another device or a communication network by using any apparatus like a transceiver. The communication interface 404 includes a wired communication interface, or may optionally include a wireless communication interface. The wired communication interface is, for example, an Ethernet interface. Optionally, the Ethernet interface is an optical interface, an electrical interface, or a combination thereof. The wireless communication interface is a wireless local area network (wireless local area network, WLAN) interface, a cellular network communication interface, a combination thereof, or the like.

Optionally, in some embodiments, the codec device includes a plurality of processors, for example, the processor 401 and a processor 405 shown in FIG. 4. Each of these processors is a single-core processor or a multicore processor. Optionally, the processor herein is one or more devices, circuits, and/or processing cores for processing data (for example, computer program instructions).

During specific implementation, in an embodiment, the codec device further includes an output device 406 and an input device 407. The output device 406 communicates with the processor 401, and can display information in a plurality of manners. For example, the output device 406 is a liquid crystal display (liquid crystal display, LCD), a light emitting diode (light emitting diode, LED) display device, a cathode ray tube (cathode ray tube, CRT) display device, or a projector (projector). The input device 407 communicates with the processor 401, and can receive an input of a user in a plurality of manners. For example, the input device 407 is a mouse, a keyboard, a touchscreen device, or a sensing device.

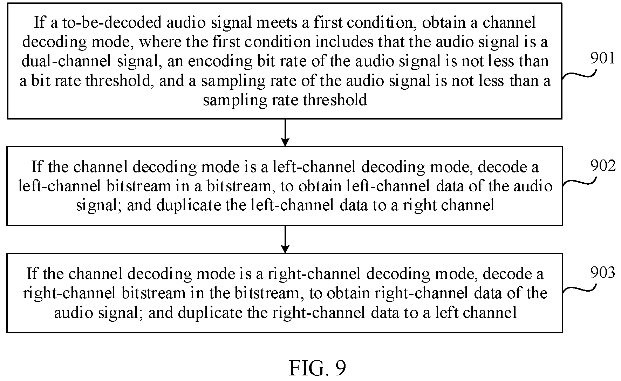

In some embodiments, the memory 403 is configured to store program code 410 for executing the solutions of this application, and the processor 401 can execute the program code 410 stored in the memory 403. The program code includes one or more software modules, and the codec device can implement, by using the processor 401 and the program code 410 in the memory 403, an audio encoding method provided in an embodiment in FIG. 5 and/or an audio decoding method shown in FIG. 9 in the following.

FIG. 5 is a flowchart of an audio encoding method according to an embodiment of this application. The method is applied to an encoder side. Refer to FIG. 5. The method includes the following steps.

Step 501: If a to-be-encoded audio signal meets a first condition, encode left-channel data of the audio signal into a bitstream, where the first condition includes that the audio signal is a dual-channel signal, an encoding bit rate of the audio signal is not less than a bit rate threshold, and a sampling rate of the audio signal is not less than a sampling rate threshold.

In embodiments of this application, to implement flexible encoding at the encoder side, the encoder side can sequentially encode the left-channel data and right-channel data based on the condition met by the to-be-encoded audio signal, rather than necessarily performing encoding in a dual-channel interleaving encoding scheme or a dual-channel deinterleaving encoding scheme.

If the to-be-encoded audio signal meets the first condition, the encoder side encodes the left-channel data of the audio signal into the bitstream. The first condition includes that the audio signal is a dual-channel signal, the encoding bit rate of the audio signal is not less than the bit rate threshold, and the sampling rate of the audio signal is not less than the sampling rate threshold.

Optionally, both the bit rate threshold and the sampling rate threshold are preset parameters, the bit rate threshold is 300 kbps or another value, and the sampling rate threshold is 88.2 kHz or another value. In this embodiment of this application, an example in which the bit rate threshold is 300 kbps and the sampling rate threshold is 88.2 kHz is used for description.

To perform efficient encoding, in this embodiment of this application, the encoder side can encode the left-channel data based on a distribution characteristic of a quantized value of a spectrum of the to-be-encoded audio signal. This is described below.

An implementation in which the encoder side encodes the left-channel data of the audio signal into the bitstream is: The encoder side obtains a quantization level measurement factor of each of a plurality of sub-bands, where the quantization level measurement factor indicates an average number of bits for encoding each spectral value in a corresponding sub-band, and the plurality of sub-bands are a plurality of sub-bands to which the encoder side allocates quantized spectrum data included in the left-channel data. The encoder side groups the plurality of sub-bands into a plurality of groups of sub-bands based on the quantization level measurement factors of the plurality of sub-bands, where quantization level measurement factors of sub-bands in a same group are the same. The encoder side determines, from a plurality of encoding codebooks based on a quantization level measurement factor of each group of sub-bands, a target encoding codebook corresponding to each group of sub-bands, and determines a bitstream of spectral values in each group of sub-bands, where the target encoding codebook is an encoding codebook used to encode spectral values in a corresponding group of sub-bands. The encoder side encodes, as a type of side information of the left-channel data, an identifier of the target encoding codebook corresponding to each group of sub-bands into the bitstream.

In brief, the left-channel data includes the quantized spectrum data, and the spectrum data is allocated to the plurality of sub-bands. The encoder side selects a better encoding codebook (namely, the target encoding codebook) from the plurality of encoding codebooks based on the quantization level measurement factor of each of the plurality of sub-bands, to obtain a left-channel bitstream obtained through encoding based on the encoding codebook. In addition, because different encoding codebooks correspond to different decoding codebooks, the encoder side further encodes the identifier of the target encoding codebook into the bitstream, to enable a decoder side to learn of a decoding codebook corresponding to the target encoding codebook used by the encoder side. The left-channel bitstream includes the bitstreams of the spectral values in the plurality of groups of sub-bands.

It should be noted that there are a plurality of implementations in which the encoder side obtains the quantization level measurement factor of each of the plurality of sub-bands. This is not limited in embodiments of this application.

Optionally, an implementation process in which the encoder side determines, from the plurality of encoding codebooks based on the quantization level measurement factor of each group of sub-bands, the target encoding codebook corresponding to each group of sub-bands, and determines the bitstream of the spectral values in each group of sub-bands includes: For any one of the plurality of groups of sub-bands, if a quantization level measurement factor of the any group of sub-bands is a first value, the encoder side separately encodes spectral values in the any group of sub-bands by using a plurality of first encoding codebooks in the plurality of encoding codebooks, to obtain a plurality of first candidate spectral bitstreams that one-to-one correspond to the plurality of first encoding codebooks. The encoder side determines, as a bitstream of the spectral values in the any group of sub-bands, a first candidate spectral bitstream with a minimum total number of bits in the plurality of first candidate spectral bitstreams, and determines, as a target encoding codebook corresponding to the any group of sub-bands, a first encoding codebook corresponding to the first candidate spectral bitstream with the minimum total number of bits. In brief, for the sub-bands whose quantization level measurement factor is the first value, the encoder side selects a better encoding codebook from the plurality of first encoding codebooks as the target encoding codebook of the sub-bands, and a data amount of a spectral bitstream obtained by using the target encoding codebook is the smallest. This implements efficient encoding at the encoder side, so that the decoder side can quickly decode the spectral bitstream subsequently.

The first value is 1, and the encoder side combines every four spectral values in the any group of sub-bands into a binary number, and separately encodes, by using the plurality of first encoding codebooks, a decimal number represented by the binary number. It should be understood that the first value being 1 indicates that an average number of bits for encoding each spectral value in a corresponding sub-band is 1. In this case, the encoder side combines every four spectral values in the any group of sub-bands into a binary number, where a number of bits of the binary number is 4. The encoder side separately encodes, by using the plurality of first encoding codebooks, a decimal number represented by the 4 bits, to obtain a plurality of bitstreams of the four spectral values. The rest may be deduced by analogy. After encoding all of the spectral values in the any group of sub-bands based on the foregoing method, the encoder side obtains the first candidate spectral bitstream corresponding to each first encoding codebook.

For example, four adjacent spectral values in a sub-band in the any group of sub-bands are: 0, 0, 1, and 1 (binary number). The encoder side combines the four spectral values into a binary number 0011, where a decimal number represented by the binary number 0011 is 3. In this case, the encoder side separately encodes the decimal number 3 by using the plurality of first encoding codebooks.

The plurality of first encoding codebooks are Huffman (Huffman) encoding codebooks, and Huffman coding is entropy encoding. The plurality of first encoding codebooks are determined based on a statistical feature of a large amount of quantized spectrum data or are obtained in another manner. The plurality of first encoding codebooks are as follows:
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
   };
{{0, 1, 3}, {1, 13, 4}, {2, 12, 4}, {3, 9, 4}, {4, 15, 4}, {5, 5, 4}, {6, 8, 4}, {7, 7, 4},
{8, 14, 4}, {9, 4, 4}, {10, 10, 4}, {11, 0, 5}, {12, 11, 4}, {13, 1, 4}, {14, 6, 4}, {15, 1, 5}
   };
{{0, 1, 2}, {1, 1, 4}, {2, 0, 4}, {3, 12, 4}, {4, 3, 4}, {5, 13, 4}, {6, 11, 4}, {7, 18, 5},
{8, 2, 4}, {9, 15, 4}, {10, 14, 4}, {11, 32, 6}, {12, 10, 4}, {13, 19, 5}, {14, 17, 5}, {15, 33, 6}
   }; and
{{0, 1, 1}, {1, 5, 4}, {2, 4, 4}, {3, 4, 5}, {4, 7, 4}, {5, 5, 5}, {6, 3, 5}, {7, 2, 6},
{8, 6, 4}, {9, 7, 5}, {10, 6, 5}, {11, 0, 7}, {12, 2, 5}, {13, 3, 6}, {14, 1, 6}, {15, 1, 7}
   }.

Optionally, for any one of the plurality of groups of sub-bands, if a quantization level measurement factor of the any group of sub-bands is a second value, the encoder side separately encodes spectral values in the any group of sub-bands by using a plurality of second encoding codebooks in the plurality of encoding codebooks, to obtain a plurality of second candidate spectral bitstreams that one-to-one correspond to the plurality of second encoding codebooks. The encoder side determines, as a bitstream of the spectral values in the any group of sub-bands, a second candidate spectral bitstream with a minimum total number of bits in the plurality of second candidate spectral bitstreams, and determines, as a target encoding codebook corresponding to the any group of sub-bands, a second encoding codebook corresponding to the second candidate spectral bitstream with the minimum total number of bits. In brief, for the sub-bands whose quantization level measurement factor is the second value, the encoder side selects a better encoding codebook from the plurality of second encoding codebooks as the target encoding codebook of the sub-bands.

The second value is 2, and the encoder side combines every two spectral values in the any group of sub-bands into a binary number, and separately encodes, by using the plurality of second encoding codebooks, a decimal number represented by the binary number. It should be understood that the second value being 2 indicates that an average number of bits for encoding each spectral value in a corresponding sub-band is 2. In this case, the encoder side combines every two spectral values in the any group of sub-bands into a binary number, where a number of bits of the binary number is 4. The encoder side separately encodes, by using the plurality of second encoding codebooks, a decimal number represented by the 4 bits, to obtain a plurality of bitstreams of the two spectral values. The rest may be deduced by analogy. After encoding all of the spectral values in the any group of sub-bands based on the foregoing method, the encoder side obtains the second candidate spectral bitstream corresponding to each second encoding codebook.

For example, two adjacent spectral values in a sub-band in the any group of sub-bands are: 01 and 11 (binary number). The encoder side combines the two spectral values into a binary number 0111, where a decimal number represented by the binary number 0111 is 7. In this case, the encoder side separately encodes the decimal number 7 by using the plurality of second encoding codebooks.

The plurality of second encoding codebooks are Huffman encoding codebooks. The plurality of second encoding codebooks are determined based on a statistical feature of a large amount of quantized spectrum data or are obtained in another manner. The plurality of second encoding codebooks are as follows:
{{0, 1, 3}, {1, 13, 4}, {2, 14, 4}, {3, 8, 4}, {4, 12, 4}, {5, 15, 4}, {6, 10, 4}, {7, 4, 4}, {8, 9, 4}, {9, 5, 4}, {10, 6, 4}, {11, 0, 5}, {12, 11, 4}, {13, 7, 4}, {14, 1, 4}, {15, 1, 5}
   };
{{0, 1, 3}, {1, 7, 3}, {2, 0, 4}, {3, 7, 4}, {4, 6, 3}, {5, 1, 4}, {6, 10, 4}, {7, 10, 5},
{8, 8, 4}, {9, 9, 4}, {10, 8, 5}, {11, 22, 5}, {12, 6, 4}, {13, 9, 5}, {14, 11, 5}, {15, 23, 5}
   };
{{0, 1, 2}, {1, 1, 4}, {2, 2, 4}, {3, 11, 4}, {4, 0, 4}, {5, 3, 4}, {6, 14, 4}, {7, 18, 5},
{8, 12, 4}, {9, 13, 4}, {10, 16, 5}, {11, 30, 5}, {12, 10, 4}, {13, 17, 5}, {14, 19, 5}, {15, 31, 5}
   }; and
{{0, 1, 1}, {1, 5, 4}, {2, 6, 4}, {3, 3, 5}, {4, 4, 4}, {5, 7, 4}, {6, 6, 5}, {7, 2, 6},
{8, 4, 5}, {9, 5, 5}, {10, 0, 6}, {11, 14, 6}, {12, 2, 5}, {13, 1, 6}, {14, 3, 6}, {15, 15, 6}
   }.

Optionally, for any one of the plurality of groups of sub-bands, if a quantization level measurement factor of the any group of sub-bands is a third value, the encoder side separately encodes spectral values in the any group of sub-bands by using a plurality of third encoding codebooks in the plurality of encoding codebooks, to obtain a plurality of third candidate spectral bitstreams that one-to-one correspond to the plurality of third encoding codebooks. The encoder side determines, as a bitstream of the spectral values in the any group of sub-bands, a third candidate spectral bitstream with a minimum total number of bits in the plurality of third candidate spectral bitstreams, and determines, as a target encoding codebook corresponding to the any group of sub-bands, a third encoding codebook corresponding to the third candidate spectral bitstream with the minimum total number of bits. In brief, for the sub-bands whose quantization level measurement factor is the third value, the encoder side selects a better encoding codebook from the plurality of third encoding codebooks as the target encoding codebook of the sub-bands.

The third value is 3, and the encoder side separately encodes all of the spectral values in the any group of sub-bands by using the plurality of third encoding codebooks. It should be understood that the third value being 3 indicates that an average number of bits for encoding each spectral value in a corresponding sub-band is 3. In this case, the encoder side directly encodes all of the spectral values in the any group of sub-bands by using the plurality of third encoding codebooks, to obtain a plurality of bitstreams of the spectral values. The rest may be deduced by analogy. After encoding all of the spectral values in the any group of sub-bands based on the foregoing method, the encoder side obtains the third candidate spectral bitstream corresponding to each third encoding codebook.

The plurality of first encoding codebooks are Huffman encoding codebooks. The plurality of third encoding codebooks are determined based on a statistical feature of a large amount of quantized spectrum data or are obtained in another manner. The plurality of third encoding codebooks are as follows:
{{0, 3, 2}, {1, 2, 2}, {2, 1, 2}, {3, 1, 3}, {4, 0, 4}, {5, 3, 5}, {6, 4, 6}, {7, 5, 6}
   };
{{0, 3, 2}, {1, 2, 2}, {2, 0, 3}, {3, 1, 3}, {4, 3, 3}, {5, 4, 4}, {6, 10, 5}, {7, 11, 5}
   };
{{0, 0, 1}, {1, 5, 3}, {2, 6, 3}, {3, 7, 3}, {4, 9, 4}, {5, 16, 5}, {6, 34, 6}, {7, 35, 6}
   }; and
{{0, 0, 3}, {1, 1, 3}, {2, 2, 3}, {3, 3, 3}, {4, 4, 3}, {5, 5, 3}, {6, 6, 3}, {7, 7, 3}
   }.

Optionally, for any one of the plurality of groups of sub-bands, if a quantization level measurement factor of the any group of sub-bands is a fourth value, the encoder side separately encodes a first part of bits in each spectral value in the any group of sub-bands by using the plurality of third encoding codebooks, to obtain a plurality of first-part candidate bitstreams that one-to-one correspond to the plurality of third encoding codebooks. The encoder side determines, as a bitstream of the first part of bits, a first-part candidate bitstream with a minimum total number of bits in the plurality of first-part candidate bitstreams, and determines, as a target encoding codebook corresponding to the any group of sub-bands, a third encoding codebook corresponding to the first-part candidate bitstream with the minimum total number of bits. The encoder side performs uniform quantization encoding on a second part of bits other than the first part of bits in each spectral value in the any group of sub-bands, to obtain a bitstream of the second part of bits.

In brief, for the sub-bands whose quantization level measurement factor is the fourth value, the encoder side divides each spectral value in the sub-bands into the first part of bits and the second part of bits, separately encodes the first part of bits by using the plurality of third encoding codebooks, and performs uniform quantization encoding on the second part of bits. The encoder side selects a better encoding codebook from the plurality of third encoding codebooks as the target encoding codebook of the sub-bands.

Optionally, the first part of bits are N high-order bits in the spectral value, and the second part of bits are M low-order bits in the spectral value, where M is equal to the quantization level measurement factor of the any group of sub-bands minus the third value.

For example, the third value is 3, and the fourth value is 5. M=5-3=2, N=3, and a spectral value is 10100 (binary number). The encoder side determines three high-order bits (namely, a binary number 101) in the spectral value as the first part of bits in the spectral value, and determines two low-order bits (namely, a binary number 00) in the spectral value as the second part of bits in the spectral value. The encoder side separately encodes, by using the plurality of third encoding codebooks, a decimal number 5 represented by the binary number 101, to obtain a bitstream of the first part of bits in the spectral value, and performs uniform quantization encoding on the binary number 00, to obtain the bitstream of the second part of bits in the spectral value.

Optionally, if the encoder side determines, based on the encoding bit rate, that there is still an available encoding bit remaining after the left-channel data is encoded into the bitstream, the encoder side can further perform residual encoding on the spectrum data included in the left-channel data, to obtain a residual bitstream in the left-channel bitstream.

Step 502: Encode the right-channel data of the audio signal into the bitstream.

In other words, if the audio signal meets the first condition, the encoder side further encodes the right-channel data of the audio signal into the bitstream.

Optionally, an implementation process in which the encoder side encodes the right-channel data is similar to the implementation process in which the encoder side encodes the left-channel data. For example, the encoder side obtains a quantization level measurement factor of each of a plurality of sub-bands, where the quantization level measurement factor indicates an average number of bits for encoding each spectral value in a corresponding sub-band, and the plurality of sub-bands are a plurality of sub-bands to which the encoder side allocates quantized spectrum data included in the right-channel data. The encoder side groups the plurality of sub-bands into a plurality of groups of sub-bands based on the quantization level measurement factors of the plurality of sub-bands, where quantization level measurement factors of sub-bands in a same group are the same. The encoder side determines, from a plurality of encoding codebooks based on a quantization level measurement factor of each group of sub-bands, a target encoding codebook corresponding to each group of sub-bands, and determines a bitstream of spectral values in each group of sub-bands, where the target encoding codebook is an encoding codebook used to encode spectral values in a corresponding group of sub-bands. The encoder side encodes, as a type of side information of the right-channel data, an identifier of the target encoding codebook corresponding to each group of sub-bands into the bitstream. For a specific implementation, refer to related descriptions of encoding the left-channel data. Details are not described herein again.

Certainly, in some other embodiments, the encoder side may alternatively encode the right-channel data in a scheme different from that of encoding the left-channel data.

For example, if the to-be-encoded audio signal is a dual-channel signal, the sampling rate is 88.2 kHz or 96 kHz, and the encoding bit rate is not less than 300 kbps, the encoder side performs initialization to enter mono-channel encoding logic, and sequentially performs the following operations: separately encoding the left-channel data, packaging the encoded left-channel data into the bitstream, separately encoding the right-channel data, and packaging the encoded right-channel data into the bitstream.

It should be noted that, in addition to encoding the left-channel data and the right-channel data, the encoder side further encodes left channel side information and right channel side information into the bitstream. In addition, the encoder side further encodes some parameters of the audio signal into a header of the bitstream. The header and the side information of the bitstream are used by the decoder side for decoding.

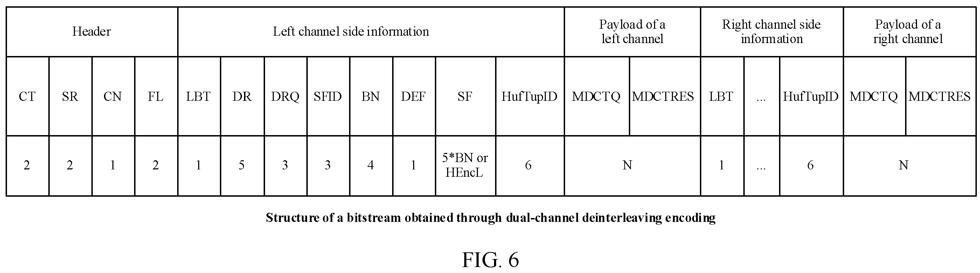

FIG. 6 is a diagram of a structure of a bitstream according to an embodiment of this application. The structure of the bitstream shown in FIG. 6 is a structure of a bitstream obtained through dual-channel deinterleaving encoding. A dual-channel deinterleaving encoding scheme is an encoding scheme in which the encoder side separately encodes the left-channel data and the right-channel data into the bitstream. Refer to FIG. 6. The structure of the bitstream sequentially includes fields such as a header (header) (which is also referred to as a packet header), left channel side information (left channel side information), left channel payload (left channel payload), right channel side information (right channel side information), and right channel payload (right channel payload).

The header field includes subfields such as a codec type (codec type, CT), a sampling rate (sampling rate, SR), a channel number (channel number, CN), and a frame length (frame length, FL). Numbers of bits occupied by the four subfields are sequentially 2, 2, 1, and 2.

The left channel side information field includes subfields such as a low bit rate flag (low bit rate flag, LBF), a global coding control factor (DR), a local coding control factor (DRQuater, DRQ), a scale factor identifier (scale factor identifier, SFID), a band number (band number, BN), a differential encoding flag (differential encoding flag, DEF), a scale factor (SF), and a Huffman encoding codebook identifier (Huffman encoding tuple ID, HufTupID). Numbers of bits occupied by the eight subfields are sequentially 1, 5, 3, 3, 4, 1, (5*BN) or a Huffman encoding length (Huffman encoding length, HEncL), and 6.

The low bit rate flag being 1 indicates that the audio signal meets a second condition. The low bit rate flag being 0 indicates that the audio signal does not meet the second condition. The second condition is that the encoding bit rate of the audio signal is less than the bit rate threshold, and an energy concentration of the audio signal is less than a concentration threshold.

The scale factor indicates a scale factor of each sub-band, and the scale factor is used by the encoder side to shape a spectral envelope and indicate the decoder side to perform reverse processing on the spectral envelope. The scale factor is obtained based on a maximum spectral value in a corresponding sub-band.

The Huffman encoding codebook identifier is an identifier of the target encoding codebook.

The left channel payload field includes a spectral bitstream and a residual bitstream of the left channel. For example, the spectrum data is modified discrete cosine transform (modified discrete cosine transform, MDCT) spectrum data. The spectral bitstream is an MDCT quantization encoding (MDCTQ) bitstream, and the residual bitstream is an MDCT residual (MDCTRES) encoding bitstream. The residual bitstream is optional. A number of bits occupied by the left channel payload field is N, where N is greater than 0.

Similarly, the right channel side information field includes subfields such as a low bit rate flag (LBF), a global coding control factor (DR), a local coding control factor (DRQuater), a scale factor identifier (SFID), a band number (BN), a differential encoding flag (DEF), a scale factor (SF), and a Huffman encoding codebook identifier (HufTupID). Numbers of bits occupied by the eight subfields are sequentially 1, 5, 3, 3, 4, 1, (5*band number) or a Huffman encoding length (HEncL), and 6.

The right channel payload field includes a spectral bitstream and a residual bitstream of the right channel. For example, the spectrum data is MDCT spectrum data. The spectral bitstream is an MDCT quantization encoding bitstream, and the residual bitstream is an MDCT residual encoding bitstream. A number of bits occupied by the left channel payload field is N, where N is greater than 0.

The foregoing describes the implementation process in which the encoder side encodes the left-channel data and the right-channel data in the dual-channel deinterleaving encoding scheme when the audio signal meets the first condition. The following describes an encoding process at the encoder side in another case.

In this embodiment of this application, if the audio signal does not meet the first condition, when the audio signal is a dual-channel signal, the encoder side encodes the left-channel data and the right-channel data into the bitstream in a dual-channel interleaving encoding scheme. In other words, the encoder side encodes the audio signal in a joint stereo encoding scheme.

It should be noted that, in addition to encoding the left-channel data and the right-channel data in the dual-channel interleaving encoding scheme, the encoder side further encodes left channel side information and right channel side information into the bitstream. In addition, the encoder side further encodes some parameters of the audio signal into a header of the bitstream. The parameters are used as dual-channel common parameters.

Optionally, the encoder side encodes identifiers of the dual-channel common parameters, the left channel side information, the right channel side information, the spectrum data of the left channel, and the spectrum data of the right channel in the dual-channel interleaving encoding scheme. The dual-channel common parameters include a codec type, a sampling rate, a channel number, a frame length, and the like. The side information includes a low bit rate flag, a mid/side-stereo transform coding flag (mid/side-stereo transform coding flag, MSF), global coding control factor, a local coding control factor, a scale factor identifier, a band number, a differential encoding flag, a scale factor, and a Huffman encoding codebook. The spectrum data of the left channel and the spectrum data of the right channel include the left-channel data and the right-channel data. MSFlag indicates whether the encoder side performs MS transform on the spectrum data of the left channel and the spectrum data of the right channel and then encodes spectrum data into the bitstream.

For example, if the to-be-encoded audio signal is a dual-channel signal, and the sampling rate is 44.1 kHz and/or the encoding bit rate is less than 300 kbps, the encoder side performs initialization to enter a dual-channel interleaving encoding mode, and sequentially performs the following operations: encoding and packaging the identifiers of the dual-channel common parameters, encoding and packaging scale factors of the left channel and right channel, encoding and packaging a Huffman encoding codebook identifier corresponding to an MDCT spectral value, and encoding and packaging the MDCT spectral value by using the Huffman encoding codebook.

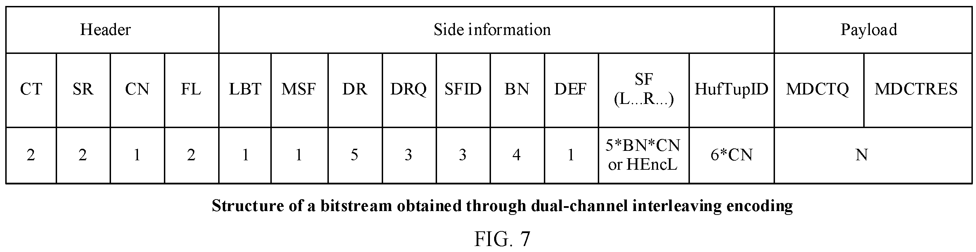

FIG. 7 is a diagram of another structure of a bitstream according to an embodiment of this application. The structure of the bitstream shown in FIG. 7 is a structure of a bitstream obtained through dual-channel interleaving encoding. Refer to FIG. 7. The structure of the bitstream sequentially includes fields such as a header (header), side information (side information), and a payload (payload).

The header field includes subfields such as a codec type, a sampling rate, a channel number, and a frame length. Numbers of bits occupied by the four subfields are sequentially 2, 2, 1, and 2.

The side information field includes subfields such as a low bit rate flag (LBF), a mid/side-stereo transform coding flag (MSF), a global coding control factor (DR), a local coding control factor (DRQ), a scale factor identifier (SFID), a band number (BN), a differential encoding flag (DEF), a scale factor (SF), and a Huffman encoding codebook identifier (HufTupID). Numbers of bits occupied by the nine subfields are sequentially 1, 1, 5, 3, 3, 4, 1, (5*BN*CN) or a Huffman encoding length (HEncL), and 6*CN.

The payload field includes spectral bitstreams and residual bitstreams, obtained through dual-channel interleaving encoding, of the left channel and the right channel. For example, the spectrum data is MDCT spectrum data. The spectral bitstream is an MDCT quantization encoding bitstream, and the residual bitstream is an MDCT residual encoding bitstream. The residual bitstream is optional. A number of bits occupied by the payload field is N, where N is greater than 0.

Optionally, when the audio signal is a dual-channel signal, the bit allocation policy that is of the left channel and the right channel and that is used by the encoder side is an even allocation policy. In this embodiment of this application, if a number of allocatable bits cannot be evenly allocated, that is, a bit rate level that cannot be exactly divided, a redundant bit is preferentially allocated to the right channel. Certainly, in some other embodiments, a redundant bit may alternatively be preferentially allocated to the left channel.

In this embodiment of this application, if the audio signal does not meet the first condition, when the audio signal is a mono-channel signal, the encoder side encodes mono-channel data of the audio signal into the bitstream.

It should be noted that an implementation process in which the encoder side encodes the mono-channel data is similar to the implementation process in which the encoder side encodes the left-channel data or the right-channel data. Details are not described herein.

Optionally, the structure of the bitstream obtained by encoding mono-channel data by the encoder side is consistent with the structure of the bitstream obtained through dual-channel interleaving encoding. However, the bitstream corresponding to the mono-channel data includes only related data of a single channel.

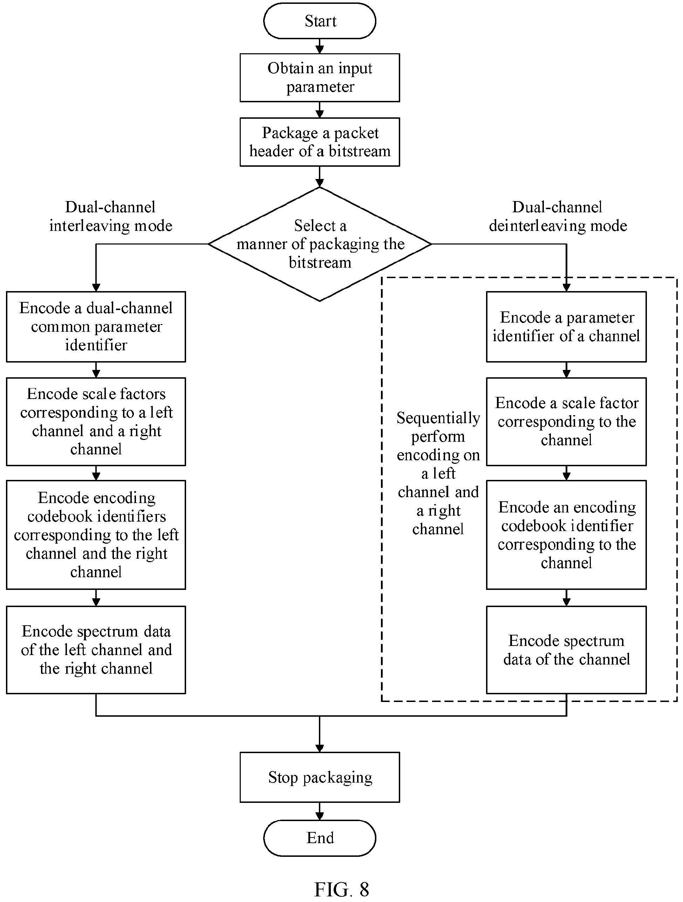

The following describes the encoding procedure in embodiments of this application again with reference to FIG. 8. The encoding procedure shown in FIG. 8 is a procedure of encoding the dual-channel signal. A procedure of decoding the mono-channel signal is similar to a left branch procedure in FIG. 8. Refer to FIG. 8. The encoder side obtains an input parameter, where the input parameter includes the encoding frame length, the encoding bit rate, the to-be-encoded audio signal (for example, the PCM data), and the like. The encoder side packages the packet header of the bitstream based on the input parameter. Then, the encoder side selects an encoding mode (that is, selects a manner of packaging the bitstream). When the dual-channel interleaving mode is selected, the encoder side enters the left branch procedure, and sequentially encodes the identifiers of the dual-channel common parameters, encodes the scale factors corresponding to the left channel and the right channel, encodes the encoding codebook identifiers used by the left channel and the right channel, and encodes the spectrum data of the left channel and the right channel. When the dual-channel deinterleaving mode is selected, the encoder side enters a right branch procedure, and sequentially performs left-channel encoding and right-channel encoding. An encoding process of each channel sequentially includes encoding a parameter identifier of the channel, encoding a scale factor of the channel, encoding an encoding codebook identifier of the channel, and encoding spectrum data of the channel. After all data is packaged, the encoder side ends the encoding procedure.

It can be learned from the foregoing that, when encoding the spectrum data of the channel, the encoder side selects an appropriate encoding codebook to improve encoding efficiency. This also facilitates efficient decoding at the decoder side. It can be further learned from the foregoing that the scale factor is encoded into the bitstream. In embodiments of this application, the encoder side properly encodes the scale factor, to improve encoding effect and compression efficiency to some extent. The following describes an implementation process in which the encoder side encodes the scale factor.

In embodiments of this application, the encoder side obtains the scale factor of each of the plurality of sub-bands. If there is an absolute value of a difference between scale factors of two adjacent sub-bands in the plurality of sub-bands that is greater than a difference threshold, the encoder side performs uniform quantization encoding on the scale factors of the plurality of sub-bands. If there is no absolute value of a difference between scale factors of two adjacent sub-bands in the plurality of sub-bands that is greater than the difference threshold, the encoder side performs differential encoding on the scale factors of the plurality of sub-bands.

Optionally, in embodiments of this application, the difference threshold is 6. In some other embodiments, the difference threshold may alternatively be another value. It should be noted that the difference threshold is determined based on statistical features of the scale factors of the plurality of sub-bands or is determined in another manner.

An implementation in which the encoder side performs differential encoding on the scale factors of the plurality of sub-bands is described herein.

The encoder side determines a differential scale value of each of the plurality of sub-bands. A differential scale value of a first sub-band in the plurality of sub-bands is a scale factor of the first sub-band plus a reference value. A differential scale value of any sub-band other than the first sub-band in the plurality of sub-bands is a difference between a scale factor of the any sub-band and a scale factor of a previous sub-band of the any sub-band. The encoder side performs uniform quantization encoding on the differential scale value of the first sub-band. The encoder side performs entropy encoding, for example, Huffman encoding, on any sub-band other than the first sub-band in the plurality of sub-bands.

Optionally, the encoder side encodes any sub-band other than the first sub-band in the plurality of sub-bands by using the Huffman encoding codebook. The Huffman encoding codebook is as follows:
HuffmanCB HUF_ENC_DIFF_SF[HUF_ENC_DIFF_SF_MAXIDX]={ {0, 3, 2}, {1, 2, 2}, {2, 1, 2}, {3, 1, 3}, {4, 0, 4}, {5, 2, 5}, {6, 3, 5} }.

The Huffman encoding codebook includes a plurality of tuples. In each tuple, a first element indicates a to-be-coded decimal number, a second element indicates a decimal number, namely, a code value, corresponding to an encoded binary number, and a third element indicates a number of bits, namely, a code length, occupied by the encoded binary number.

Optionally, in embodiments of this application, the reference value is 8. In some other embodiments, the reference value may alternatively be another value.

For example, the encoder side determines the differential scale value of each of the plurality of sub-bands according to a formula (1). $sfDiff \left(b\right) = \left\{\begin{matrix}sf \left(b\right) + 8 , & if b = 0 \\ sf \left(b\right) - sf \left(b-1\right) , & if b > 0\end{matrix}\right. , b = 0 , 1 , 2 , … , bandsNum$ (1)

In the formula (1), b indicates a sequential number of a sub-band, bandsNum+1 indicates a total number of sub-bands, sf(b) indicates a scale factor of a sub-band b, and sfDiff(b) indicates a differential scale value of the sub-band b.

When b=0, the encoder side performs uniform quantization encoding on sfDiff(0), that is, sfDiff(0) is uniformly encoded into a binary number. The binary number occupies 5 bits, and the 5 bits are packaged into the bitstream.

When b>0, after obtaining an absolute value of sfDiff(b), the encoder side performs encoding by using the Huffman encoding codebook, and encodes an encoded binary number into the bitstream. For positive sfDiff(b), the encoder side determines a sign bit of sfDiff(b) as 1, and encodes the sign bit into the bitstream, where the sign bit occupies 1 bit. Negative sfDiff (b) does not occupy a sign bit.

It should be noted that, the Huffman encoding codebook is obtained based on experience or big data training, and usually conforms to the following rule: A code length corresponding to a value that appears frequently is short, and a code length corresponding to a value that appears infrequently is long.

In conclusion, in embodiments of this application, the encoder side can sequentially encode the left-channel data and the right-channel data based on the condition met by the audio signal, rather than performing encoding in the dual-channel interleaving encoding scheme or the dual-channel deinterleaving encoding scheme. It can be learned that the encoding scheme in this solution is more flexible.

FIG. 9 is a flowchart of an audio decoding method according to an embodiment of this application. The decoding method is applied to a decoder side. The decoding method matches the encoding method shown in FIG. 5. Refer to FIG. 9. The decoding method includes the following steps.

Step 901: If a to-be-decoded audio signal meets a first condition, obtain a channel decoding mode, where the first condition includes that the audio signal is a dual-channel signal, an encoding bit rate of the audio signal is not less than a bit rate threshold, and a sampling rate of the audio signal is not less than a sampling rate threshold.

In this embodiment of this application, the decoder side can perform on-demand decoding based on the condition met by the to-be-decoded audio signal and the channel decoding mode, to implement low power consumption at the decoder side and enable an electronic device with limited resources to successfully decode a bitstream.

The channel decoding mode is a parameter configured at the decoder side. Optionally, the channel decoding mode is represented by values such as 0, 1, and 2, and different values indicate different channel decoding modes. For example, 0 indicates a dual-channel decoding mode, 1 indicates a left-channel decoding mode, and 2 indicates a right-channel decoding mode.

In this embodiment of this application, when the audio signal is a dual-channel signal, the encoding bit rate is not less than the bit rate threshold, and the sampling rate is not less than the sampling rate threshold, the bitstream includes a left-channel bitstream and a right-channel bitstream, and the decoder side obtains the channel decoding mode, and determines, based on the channel decoding mode, to decode a bitstream of which channel.

Optionally, the bit rate threshold is 300 kbps or another value, and the sampling rate threshold is 88.2 kHz or another value. In this embodiment of this application, an example in which the bit rate threshold is 300 kbps and the sampling rate threshold is 88.2 kHz is used for description. It should be noted that the bit rate threshold at the encoder side is the same as the bit rate threshold at the decoder side, and the sampling rate threshold at the encoder side is the same as the sampling rate threshold at the decoder side.

In this embodiment of this application, an implementation process in which the decoder side determines whether the audio signal meets the first condition includes: The decoder side obtains a total data amount of the bitstream and decodes a packet header of the bitstream, to obtain a channel number, the sampling rate, and a frame length of the audio signal. The decoder side determines, based on the total data amount, the channel number, the sampling rate, and the frame length, whether the audio signal meets the first condition.

The decoder side determines the encoding bit rate of the audio signal based on the total data amount, the sampling rate, and the frame length. The decoder side determines, based on the encoding bit rate, the channel number, and the sampling rate of the audio signal, whether the audio signal meets the first condition.

Step 902: If the channel decoding mode is a left-channel decoding mode, decode the left-channel bitstream in the bitstream, to obtain left-channel data of the audio signal; and duplicate the left-channel data to a right channel.

The left-channel decoding mode indicates that the right-channel bitstream in the bitstream does not need to be decoded. After the left-channel data is obtained through decoding, the decoder side duplicates the left-channel data to the right channel. It should be noted that, if the left-channel data includes quantized spectrum data of a left channel, the decoder side dequantizes the quantized spectrum data of the left channel, and duplicates the dequantized spectrum data of the left channel to the right channel. Alternatively, the decoder side dequantizes the quantized spectrum data of the left channel; performs inverse time-frequency domain transform (for example, inverse-modified discrete cosine transform (inverse-modified discrete cosine transform, IMDCT)) on the dequantized left-channel data, to obtain time-domain aliased signals of the left channel; performs an overlap-add method on the time-domain aliased signals of the left channel, to reconstruct a time-domain signal of the left channel; and duplicates the reconstructed time-domain signal of the left channel to the right channel.

It can be learned from the foregoing related descriptions of the encoding procedure that the bitstream includes parameters for decoding at the decoder side. For example, the bitstream includes left channel side information, and the side information includes an identifier of an encoding codebook used for encoding the left-channel data. In view of this, the decoder side decodes a bitstream of the side information in the bitstream, to obtain the side information, where the side information includes the encoding codebook identifier. The decoder side determines, based on the encoding codebook identifier, a target decoding codebook for decoding from a plurality of decoding codebooks. The side information herein is the left channel side information.

For example, the encoding codebook identifier is an identifier of any one of a plurality of encoding codebooks. The plurality of encoding codebooks one-to-one correspond to the plurality of decoding codebooks. The decoder side determines, according to a correspondence between encoding codebook identifiers and decoding codebook identifiers, a decoding codebook identifier corresponding to the encoding codebook identifier included in the side information, and determines the determined decoding codebook identifier as a target decoding identifier.

For example, the plurality of encoding codebooks include the plurality of first encoding codebooks, the plurality of second encoding codebooks, and the plurality of third encoding codebooks that are described above, and the plurality of corresponding decoding codebooks include a plurality of first decoding codebooks, a plurality of second decoding codebooks, and a plurality of third decoding codebooks. The plurality of first decoding codebooks one-to-one correspond to the plurality of first encoding codebooks, the plurality of second decoding codebooks one-to-one correspond to the plurality of second encoding codebooks, and the plurality of third decoding codebooks one-to-one correspond to the plurality of third encoding codebooks.

The plurality of first decoding codebooks are as follows:
{{0, 0, 4}, {1, 1, 4}, {2, 2, 4}, {3, 3, 4}, {4, 4, 41, {5, 5, 4}, {6,6,4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
   };
}{11, 0, 5}, {15, 1, 5}, {13, 2, 4}, {13, 3, 4}, {0, 4, 3}, {0, 5, 3}, {0, 6, 3}, {0, 7, 3},
{9, 8, 4}, {9, 9, 4}, {5, 10, 4}, {5, 11, 4}, {14, 12, 4}, {14, 13, 4}, {7, 14, 4}, {7, 15, 4}, {6, 16, 4}, {6, 17, 4}, {3, 18, 4}, {3, 19, 4}, {10, 20, 4}, {10, 21, 4}, {12, 22, 4}, {12, 23, 4}, {2, 24, 4}, {2, 25, 4}, {1, 26, 4}, {1, 27, 4}, {8, 28, 4}, {8, 29, 4}, {4, 30, 4}, {4, 31, 4}
   };
{{2, 0, 4}, {2, 1, 4}, {2, 2, 4}, {2,3,4}, {1,4,4}, {1, 5, 4}, {1,6,4}, {1, 7, 4},
{8, 8, 4}, {8, 9, 4}, {8, 10, 4}, {8, 11, 4}, {4, 12, 4}, {4, 13, 4}, {4, 14, 4}, {4, 15, 4}, {0, 16, 2}, {0, 17, 2}, {0, 18, 2}, {0, 19, 2}, {0, 20, 2}, {0, 21, 2}, {0, 22, 2}, {0, 23, 2}, 0, 24, 2}, {0, 25, 2}, {0, 26, 2}, {0, 27, 2}, {0, 28, 2}, {0, 29, 2}, {0, 30, 2}, {0, 31, 2}, {11, 32, 6}, {15, 33, 6}, {14, 34, 5}, {14, 35, 5}, {7, 36, 5}, {7, 37, 5}, {13, 38, 5}, {13, 39, 5}, {12, 40, 4}, {12, 41, 4}, {12, 42, 4}, {12, 43, 4}, {6, 44, 4}, {6, 45, 4}, {6, 46, 4}, {6, 47, 4}, {3, 48, 4}, {3, 49, 4}, {3, 50, 4}, {3, 51, 4}, {5, 52, 4}, {5, 53, 4}, {5, 54, 4}, {5, 55, 4}, {10, 56, 4}, {10, 57, 4}, {10, 58, 4}, {10, 59, 4}, {9, 60, 4}, {9, 61, 4}, {9, 62, 4}, {9, 63, 4}
   }; and
{{11, 0, 7}, {15, 1, 7}, {14, 2, 6}, {14, 3, 6}, {7, 4, 6}, {7, 5, 6}, {13, 6, 6}, {13, 7, 6}, {12, 8, 5}, {12, 9, 5}, {12, 10, 5}, {12, 11, 5}, {6, 12, 5}, {6, 13, 5}, {6, 14, 5}, {6, 15, 5}, {3, 16, 5}, {3, 17, 5}, {3, 18, 5}, {3, 19, 5}, {5, 20, 5}, {5, 21, 5}, {5, 22, 5}, {5, 23, 5}, {10, 24, 5}, {10, 25, 5}, {10, 26, 5}, {10, 27, 5}, {9, 28, 5}, {9, 29, 5}, {9, 30, 5}, {9, 31, 5}, {2, 32, 4}, {2, 33, 4}, {2, 34, 4}, {2, 35, 4}, {2, 36, 4}, {2, 37, 4}, {2, 38, 4}, {2, 39, 4}, {1, 40, 4}, {1, 41, 4}, {1, 42, 4}, {1, 43, 4}, {1, 44, 4}, {1, 45, 4}, {1, 46, 4}, {1, 47, 4}, {8, 48, 4}, {8, 49, 4}, {8, 50, 4}, {8, 51, 4}, {8, 52, 4}, {8,53, 4}, {8,54, 4}, {8, 55, 4}, {4, 56, 4}, {4,57, 4}, {4, 58, 4}, {4, 59, 4}, {4, 60, 4}, {4, 61, 4}, {4, 62, 4}, {4, 63, 4}, {0, 64, 1}, {0, 65, 1}, {0, 66, 1}, {0, 67, 1}, {0, 68, 1}, {0, 69, 1}, {0, 70, 1}, {0, 71, 1}, {0, 72, 1}, {0, 73, 1}, {0, 74, 1}, {0, 75, 1}, {0, 76, 1}, {0, 77, 1}, {0, 78, 1}, {0, 79, 1}, {0, 80, 1}, {0, 81, 1}, {0, 82, 1}, {0, 83, 1}, {0, 84, 1}, {0, 85, 1}, {0, 86, 1}, {0, 87, 1}, {0, 88, 1}, {0, 89, 1}, {0, 90, 1}, {0, 91, 1}, {0, 92, 1}, {0, 93, 1}, {0, 94, 1}, {0, 95, 1}, {0, 96, 1}, {0, 97, 1}, {0, 98, 1}, {0, 99, 1}, {0, 100, 1}, {0, 101, 1}, {0, 102, 1}, {0, 103, 1}, {0, 104, 1}, {0, 105, 1}, {0, 106, 1}, {0, 107, 1}, {0, 108, 1}, {0, 109, 1}, {0, 110, 1}, {0, 111, 1}, {0, 112, 1}, {0, 113, 1}, {0, 114, 1}, {0, 115, 1}, {0, 116, 1}, {0, 117, 1}, {0, 118, 1}, {0, 119, 1}, {0, 120, 1}, {0, 121, 1}, {0, 122, 1}, {0, 123, 1}, {0, 124, 1}, {0, 125, 1}, {0, 126, 1}, {0, 127, 1}
   }.

The plurality of second decoding codebooks are as follows:
{{11, 0, 5}, {15, 1, 5}, {14, 2, 4}, {14, 3, 4}, {0, 4, 3}, {0, 5, 3}, {0, 6, 3}, {0, 7, 3}, {7, 8, 4}, {7, 9, 4}, {9, 10, 4}, {9, 11, 4}, {10, 12, 4}, {10, 13, 4}, {13, 14, 4}, {13, 15, 4}, {3, 16, 4}, {3, 17, 4}, {8, 18, 4}, {8, 19, 4}, {6, 20, 4}, {6, 21, 4}, {12,22, 4}, {12, 23, 4}, {4, 24, 4}, {4, 25, 4}, {1, 26, 4}, {1, 27, 4}, {2, 28, 4}, {2, 29, 4}, {5, 30, 4}, {5, 31, 4}
   };
{{2, 0, 4}, {2, 1, 4}, {5, 2, 4}, {5, 3, 4}, {0, 4, 3}, {0, 5, 3}, {0, 6, 3}, {0, 7, 3}, {10, 8, 5}, {13, 9, 5}, {7, 10, 5}, {14, 11, 5}, {12, 12, 4}, {12, 13, 4}, {3, 14, 4}, {3, 15, 4}, {8, 16, 4}, {8, 17, 4}, {9, 18, 4}, {9, 19, 4}, {6, 20, 4}, {6, 21, 4}, {11, 22, 5}, {15, 23, 5}, {4, 24, 3}, {4, 25, 3}, {4, 26, 3}, {4, 27, 3}, {1, 28, 3}, {1, 29, 3}, {1, 30, 3}, {1, 31, 3}
   };
{{4, 0, 4}, {4, 1, 4}, {1, 2, 4}, {1, 3, 4}, {2, 4, 4}, {2, 5, 4}, {5, 6, 4}, {5, 7, 4}, {0, 8, 2}, {0, 9, 2}, {0, 10, 2}, {0, 11, 2}, {0, 12, 2}, {0, 13, 2}, {0, 14, 2}, {0, 15, 2}, {10, 16, 5}, {13, 17, 5}, {7, 18, 5}, {14, 19, 5}, {12, 20, 4}, {12, 21, 4}, {3, 22, 4}, {3, 23,4}, {8, 24, 4}, {8, 25, 4}, {9, 26, 4}, {9, 27, 4}, {6, 28, 4}, {6, 29, 4}, {11, 30, 5}, {15, 31, 5},
   }; and
{{10, 0, 6}, {13, 1, 6}, {7, 2, 6}, {14, 3, 6}, {12, 4, 5}, {12, 5, 5}, {3, 6, 5}, {3, 7, 5}, {8, 8, 5}, {8, 9, 5}, {9, 10, 5}, {9, 11, 5}, {6, 12, 5}, {6, 13, 5}, {11, 14, 6}, {15, 15, 6}, {4, 16, 4}, {4, 17, 4}, {4, 18, 4}, {4, 19, 4}, {1, 20, 4}, {1, 21, 4}, {1, 22, 4}, {1, 23, 4}, {2, 24, 4}, {2, 25, 4}, {2, 26, 4}, {2, 27, 4}, {5, 28, 4}, {5, 29, 4}, {5, 30, 4}, {5, 31, 4}, {0, 32, 1}, {0, 33, 1}, {0, 34, 1}, {0, 35, 1}, {0, 36, 1}, {0, 37, 1}, {0, 38, 1}, {0, 39, 1}, {0, 40, 1}, {0, 41, 1}, {0, 42, 1}, {0, 43, 1}, {0, 44, 1}, {0, 45, 1}, {0, 46, 1}, {0, 47, 1}, {0, 48, 1}, {0, 49, 1}, {0, 50, 1}, {0, 51, 1}, {0, 52, 1}, {0, 53, 1}, {0, 54, 1}, {0, 55, 1}, {0, 56, 1}, {0, 57, 1}, {0, 58, 1}, {0, 59, 1}, {0, 60, 1}, {0, 61, 1}, {0, 62, 1}, {0, 63, 1}
   }.

The plurality of third decoding codebooks are as follows:
{{4, 0, 4}, {4, 1, 4}, {4, 2, 4}, {4, 3, 4}, {6, 4, 6}, {7, 5, 6}, {5, 6, 5}, {5, 7, 5}, {3, 8, 3}, {3, 9, 3}, {3, 10, 3}, {3, 11, 3}, {3, 12, 3}, {3, 13, 3}, {3, 14, 3}, {3, 15, 3}, {2, 16, 2}, {2, 17, 2}, {2, 18, 2}, {2, 19, 2}, {2, 20, 2}, {2, 21, 2}, {2, 22, 2}, {2, 23, 2}, {2, 24, 2}, {2, 25, 2}, {2, 26, 2}, {2, 27, 2}, {2, 28, 2}, {2, 29, 2}, {2, 30, 2}, {2, 31, 2}, {1, 32, 2}, {1, 33, 2}, {1, 34, 2}, {1, 35, 2}, {1, 36, 2}, {1, 37, 2}, {1, 38, 2}, {1, 39, 2}, {1, 40, 2}, {1, 41, 2}, {1, 42, 2}, {1, 43, 2}, {1, 44, 2}, {1, 45, 2}, {1, 46, 2}, {1, 47, 2}, {0, 48, 2}, {0, 49, 2}, {0, 50, 2}, {0, 51, 2}, {0, 52, 2}, {0, 53, 2}, {0, 54, 2}, {0, 55, 2}, {0, 56, 2}, {0, 57, 2}, {0, 58, 2}, {0, 59, 2}, {0, 60, 2}, {0, 61, 2}, {0, 62, 2}, {0, 63, 2}
   };
{{2, 0, 3}, {2, 1, 3}, {2, 2, 3}, {2, 3, 3}, {3, 4, 3}, {3, 5, 3}, {3, 6, 3}, {3, 7, 3}, {5, 8, 4}, {5, 9, 4}, {6, 10, 5}, {7, 11, 5}, {4, 12, 3}, {4, 13, 3}, {4, 14, 3}, {4, 15, 3}, {1, 16, 2}, {1, 17, 2}, {1, 18, 2}, {1, 19, 2}, {1, 20, 2}, {1, 21, 2}, {1, 22, 2}, {1, 23, 2}, {0, 24, 2}, {0, 25, 2}, {0, 26, 2}, {0, 27, 2}, {0, 28, 2}, {0, 29, 2}, {0, 30, 2}, {0, 31, 2}
   };
{{0, 0, 1}, {0, 1, 1}, {0, 2, 1}, {0, 3, 1}, {0, 4, 1}, {0, 5, 1}, {0, 6, 1}, {0, 7, 1}, {0, 8, 1}, {0, 9, 1}, {0, 10, 1}, {0, 11, 1}, {0, 12, 1}, {0, 13, 1}, {0, 14, 1}, {0, 15, 1}, {0, 16, 1}, {0, 17, 1}, {0, 18, 1}, {0, 19, 1}, {0, 20, 1}, {0, 21, 1}, {0, 22, 1}, {0, 23, 1}, {0, 24, 1}, {0, 25, 1}, {0, 26, 1}, {0, 27, 1}, {0, 28, 1}, {0, 29, 1}, {0, 30, 1}, {0, 31, 1}, {5, 32, 5}, {5, 33, 5}, {6, 34, 6}, {7, 35, 6}, {4, 36, 4}, {4, 37, 4}, {4, 38, 4}, {4, 39, 4}, {1, 40, 3}, {1, 41, 3}, {1, 42, 3}, {1, 43, 3}, {1, 44, 3}, {1, 45, 3}, {1, 46, 3}, {1, 47, 3}, {2, 48, 3}, {2, 49, 3}, {2, 50, 3}, {2, 51, 3}, {2, 52, 3}, {2, 53, 3}, {2, 54, 3}, {2, 55, 3}, {3, 56, 3}, {3, 57, 3}, {3, 58, 3}, {3, 59, 3}, {3, 60, 3}, {3, 61, 3}, {3, 62, 3}, {3, 63, 3}
   }; and
{{0, 0, 3}, {1, 1, 3}, {2, 2, 3}, {3, 3, 3}, {4, 4, 3}, {5, 5, 3}, {6, 6, 3}, {7, 7, 3}
   }.

Step 903: If the channel decoding mode is the right-channel decoding mode, decode the right-channel bitstream in the bitstream, to obtain the right-channel data of the audio signal; and duplicate the right-channel data to the left channel.

The right-channel decoding mode indicates that the left-channel bitstream in the bitstream does not need to be decoded. After the right-channel data is obtained through decoding, the decoder side duplicates the right-channel data to the left channel. It should be noted that, if the right-channel data includes quantized spectrum data of the right channel, the decoder side dequantizes the quantized spectrum data of the right channel, and duplicates the dequantized spectrum data of the right channel to the left channel Alternatively, the decoder side dequantizes the quantized spectrum data of the right channel; performs inverse time-frequency domain transform (for example, IMDCT) on the dequantized right-channel data, to obtain time-domain aliased signals of the right channel; performs the overlap-add method on the time-domain aliased signals of the right channel, to reconstruct a time-domain signal of the right channel; and duplicates the reconstructed time-domain signal of the right channel to the left channel.

It can be learned from the foregoing related descriptions of the encoding procedure that the bitstream includes parameters for decoding at the decoder side. For example, the bitstream includes right channel side information, and the side information includes an identifier of an encoding codebook used for encoding the right-channel data. In view of this, the decoder side decodes a bitstream of the side information in the bitstream, to obtain the side information, where the side information includes the encoding codebook identifier. The decoder side determines, based on the encoding codebook identifier, a target decoding codebook for decoding from a plurality of decoding codebooks. The side information herein is the right channel side information.

It should be noted that the plurality of decoding codebooks are the same as the plurality of decoding codebooks described in step 902. Details are not described herein again.

Optionally, if the channel decoding mode is neither the left-channel decoding mode nor the right-channel decoding mode, the decoder side decodes the left-channel bitstream and the right-channel bitstream, to obtain the left-channel data and the right-channel data. In other words, the decoder side decodes all data in the bitstream.

If the audio signal does not meet the first condition, when the audio signal is a dual-channel signal, the decoder side decodes a dual-channel interleaved bitstream in the bitstream, to obtain the left-channel data and the right-channel data. It should be understood that, if the audio signal is a dual-channel signal but does not meet the first condition, it indicates that the encoder side encodes the left-channel data and the right-channel data in a dual-channel interleaving encoding scheme. In this case, the decoder side decodes the dual-channel interleaved bitstream in a dual-channel interleaving decoding scheme, to obtain the left-channel data and the right-channel data.

The left-channel data and the right-channel data obtained at the decoder side include the quantized spectrum data. If the channel decoding mode is the left-channel decoding mode, the decoder side dequantizes the quantized spectrum data included in the left-channel data, to obtain the dequantized spectrum data of the left channel; and duplicates the dequantized spectrum data of the left channel to the right channel. If the channel decoding mode is the right-channel decoding mode, the decoder side dequantizes the quantized spectrum data included in the right-channel data, to obtain the dequantized spectrum data of the right channel; and duplicates the dequantized spectrum data of the right channel to the left channel. If the channel decoding mode is the dual-channel decoding mode, the decoder side dequantizes the quantized spectrum data included in the left-channel data, to obtain the dequantized spectrum data of the left channel; and dequantizes the quantized spectrum data included in the right-channel data, to obtain the dequantized spectrum data of the right channel.

Alternatively, if the channel decoding mode is the left-channel decoding mode, the decoder side dequantizes the quantized spectrum data included in the left-channel data, to obtain the dequantized spectrum data of the left channel; performs inverse time-frequency domain transform (for example, IMDCT) on the dequantized spectrum data of the left channel, to obtain time-domain aliased signals of the left channel; performs an overlap-add method on the time-domain aliased signals of the left channel, to reconstruct a time-domain signal of the left channel; and duplicates the reconstructed time-domain signal of the left channel to the right channel. If the channel decoding mode is the right-channel decoding mode, the decoder side dequantizes the quantized spectrum data included in the right-channel data, to obtain the dequantized spectrum data of the right channel; performs inverse time-frequency domain transform (for example, IMDCT) on the dequantized spectrum data of the right channel, to obtain time-domain aliased signals of the right channel; performs the overlap-add method on the time-domain aliased signals of the right channel, to reconstruct a time-domain signal of the right channel; and duplicates the reconstructed time-domain signal of the right channel to the left channel. If the channel decoding mode is the dual-channel decoding mode, the decoder side sequentially performs dequantization, inverse time-frequency domain transform, and the overlap-add method on the quantized spectrum data included in the left-channel data, to reconstruct the time-domain signal of the left channel; and sequentially performs dequantization, inverse time-frequency domain transform, and the overlap-add method on the quantized spectrum data included in the right-channel data, to reconstruct the time-domain signal of the right channel.

Optionally, if the encoder side performs MS transform on the left-channel data and the right-channel data, and encodes the left-channel data and the right-channel data that are obtained through MS transform into the bitstream, after the decoder side obtains the left-channel data and/or the right-channel data, the decoder side further needs to perform inverse MS transform on the left-channel data and/or the right-channel data, to obtain original left-channel data and/or right-channel data.

If the audio signal does not meet the first condition, when the audio signal is a mono-channel signal, the decoder side decodes a mono-channel bitstream in the bitstream, to obtain mono-channel data of the audio signal. Optionally, the decoder side duplicates the mono-channel data to the left channel and the right channel. If the mono-channel data obtained through decoding is quantized spectrum data of a single channel, the decoder side dequantizes the quantized spectrum data of the single channel, and performs inverse time-frequency domain transform (for example, IMDCT) on the dequantized spectrum data of the single channel, to obtain time-domain aliased signals of the single channel; performs the overlap-add method on the time-domain aliased signals of the single channel, to reconstruct a time-domain signal of the single channel; and duplicates the reconstructed time-domain signal of the single channel to the left channel and the right channel.

In embodiments of this application, after the decoder side inputs the signals into the left channel and the right channel, a playing device like a headset may obtain, based on configuration, a signal of a corresponding channel for playing.

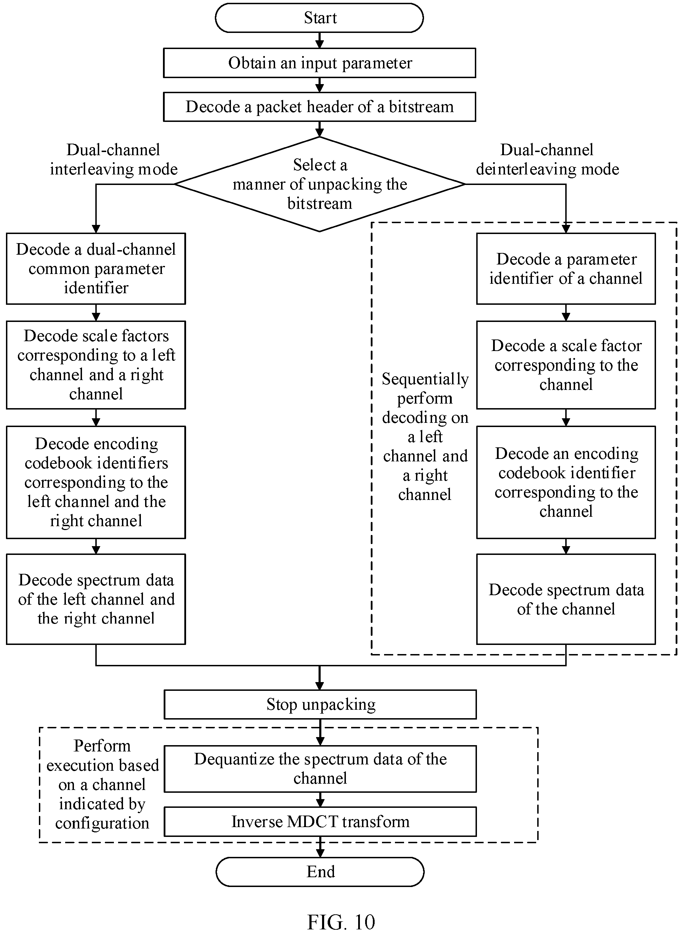

The following describes the decoding procedure in embodiments of this application again with reference to FIG. 10. The decoding procedure shown in FIG. 10 is a procedure of decoding the dual-channel signal. A procedure of decoding the mono-channel signal is similar to a left branch procedure in FIG. 10. Refer to FIG. 10. The decoder side obtains an input parameter, where the input parameter includes the channel decoding mode and the like. The decoder side decodes a packet header of the bitstream. Then, the decoder side selects a decoding mode (that is, selects a manner of unpacking the bitstream) based on the packet header and the channel decoding mode. When the dual-channel interleaving mode is selected, the decoder side enters the left branch procedure, and sequentially decodes identifiers of dual-channel common parameters, decodes scale factors of the left channel and the right channel, decodes encoding codebook identifiers used by the left channel and the right channel, and decodes the spectrum data of the left channel and the right channel. When the dual-channel deinterleaving mode is selected, the decoder side enters a right branch procedure, and sequentially performs left-channel decoding and right-channel decoding. A decoding process of each channel sequentially includes decoding a parameter identifier of the channel, decoding a scale factor of the channel, decoding an encoding codebook identifier of the channel, and decoding spectrum data of the channel. After decoding is completed, the decoder side sequentially performs, based on a channel indicated by the configured channel decoding mode, dequantization and inverse MDCT transform on the spectrum data, obtained through parsing, of the corresponding channel, to reconstruct a signal of the corresponding channel.

The foregoing mainly describes the implementation process in which the decoder side parses the spectrum data in the bitstream. It can be learned from the foregoing related descriptions of the encoding process that the scale factors of the plurality of sub-bands are further encoded into the bitstream, and the scale factors are used to shape the spectral envelope of the audio signal. In view of this, after parsing the bitstream to obtain the side information and obtaining the scale factors in the side information, the decoder side shapes the spectral envelope of the audio signal based on the scale factors, for example, shapes a spectral envelope of the left channel and/or a spectral envelope of the right channel. The following uses an example to describe an implementation process in which the decoder side decodes the scale factor.

For example, the decoder side first obtains a binary number of first 5 bits in a bitstream of the scale factors, to obtain a differential scale value of a first sub-band in the plurality of sub-bands, and subtracts a reference value (the reference value is 8 in this example) from the differential scale value of the first sub-band, to obtain a scale factor of the first sub-band. Then, the decoder side reads a binary number of next 5 bits from the bitstream, uses a decimal number corresponding to the binary number as a code value, and obtains a decoded decimal number corresponding to the code value by searching the Huffman decoding codebook, where the decimal number is an absolute value of a differential scale value of a next sub-band. Then, if the absolute value is greater than 0, the decoder side continues to read 1 bit from the bitstream, and uses the 1 bit as a sign bit of the absolute value, to obtain the differential scale value of the sub-band. If the absolute value is 0, the absolute value of the differential scale value is the differential scale value of the sub-band. The rest may be deduced by analog. The decoder side obtains a differential scale value of each of the plurality of sub-bands. The decoder side restores a scale factor of each of the plurality of sub-bands according to a formula (2). $sf \left(b\right) = \left\{\begin{matrix}sfDiff \left(b\right) - 8 , & if b = 0 \\ sfDiff \left(b\right) + sfDiff \left(b-1\right) , & if b > 0\end{matrix}\right. , b = 0 , 1 , 2 , … , bandsNum$ (2)

In this case, the decoder side obtains the scale factors of the plurality of sub-bands through parsing based on a band number.

The Huffman decoding codebook used at the decoder side is as follows:
HuffmanCB HUF_DEC_DIFF_SF[HUF_DEC_DIFF_SF_MAXIDX]={
{4, 0, 4}, {4, 1, 4}, {5, 2, 5}, {6, 3, 5}, {3, 4, 3}, {3, 5, 3}, {3, 6, 3}, {3, 7, 3},
{2, 8, 2}, {2, 9, 2}, {2, 10, 2}, {2, 11, 2}, {2, 12, 2}, {2, 13, 2}, {2, 14, 2}, {2, 15, 2}, {1, 16, 2}, {1, 17, 2}, {1, 18, 2}, {1, 19, 2}, {1, 20, 2}, {1, 21, 2}, {1, 22, 2}, {1, 23, 2}, {0, 24, 2}, {0, 25, 2}, {0, 26, 2}, {0, 27, 2}, {0, 28, 2}, {0, 29, 2}, {0, 30, 2}, {0, 31, 2}
   }.

In conclusion, in embodiments of this application, when the audio signal is a dual-channel signal, even if the bitstream includes the left-channel bitstream and the right-channel bitstream, based on the channel decoding mode, the left-channel bitstream is decoded but the right-channel bitstream is not decoded, or the right-channel bitstream is decoded but the left-channel bitstream is not decoded in the decoding process. Therefore, power consumption at the decoder side is reduced when resources at the decoder side are limited.

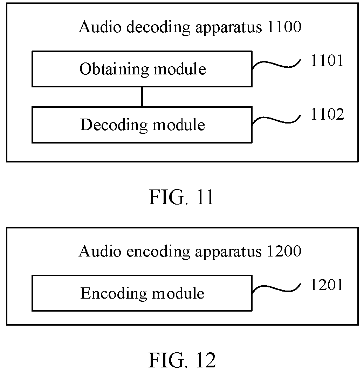

FIG. 11 is a diagram of a structure of an audio decoding apparatus 1100 according to an embodiment of this application. The audio decoding apparatus 1100 may be implemented as a part or the entire of an audio codec device by using software, hardware, or a combination thereof. Refer to FIG. 11. The apparatus 1100 includes an obtaining module 1101 and a decoding module 1102.

The obtaining module 1101 is configured to: if a to-be-decoded audio signal meets a first condition, obtain a channel decoding mode, where the first condition includes that the audio signal is a dual-channel signal, an encoding bit rate of the audio signal is not less than a bit rate threshold, and a sampling rate of the audio signal is not less than a sampling rate threshold.

The decoding module 1102 is configured to: if the channel decoding mode is a left-channel decoding mode, decode a left-channel bitstream in a bitstream, to obtain left-channel data of the audio signal; and duplicate the left-channel data to a right channel.

The decoding module 1102 is further configured to: if the channel decoding mode is a right-channel decoding mode, decode a right-channel bitstream in the bitstream, to obtain right-channel data of the audio signal; and duplicate the right-channel data to a left channel.

Optionally, the decoding module 1102 is further configured to: if the channel decoding mode is neither the left-channel decoding mode nor the right-channel decoding mode, decode the left-channel bitstream and the right-channel bitstream, to obtain the left-channel data and the right-channel data.

Optionally, the decoding module 1102 is further configured to: if the audio signal does not meet the first condition, when the audio signal is a dual-channel signal, decode a dual-channel interleaved bitstream in the bitstream, to obtain the left-channel data and the right-channel data.

Optionally, the decoding module 1102 is further configured to: if the audio signal does not meet the first condition, when the audio signal is a mono-channel signal, decode a mono-channel bitstream in the bitstream, to obtain mono-channel data of the audio signal.

Optionally, the apparatus 1100 further includes:
a second obtaining module, configured to obtain a total data amount of the bitstream, where
the decoding module is further configured to decode a packet header of the bitstream, to obtain a channel number, the sampling rate, and a frame length of the audio signal; and
a first determining module, configured to determine, based on the total data amount, the channel number, the sampling rate, and the frame length, whether the audio signal meets the first condition.

Optionally, the decoding module 1102 is further configured to decode a bitstream of side information in the bitstream, to obtain the side information, where the side information includes an encoding codebook identifier.

The apparatus 1100 further includes a second determining module, configured to determine, based on the encoding codebook identifier, a target decoding codebook for decoding from a plurality of decoding codebooks.

Optionally, the plurality of decoding codebooks are as follows:
{{0, 0, 4}, {1, 1, 4}, {2, 2, 4}, {3, 3, 4}, {4, 4, 41, {5, 5, 4}, {6,6,4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
   };
{{11, 0, 5}, {15, 1, 5}, {13, 2, 4}, {13, 3, 4}, {0, 4, 3}, {0, 5, 3}, {0, 6, 3}, {0, 7, 3},
{9, 8, 4}, {9, 9, 4}, {5, 10, 4}, {5, 11, 4}, {14, 12, 4}, {14, 13, 4}, {7, 14, 4}, {7, 15, 4}, {6, 16, 4}, {6, 17, 4}, {3, 18, 4}, {3, 19, 4}, {10, 20, 4}, {10, 21, 4}, {12, 22, 4}, {12, 23, 4}, {2, 24, 4}, {2, 25, 4}, {1, 26, 4}, {1, 27, 4}, {8, 28, 4}, {8, 29, 4}, {4, 30, 4}, {4, 31, 4}
   };
{{2, 0, 4}, {2, 1, 4}, {2, 2, 4}, {2, 3, 4}, {1, 4, 4}, {1, 5, 4}, {1,6,4}, {1, 7, 4},
{8, 8, 4}, {8, 9, 4}, {8, 10, 4}, {8, 11, 4}, {4, 12, 4}, {4, 13, 4}, {4, 14, 4}, {4, 15, 4}, {0, 16, 2}, {0, 17, 2}, {0, 18, 2}, {0, 19, 2}, {0, 20, 2}, {0, 21, 2}, {0, 22, 2}, {0, 23, 2},
{0, 24, 2}, {0, 25, 2}, {0, 26, 2}, {0, 27, 2}, {0, 28, 2}, {0, 29, 2}, {0, 30, 2}, {0, 31, 2}, {11, 32, 6}, {15, 33, 6}, {14, 34, 5}, {14, 35, 5}, {7, 36, 5}, {7, 37, 5}, {13, 38, 5},
{13, 39, 5}, {12, 40, 4}, {12, 41, 4}, {12, 42, 4}, {12, 43, 4}, {6, 44, 4}, {6, 45, 4},
{6, 46, 4}, {6, 47, 4}, {3, 48, 4}, {3, 49, 4}, {3, 50, 4}, {3, 51, 4}, {5, 52, 4}, {5, 53, 4}, {5, 54, 4}, {5, 55, 4}, {10, 56, 4}, {10, 57, 4}, {10, 58, 4}, {10, 59, 4}, {9, 60, 4}, {9, 61, 4}, {9, 62, 4}, {9, 63, 4}
   };
{{11, 0, 7}, {15, 1, 7}, {14, 2, 6}, {14, 3, 6}, {7, 4, 6}, {7, 5, 6}, {13, 6, 6}, {13, 7, 6}, {12, 8, 5}, {12, 9, 5}, {12, 10, 5}, {12, 11, 5}, {6, 12, 5}, {6, 13, 5}, {6, 14, 5}, {6, 15, 5}, {3, 16, 5}, {3, 17, 5}, {3, 18, 5}, {3, 19, 5}, {5, 20, 5}, {5, 21, 5}, {5, 22, 5}, {5, 23, 5}, {10, 24, 5}, {10, 25, 5}, {10, 26, 5}, {10, 27, 5}, {9, 28, 5}, {9, 29, 5}, {9, 30, 5}, {9, 31, 5}, {2, 32, 4}, {2, 33, 4}, {2, 34, 4}, {2, 35, 4}, {2, 36, 4}, {2, 37, 4}, {2, 38, 4}, {2, 39, 4}, {1, 40, 4}, {1, 41, 4}, {1, 42, 4}, {1, 43, 4}, {1, 44, 4}, {1, 45, 4}, {1, 46, 4}, {1, 47, 4}, {8, 48, 4}, {8, 49, 4}, {8, 50, 4}, {8, 51, 4}, {8, 52, 4}, {8, 53, 4}, {8, 54, 4}, {8, 55, 4}, {4, 56, 4}, {4, 57,4}, {4, 58, 4}, {4, 59, 4}, {4, 60, 4}, {4, 61, 4}, {4, 62, 4}, {4, 63, 4}, {0, 64, 1}, {0, 65, 1}, {0, 66, 1}, {0, 67, 1}, {0, 68, 1}, {0, 69, 1}, {0, 70, 1}, {0, 71, 1}, {0, 72, 1}, {0, 73, 1}, {0, 74, 1}, {0, 75, 1}, {0, 76, 1}, {0, 77, 1}, {0, 78, 1}, {0, 79, 1}, {0, 80, 1}, {0, 81, 1}, {0, 82, 1}, {0, 83, 1}, {0, 84, 1}, {0, 85, 1}, {0, 86, 1}, {0, 87, 1}, {0, 88, 1}, {0, 89, 1}, {0, 90, 1}, {0, 91, 1}, {0, 92, 1}, {0, 93, 1}, {0, 94, 1}, {0, 95, 1}, {0, 96, 1}, {0, 97, 1}, {0, 98, 1}, {0, 99, 1}, {0, 100, 1}, {0, 101, 1}, {0, 102, 1}, {0, 103, 1}, {0, 104, 1}, {0, 105, 1}, {0, 106, 1}, {0, 107, 1}, {0, 108, 1}, {0, 109, 1}, {0, 110, 1}, {0, 111, 1}, {0, 112, 1}, {0, 113, 1}, {0, 114, 1}, {0, 115, 1}, {0, 116, 1}, {0, 117, 1}, {0, 118, 1}, {0, 119, 1}, {0, 120, 1}, {0, 121, 1}, {0, 122, 1}, {0, 123, 1}, {0, 124, 1},
{0, 125, 1}, {0, 126, 1}, {0, 127, 1}
   };
{{11, 0, 5}, {15, 1, 5}, {14, 2, 4}, {14, 3, 4}, {0, 4, 3}, {0, 5, 3}, {0, 6, 3}, {0, 7, 3}, {7, 8, 4}, {7, 9, 4}, {9, 10, 4}, {9, 11, 4}, {10, 12, 4}, {10, 13, 4}, {13, 14, 4}, {13, 15, 4}, {3, 16, 4}, {3, 17, 4}, {8, 18, 4}, {8, 19, 4}, {6, 20, 4}, {6, 21, 4}, {12, 22, 4}, {12, 23, 4}, {4, 24, 4}, {4, 25, 4}, {1, 26, 4}, {1, 27, 4}, {2, 28, 4}, {2, 29, 4}, {5, 30, 4}, {5, 31, 4}
   };
{{2, 0, 4}, {2, 1, 4}, {5, 2, 4}, {5, 3, 4}, {0, 4, 3}, {0, 5, 3}, {0, 6, 3}, {0, 7, 3}, {10, 8, 5}, {13, 9, 5}, {7, 10, 5}, {14, 11, 5}, {12, 12, 4}, {12, 13, 4}, {3, 14, 4}, {3, 15, 4}, {8, 16, 4}, {8, 17, 4}, {9, 18, 4}, {9, 19, 4}, {6, 20, 4}, {6, 21, 4}, {11, 22, 5}, {15, 23, 5}, {4, 24, 3}, {4, 25, 3}, {4, 26, 3}, {4, 27, 3}, {1, 28, 3}, {1, 29, 3}, {1, 30, 3}, {1, 31, 3}
   };
{{4, 0, 4}, {4, 1, 4}, {1, 2, 4}, {1, 3, 4}, {2, 4, 4}, {2, 5, 4}, {5, 6, 4}, {5, 7, 4}, {0, 8, 2}, {0, 9, 2}, {0, 10, 2}, {0, 11, 2}, {0, 12, 2}, {0, 13, 2}, {0, 14, 2}, {0, 15, 2}, {10, 16, 5}, {13, 17, 5}, {7, 18, 5}, {14, 19, 5}, {12, 20, 4}, {12, 21, 4}, {3, 22, 4}, {3, 23, 4}, {8, 24, 4}, {8, 25, 4}, {9, 26, 4}, {9, 27, 4}, {6, 28, 4}, {6, 29, 4}, {11, 30, 5}, {15, 31, 5},
   };
{{10, 0, 6}, {13, 1, 6}, {7, 2, 6}, {14, 3, 6}, {12, 4, 5}, {12, 5, 5}, {3, 6, 5}, {3, 7, 5}, {8, 8, 5}, {8, 9, 5}, {9, 10, 5}, {9, 11, 5}, {6, 12, 5}, {6, 13, 5}, {11, 14, 6}, {15, 15, 6}, {4, 16, 4}, {4, 17, 4}, {4, 18, 4}, {4, 19, 4}, {1, 20, 4}, {1, 21, 4}, {1, 22, 4}, {1, 23, 4}, {2, 24, 4}, {2, 25, 4}, {2, 26, 4}, {2, 27, 4}, {5, 28, 4}, {5, 29, 4}, {5, 30, 4}, {5, 31, 4}, {0, 32, 1}, {0, 33, 1}, {0, 341}, {0, 35, 1}, {0, 36, 1}, {0, 37, 1}, {0, 38, 1}, {0, 39, 1}, {0, 40, 1}, {0, 41, 1}, {0, 42, 1}, {0, 43, 1}, {0, 44, 1}, {0, 45, 1}, {0, 46, 1}, {0, 47, 1}, {0, 48, 1}, {0, 49, 1}, {0, 50, 1}, {0, 51, 1}, {0, 52, 1}, {0, 53, 1}, {0, 54, 1}, {0, 55, 1}, {0, 56, 1}, {0, 57, 1}, {0, 58, 1}, {0, 59, 1}, {0, 60, 1}, {0, 61, 1}, {0, 62, 1}, {0, 63, 1}
   };
{{4, 0, 4}, {4, 1, 4}, {4, 2, 4}, {4, 3, 4}, {6, 4, 6}, {7, 5, 6}, {5, 6, 5}, {5, 7, 5}, {3, 8, 3}, {3, 9, 3}, {3, 10, 3}, {3, 11, 3}, {3, 12, 3}, {3, 13, 3}, {3, 14, 3}, {3, 15, 3}, {2, 16, 2}, {2, 17, 2}, {2, 18, 2}, {2, 19, 2}, {2, 20, 2}, {2, 21, 2}, {2, 22, 2}, {2, 23, 2}, {2, 24, 2}, {2, 25, 2}, {2, 26, 2}, {2, 27, 2}, {2, 28, 2}, {2, 29, 2}, {2, 30, 2}, {2, 31, 2}, {1, 32, 2}, {1, 33, 2}, {1, 34, 2}, {1, 35, 2}, {1, 36, 2}, {1, 37, 2}, {1, 38, 2}, {1, 39, 2}, {1, 40, 2}, {1, 41, 2}, {1, 42, 2}, {1, 43, 2}, {1, 44, 2}, {1, 45, 2}, {1, 46, 2}, {1, 47, 2}, {0, 48, 2}, {0, 49, 2}, {0, 50, 2}, {0, 51, 2}, {0, 52, 2}, {0, 53, 2}, {0, 54, 2}, {0, 55, 2}, {0, 56, 2}, {0, 57, 2}, {0, 58, 2}, {0, 59, 2}, {0, 60, 2}, {0, 61, 2}, {0, 62, 2}, {0, 63, 2}
   };
{{2, 0, 3}, {2, 1, 3}, {2, 2, 3}, {2, 3, 3}, {3, 4, 3}, {3, 5, 3}, {3, 6, 3}, {3, 7, 3}, {5, 8, 4}, {5, 9, 4}, {6, 10, 5}, {7, 11, 5}, {4, 12, 3}, {4, 13, 3}, {4, 14, 3}, {4, 15, 3}, {1, 16, 2}, {1, 17, 2}, {1, 18, 2}, {1, 19, 2}, {1, 20, 2}, {1, 21, 2}, {1, 22, 21, {1, 23, 2}, {0, 24, 2}, {0, 25, 2}, {0, 26, 2}, {0, 27, 2}, {0, 28, 2}, {0, 29, 2}, {0, 30, 2}, {0, 31, 2}
   };
{{0, 0, 1}, {0, 1, 1}, {0, 2, 1}, {0, 3, 1}, {0, 4, 1}, {0, 5, 1}, {0, 6, 1}, {0, 7, 1}, {0, 8, 1}, {0, 9, 1}, {0, 10, 1}, {0, 11, 1}, {0, 12, 1}, {0, 13, 1}, {0, 14, 1}, {0, 15, 1}, {0, 16, 1}, {0, 17, 1}, {0, 18, 1}, {0, 19, 1}, {0, 20, 1}, {0, 21, 1}, {0, 22, 1}, {0, 23, 1}, {0, 24, 1}, {0, 25, 1}, {0, 26, 1}, {0, 27, 1}, {0, 28, 1}, {0, 29, 1}, {0, 30, 1}, {0, 31, 1}, {5, 32, 5}, {5, 33, 5}, {6, 34, 6}, {7, 35, 6}, {4, 36, 4}, {4, 37, 4}, {4, 38, 4}, {4, 39, 4}, {1, 40, 3}, {1, 41, 3}, {1, 42, 3}, {1, 43, 3}, {1, 44, 3}, {1, 45, 3}, {1, 46, 3}, {1, 47, 3}, {2, 48, 3}, {2, 49, 3}, {2, 50, 3}, {2, 51, 3}, {2, 52, 3}, {2, 53, 3}, {2, 54, 3}, {2, 55, 3}, {3, 56, 3}, {3, 57, 3}, {3, 58, 3}, {3, 59, 3}, {3, 60, 3}, {3, 61, 3}, {3, 62, 3}, {3, 63, 3}
   }; and
{{0, 0, 3}, {1, 1, 3}, {2, 2, 3}, {3, 3, 3}, {4, 4, 3}, {5, 5, 3}, {6, 6, 3}, {7, 7, 3}
   }.

In embodiments of this application, when the audio signal is a dual-channel signal, even if the bitstream includes the left-channel bitstream and the right-channel bitstream, based on the channel decoding mode, the left-channel bitstream is decoded but the right-channel bitstream is not decoded, or the right-channel bitstream is decoded but the left-channel bitstream is not decoded in the decoding process. Therefore, power consumption at the decoder side is reduced when resources at the decoder side are limited. Correspondingly, an encoder side can also sequentially encode the left-channel data and the right-channel data based on the condition met by the audio signal, rather than performing encoding in the dual-channel interleaving encoding scheme or a dual-channel deinterleaving encoding scheme. It can be learned that a coding scheme in this solution is more flexible.

It should be noted that when the audio decoding apparatus provided in the foregoing embodiment decodes the audio signal, division of the foregoing functional modules is merely used as an example for description. During actual application, the foregoing functions may be allocated to different functional modules for implementation based on a requirement. In other words, an internal structure of the apparatus is divided into different functional modules to implement all or some of the functions described above. In addition, the audio decoding apparatus provided in the foregoing embodiment and the audio decoding method embodiments belong to a same concept. For specific implementation processes thereof, refer to the method embodiments. Details are not described herein again.

FIG. 12 is a diagram of a structure of an audio encoding apparatus 1200 according to an embodiment of this application. The audio encoding apparatus 1200 may be implemented as a part or the entire of an audio codec device by using software, hardware, or a combination thereof. Refer to FIG. 12. The apparatus 1200 includes an encoding module 1201.

The encoding module 1201 is configured to: if a to-be-encoded audio signal meets a first condition, encode left-channel data of the audio signal into a bitstream, and encode right-channel data of the audio signal into the bitstream, where the first condition includes that the audio signal is a dual-channel signal, an encoding bit rate of the audio signal is not less than a bit rate threshold, and a sampling rate of the audio signal is not less than a sampling rate threshold.

Optionally, the encoding module 1201 is further configured to:
if the audio signal does not meet the first condition, when the audio signal is a dual-channel signal, encode the left-channel data and the right-channel data into the bitstream in a dual-channel interleaving encoding scheme.

Optionally, the encoding module 1201 is further configured to:
if the audio signal does not meet the first condition, when the audio signal is a mono-channel signal, encode mono-channel data of the audio signal into the bitstream.

Optionally, the encoding module 1201 includes:
an obtaining submodule, configured to obtain a quantization level measurement factor of each of a plurality of sub-bands, where the quantization level measurement factor indicates an average number of bits for encoding each spectral value in a corresponding sub-band, and the plurality of sub-bands are a plurality of sub-bands to which quantized spectrum data included in the left-channel data is allocated;
a grouping submodule, configured to group the plurality of sub-bands into a plurality of groups of sub-bands based on the quantization level measurement factors of the plurality of sub-bands, where quantization level measurement factors of sub-bands in a same group are the same;
a determining submodule, configured to determine, from a plurality of encoding codebooks based on a quantization level measurement factor of each group of sub-bands, a target encoding codebook corresponding to each group of sub-bands, and determine a bitstream of spectral values in each group of sub-bands, where the target encoding codebook is an encoding codebook used to encode spectral values in a corresponding group of sub-bands; and
an encoding submodule, configured to encode, as a type of side information of the left-channel data, an identifier of the target encoding codebook corresponding to each group of sub-bands into the bitstream.

Optionally, the determining submodule is configured to:
for any one of the plurality of groups of sub-bands, if a quantization level measurement factor of the any group of sub-bands is a first value, separately encode spectral values in the any group of sub-bands by using a plurality of first encoding codebooks in the plurality of encoding codebooks, to obtain a plurality of first candidate spectral bitstreams that one-to-one correspond to the plurality of first encoding codebooks; and
determine, as a bitstream of the spectral values in the any group of sub-bands, a first candidate spectral bitstream with a minimum total number of bits in the plurality of first candidate spectral bitstreams, and determine, as a target encoding codebook corresponding to the any group of sub-bands, a first encoding codebook corresponding to the first candidate spectral bitstream with the minimum total number of bits.

Optionally, the first value is 1.

The separately encoding spectral values in the any group of sub-bands by using a plurality of first encoding codebooks in the plurality of encoding codebooks includes:
combining every four spectral values in the any group of sub-bands into a binary number; and
separately encoding, by using the plurality of first encoding codebooks, a decimal number represented by the binary number.

The plurality of first encoding codebooks are as follows:
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
   };
{{0, 1, 3}, {1, 13, 4}, {2, 12, 4}, {3, 9, 4}, {4, 15, 4}, {5, 5, 4}, {6, 8, 4}, {7, 7, 4},
{8, 14, 4}, {9, 4, 4}, {10, 10, 4}, {11, 0, 5}, {12, 11, 4}, {13, 1, 4}, {14, 6, 4}, {15, 1, 5}
   };
{{0, 1, 2}, {1, 1, 4}, {2, 0, 4}, {3, 12, 4}, {4, 3, 4}, {5, 13, 4}, {6, 11, 4}, {7, 18, 5},
{8, 2, 4}, {9, 15, 4}, {10, 14, 4}, {11, 32, 6}, {12, 10, 4}, {13, 19, 5}, {14, 17, 5}, {15, 33, 6}
   }; and
{{0, 1, 1}, {1, 5, 4}, {2, 4, 4}, {3, 4, 5}, {4, 7, 4}, {5, 5, 5}, {6, 3, 5}, {7, 2, 6},
{8, 6, 4}, {9, 7, 5}, {10, 6, 5}, {11, 0, 7}, {12, 2, 5}, {13, 3, 6}, {14, 1, 6}, {15, 1, 7}
   }.

Optionally, the determining submodule is configured to:
for any one of the plurality of groups of sub-bands, if a quantization level measurement factor of the any group of sub-bands is a second value, separately encode spectral values in the any group of sub-bands by using a plurality of second encoding codebooks in the plurality of encoding codebooks, to obtain a plurality of second candidate spectral bitstreams that one-to-one correspond to the plurality of second encoding codebooks; and
determine, as a bitstream of the spectral values in the any group of sub-bands, a second candidate spectral bitstream with a minimum total number of bits in the plurality of second candidate spectral bitstreams, and determine, as a target encoding codebook corresponding to the any group of sub-bands, a second encoding codebook corresponding to the second candidate spectral bitstream with the minimum total number of bits.

Optionally, the second value is 2.

The separately encoding spectral values in the any group of sub-bands by using a plurality of second encoding codebooks in the plurality of encoding codebooks includes:
combining every two spectral values in the any group of sub-bands into a binary number; and
separately encoding, by using the plurality of second encoding codebooks, a decimal number represented by the binary number.

The plurality of second encoding codebooks are as follows:
{{0, 1, 3}, {1, 13, 4}, {2, 14, 4}, {3, 8, 4}, {4, 12, 4}, {5, 15, 4}, {6, 10, 4}, {7, 4, 4}, {8, 9, 4}, {9, 5, 4}, {10, 6, 4}, {11, 0, 5}, {12, 11, 4}, {13, 7, 4}, {14, 1, 4}, {15, 1, 5}
   };
{{0, 1, 3}, {1, 7, 3}, {2, 0, 4}, {3, 7, 4}, {4, 6, 3}, {5, 1, 4}, {6, 10, 4}, {7, 10, 5},
{8, 8, 4}, {9, 9, 4}, {10, 8, 5}, {11, 22, 5}, {12, 6, 4}, {13, 9, 5}, {14, 11, 5}, {15, 23, 5}
   };
{{0, 1, 2}, {1, 1, 4}, {2, 2, 4}, {3, 11, 4}, {4, 0, 4}, {5, 3, 4}, {6, 14, 4}, {7, 18, 5},
{8, 12, 4}, {9, 13, 4}, {10, 16, 5}, {11, 30, 5}, {12, 10, 4}, {13, 17, 5}, {14, 19, 5}, {15, 31, 5}
   }; and
{{0, 1, 1}, {1, 5, 4}, {2, 6, 4}, {3, 3, 5}, {4, 4, 4}, {5, 7, 4}, {6, 6, 5}, {7, 2, 6},
{8, 4, 5}, {9, 5, 5}, {10, 0, 6}, {11, 14, 6}, {12, 2, 5}, {13, 1, 6}, {14, 3, 6}, {15, 15, 6}
   }.

Optionally, the determining submodule is configured to:
for any one of the plurality of groups of sub-bands, if a quantization level measurement factor of the any group of sub-bands is a third value, separately encode spectral values in the any group of sub-bands by using a plurality of third encoding codebooks in the plurality of encoding codebooks, to obtain a plurality of third candidate spectral bitstreams that one-to-one correspond to the plurality of third encoding codebooks; and
determine, as a bitstream of the spectral values in the any group of sub-bands, a third candidate spectral bitstream with a minimum total number of bits in the plurality of third candidate spectral bitstreams, and determine, as a target encoding codebook corresponding to the any group of sub-bands, a third encoding codebook corresponding to the third candidate spectral bitstream with the minimum total number of bits.

Optionally, the determining submodule is configured to:
for any one of the plurality of groups of sub-bands, if a quantization level measurement factor of the any group of sub-bands is a fourth value, separately encode a first part of bits in each spectral value in the any group of sub-bands by using the plurality of third encoding codebooks, to obtain a plurality of first-part candidate bitstreams that one-to-one correspond to the plurality of third encoding codebooks;
determine, as a bitstream of the first part of bits, a first-part candidate bitstream with a minimum total number of bits in the plurality of first-part candidate bitstreams, and determine, as a target encoding codebook corresponding to the any group of sub-bands, a third encoding codebook corresponding to the first-part candidate bitstream with the minimum total number of bits; and
perform uniform quantization encoding on a second part of bits other than the first part of bits in each spectral value in the any group of sub-bands, to obtain a bitstream of the second part of bits.

Optionally, the first part of bits are N high-order bits in the spectral value, and the second part of bits are M low-order bits in the spectral value, where M is equal to the quantization level measurement factor of the any group of sub-bands minus the third value.

Optionally, the third value is 3.

The separately encoding spectral values in the any group of sub-bands by using a plurality of third encoding codebooks in the plurality of encoding codebooks includes:
separately encoding all of the spectral values in the any group of sub-bands by using the plurality of third encoding codebooks.

The plurality of third encoding codebooks are as follows:
{{0, 3, 2}, {1, 2, 2}, {2, 1, 2}, {3, 1, 3}, {4, 0, 4}, {5, 3, 5}, {6, 4, 6}, {7, 5, 6}
   };
{{0, 3, 2}, {1, 2, 2}, {2, 0, 3}, {3, 1, 3}, {4, 3, 3}, {5, 4, 4}, {6, 10, 5}, {7, 11, 5}
   };
{{0, 0, 1}, {1, 5, 3}, {2, 6, 3}, {3, 7, 3}, {4, 9, 4}, {5, 16, 5}, {6, 34, 6}, {7, 35, 6}
   }; and
{{0, 0, 3}, {1, 1, 3}, {2, 2, 3}, {3, 3, 3}, {4, 4, 3}, {5, 5, 3}, {6, 6, 3}, {7, 7, 3}
   }.

In embodiments of this application, when the audio signal is a dual-channel signal, even if the bitstream includes the left-channel bitstream and the right-channel bitstream, based on the channel decoding mode, the left-channel bitstream is decoded but the right-channel bitstream is not decoded, or the right-channel bitstream is decoded but the left-channel bitstream is not decoded in the decoding process. Therefore, power consumption at the decoder side is reduced when resources at the decoder side are limited. Correspondingly, an encoder side can also sequentially encode the left-channel data and the right-channel data based on the condition met by the audio signal, rather than performing encoding in the dual-channel interleaving encoding scheme or a dual-channel deinterleaving encoding scheme. It can be learned that a coding scheme in this solution is more flexible.

It should be noted that when the audio encoding apparatus provided in the foregoing embodiment encodes the audio signal, division of the foregoing functional modules is merely used as an example for description. During actual application, the foregoing functions may be allocated to different functional modules for implementation based on a requirement. In other words, an internal structure of the apparatus is divided into different functional modules to implement all or some of the functions described above. In addition, the audio encoding apparatus provided in the foregoing embodiment and the audio encoding method embodiments belong to a same concept. For specific implementation processes thereof, refer to the method embodiments. Details are not described herein again.

All or some of the foregoing embodiments may be implemented by software, hardware, firmware, or any combination thereof. When software is used for implementation, all or some of embodiments may be implemented in a form of a computer program product. The computer program product includes one or more computer instructions. When the computer instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium, or may be transmitted from a computer-readable storage medium to another computer-readable storage medium. For example, the computer instructions may be transmitted from a website, a computer, a server or a data center to another website, computer, server or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a digital versatile disc (digital versatile disc, DVD)), a semiconductor medium (for example, a solid-state disk (solid-state disk, SSD)), or the like. It should be noted that the computer-readable storage medium mentioned in embodiments of this application may be a non-volatile storage medium, that is, may be a non-transitory storage medium.

It should be understood that "at least one" mentioned in this specification indicates one or more, and "a plurality of" indicates two or more. In the descriptions of embodiments of this application, unless otherwise stated, "/" means "or", for example, A/B may represent A or B. In this specification, "and/or" describes only an association relationship between associated objects, and indicates that three relationships may exist. For example, A and/or B may represent three cases: Only A exists, both A and B exist, and only B exists. In addition, to clearly describe the technical solutions in embodiments of this application, terms such as "first" and "second" are used in embodiments of this application to distinguish between same items or similar items that have basically same functions and purposes. A person skilled in the art may understand that the terms such as "first" and "second" do not limit a quantity or an execution sequence, and the terms such as "first" and "second" do not indicate a definite difference.

It should be noted that information (including but not limited to user equipment information, personal information of a user, and the like), data (including but not limited to data used for analysis, stored data, displayed data, and the like), and signals in embodiments of this application are used under authorization by the user or full authorization by all parties, and capturing, use, and processing of related data need to conform to related laws, regulations, and standards of related countries and regions.

The foregoing descriptions are embodiments provided in this application, but are not intended to limit this application. Any modification, or improvement made without departing from the principle of this application shall fall within the protection scope of this application.

## Claims

1. An audio decoding method, wherein the method comprises:
if a to-be-decoded audio signal meets a first condition, obtaining a channel decoding mode, wherein the first condition comprises that the audio signal is a dual-channel signal, an encoding bit rate of the audio signal is not less than a bit rate threshold, and a sampling rate of the audio signal is not less than a sampling rate threshold;
if the channel decoding mode is a left-channel decoding mode, decoding a left-channel bitstream in a bitstream, to obtain left-channel data of the audio signal; and duplicating the left-channel data to a right channel; and
if the channel decoding mode is a right-channel decoding mode, decoding a right-channel bitstream in the bitstream, to obtain right-channel data of the audio signal; and duplicating the right-channel data to a left channel.

2. The method according to claim 1, wherein the method further comprises:
if the channel decoding mode is neither the left-channel decoding mode nor the right-channel decoding mode, decoding the left-channel bitstream and the right-channel bitstream, to obtain the left-channel data and the right-channel data.

3. The method according to claim 1 or 2, wherein the method further comprises:
if the audio signal does not meet the first condition, when the audio signal is a dual-channel signal, decoding a dual-channel interleaved bitstream in the bitstream, to obtain the left-channel data and the right-channel data.

4. The method according to any one of claims 1 to 3, wherein the method further comprises:
if the audio signal does not meet the first condition, when the audio signal is a mono-channel signal, decoding a mono-channel bitstream in the bitstream, to obtain mono-channel data of the audio signal.

5. The method according to any one of claims 1 to 4, wherein the method further comprises:
obtaining a total data amount of the bitstream;
decoding a packet header of the bitstream, to obtain a channel number, the sampling rate, and a frame length of the audio signal; and
determining, based on the total data amount, the channel number, the sampling rate, and the frame length, whether the audio signal meets the first condition.

6. The method according to any one of claims 1 to 5, wherein the method further comprises:
decoding a bitstream of side information in the bitstream, to obtain the side information, wherein the side information comprises an encoding codebook identifier; and
determining, based on the encoding codebook identifier, a target decoding codebook for decoding from a plurality of decoding codebooks.

7. The method according to claim 6, wherein the plurality of decoding codebooks comprise at least parts of decoding codebooks as follows:
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
};
{{11, 0, 5}, {15, 1, 5}, {13, 2, 4}, {13, 3, 4}, {0, 4, 3}, {0, 5, 3}, {0, 6, 3}, {0, 7, 3},
{9, 8, 4}, {9, 9, 4}, {5, 10, 4}, {5, 11, 4}, {14, 12, 4}, {14, 13, 4}, {7, 14, 4}, {7, 15, 4}, {6, 16, 4}, {6, 17, 4}, {3, 18, 4}, {3, 19, 4}, {10, 20, 4}, {10, 21, 4}, {12, 22, 4}, {12, 23, 4}, {2, 24, 4}, {2, 25, 4}, {1, 26, 4}, {1, 27, 4}, {8, 28, 4}, {8, 29, 41, {4, 30, 4}, {4, 31, 4}
};
{{2, 0, 4}, {2, 1, 4}, {2, 2, 4}, {2, 3, 4}, {1, 4, 4}, {1, 5, 4}, {1, 6, 4}, {1, 7, 4},
{8, 8, 4}, {8, 9, 4}, {8, 10, 4}, {8, 11, 4}, {4, 12, 4}, {4, 13, 4}, {4, 14, 4}, {4, 15, 4}, {0, 16, 2}, {0, 17, 2}, {0, 18, 2}, {0, 19, 2}, {0, 20, 2}, {0, 21, 2}, {0, 22, 2}, {0, 23, 2},
{0, 24, 2}, {0, 25, 2}, {0, 26, 2}, {0, 27, 2}, {0, 28, 2}, {0, 29, 2}, {0, 30, 2}, {0, 31, 2}, {11, 32, 6}, {15, 33, 6}, {14, 34, 5}, {14, 35, 5}, {7, 36, 5}, {7, 37, 5}, {13, 38, 5},
{13, 39, 5}, {12, 40, 4}, {12, 41, 4}, {12, 42, 4}, {12, 43, 4}, {6, 44, 4}, {6, 45, 4},
{6, 46, 4}, {6, 47, 4}, {3, 48, 4}, {3, 49, 4}, {3, 50, 4}, {3, 51, 4}, {5, 52, 4}, {5, 53, 4}, {5, 54, 4}, {5, 55, 4},
{10, 56, 4}, {10, 57, 4}, {10, 58, 4}, {10, 59, 4}, {9, 60, 4}, {9, 61, 4}, {9, 62, 4}, {9, 63, 4}
};
{{11, 0, 7}, {15, 1, 7}, {14, 2, 6}, {14, 3, 6}, {7, 4, 6}, {7, 5, 6}, {13, 6, 6}, {13, 7, 6}, {12, 8, 5}, {12, 9, 5}, {12, 10, 5}, {12, 11, 5}, {6, 12, 5}, {6, 13, 5}, {6, 14, 5}, {6, 15, 5}, {3, 16, 5}, {3, 17, 5}, {3, 18, 5}, {3, 19, 5}, {5, 20, 5}, {5, 21, 5}, {5, 22, 5}, {5, 23, 5}, {10, 24, 5}, {10, 25, 5}, {10, 26, 5}, {10, 27, 5}, {9, 28, 5}, {9, 29, 5}, {9, 30, 5}, {9, 31, 5}, {2, 32, 4}, {2, 33, 4}, {2, 34, 4}, {2, 35, 4}, {2, 36, 4}, {2, 37, 4}, {2, 38, 4}, {2, 39, 4}, {1, 40, 4}, {1, 41, 4}, {1, 42, 4}, {1, 43, 4}, {1, 44, 4}, {1, 45, 4}, {1, 46, 4}, {1, 47, 4}, {8, 48, 4}, {8, 49, 4}, {8, 50, 4}, {8, 51, 4}, {8, 52, 4}, {8, 53, 4}, {8, 54, 4}, {8, 55, 4}, {4, 56, 4}, {4, 57, 4}, {4, 58, 4}, {4, 59, 4}, {4, 60, 4}, {4, 61, 4}, {4, 62, 4}, {4, 63, 4}, {0, 64, 1}, {0, 65, 1}, {0, 66, 1}, {0, 67, 1}, {0,68, 1}, {0, 69, 1}, {0, 70, 1}, {0, 71, 1}, {0, 72, 1}, {0, 73, 1}, {0, 74, 1}, {0, 75, 13}, {0, 76, 1}, {0, 77, 1}, {0, 78, 1}, {0, 79, 1}, {0, 80, 1}, {0, 81, 1}, {0, 82, 1}, {0, 83, 1}, {0, 84, 1}, {0, 85, 1}, {0, 86, 1}, {0, 87, 1}, {0, 88, 1}, {0, 89, 1}, {0, 90, 1}, {0, 91, 1}, {0, 92, 1}, {0, 93, 1}, {0, 94, 1}, {0, 95, 1}, {0, 96, 1}, {0, 97, 1}, {0, 98, 1}, {0, 99, 1}, {0, 100, 1}, {0, 101, 1}, {0, 102, 1}, {0, 103, 1}, {0, 104, 1}, {0, 105, 1}, {0, 106, 1}, {0, 107, 1}, {0, 108, 1}, {0, 109, 1}, {0, 110, 1}, {0, 111, 1}, {0, 112, 1}, {0, 113, 1}, {0, 114, 1}, {0, 115, 1}, {0, 116, 1}, {0, 117, 1}, {0, 118, 1}, {0, 119, 1}, {0, 120, 1}, {0, 121, 1}, {0, 122, 1}, {0, 123, 1}, {0, 124, 1},
{0, 125, 1}, {0, 126, 1}, {0, 127, 1}
};
{{11, 0, 5}, {15, 1, 5}, {14, 2, 4}, {14, 3, 4}, {0, 4, 3}, {0, 5, 3}, {0, 6, 3}, {0, 7, 3}, {7, 8, 4}, {7, 9, 4}, {9, 10, 4}, {9, 11, 4}, {10, 12, 4}, {10, 13, 4}, {13, 14, 4}, {13, 15, 4}, {3, 16, 4}, {3, 17, 4}, {8, 18, 4}, {8, 19, 4}, {6, 20, 4}, {6, 21, 4}, {12, 22, 4}, {12, 23, 4}, {4, 24, 4}, {4, 25, 4}, {1, 26, 4}, {1, 27, 4}, {2, 28, 4}, {2, 29, 4}, {5, 30, 4}, {5,31,4}
};
{{2, 0, 4}, {2, 1, 4}, {5, 2, 4}, {5, 3, 4}, {0, 4, 3}, {0, 5, 3}, {0, 6, 3}, {0, 7, 3}, {10, 8, 5}, {13, 9, 5}, {7, 10, 5},
{14, 11, 5}, {12, 12, 4}, {12, 13,4}, {3, 14, 4}, {3, 15, 4}, {8, 16, 4}, {8, 17, 4}, {9, 18, 4}, {9, 19, 4}, {6, 20, 4}, {6, 21, 4}, {11, 22, 5}, {15, 23, 5}, {4, 24, 3}, {4, 25, 3}, {4, 26, 3}, {4, 27, 3}, {1, 28, 3}, {1, 29, 3}, {1, 30, 3}, {1, 31, 3}
};
{{4, 0, 4}, {4, 1, 4}, {1, 2, 4}, {1, 3, 4}, {2, 4, 4}, {2, 5, 4}, {5, 6, 4}, {5, 7, 4}, {0, 8, 2}, {0, 9, 2}, {0, 10, 2}, {0, 11, 2}, {0, 12, 2}, {0, 13, 2}, {0, 14, 2}, {0, 15, 2}, {10, 16, 5}, {13, 17, 5}, {7, 18, 5}, {14, 19, 5}, {12, 20, 4}, {12, 21, 4}, {3, 22, 4}, {3, 23, 4}, {8, 24, 4}, {8, 25, 4}, {9, 26, 4}, {9,27, 4}, {6, 28, 4},{6,29, 4}, {11, 30, 5}, {15, 31, 5},
};
{{10, 0, 6}, {13, 1, 6}, {7, 2, 6}, {14, 3, 6}, {12, 4, 5}, {12, 5, 5}, {3, 6, 5}, {3, 7, 5}, {8, 8, 5}, {8, 9, 5}, {9, 10,
5}, {9, 11, 5}, {6, 12, 5}, {6, 13, 5}, {11, 14, 6}, {15, 15, 6}, {4, 16, 4}, {4, 17, 4}, {4, 18, 4}, {4, 19, 4}, {1, 20, 4}, {1, 21, 4}, {1, 22, 4}, {1, 23, 4}, {2, 24, 4}, {2, 25, 4}, {2, 26, 4}, {2, 27, 4}, {5, 28, 4}, {5, 29, 4}, {5, 30, 4}, {5, 31, 4}, {0, 32, 1}, {0, 33, 1}, {0, 34, 1}, {0, 35, 1}, {0, 36, 1}, {0, 37, 1}, {0, 38, 1}, {0, 39, 1}, {0, 40, 1}, {0, 41, 1}, {0, 42, 1}, {0, 43, 1}, {0, 44, 1}, {0, 45, 1}, {0, 46, 1}, {0, 47, 1}, {0, 48, 1}, {0, 49, 1}, {0, 50, 1}, {0, 51, 1}, {0, 52, 1}, {0, 53, 1}, {0, 54, 1}, {0, 55, 1}, {0, 56, 1}, {0, 57, 1}, {0, 58, 1}, {0, 59, 1}, {0, 60, 1}, {0, 61, 1}, {0, 62, 1}, {0, 63, 1}
};
{{4, 0, 4}, {4, 1, 4}, {4, 2, 4}, {4, 3, 4}, {6, 4, 6}, {7, 5, 6}, {5, 6, 5}, {5, 7, 5}, {3, 8, 3}, {3, 9, 3}, {3, 10, 3}, {3, 11, 3}, {3, 12, 3}, {3, 13, 3}, {3, 14, 3}, {3, 15, 3}, {2, 16, 2}, {2, 17, 2}, {2, 18, 2}, {2, 19, 2}, {2, 20, 2}, {2, 21, 2}, {2, 22, 2}, {2, 23, 2}, {2, 24, 2}, {2, 25, 2}, {2, 26, 2}, {2, 27, 2}, {2, 28, 2}, {2, 29, 2}, {2, 30, 2}, {2, 31, 2}, {1, 32, 2}, {1, 33, 2}, {1, 34, 2}, {1, 35, 2}, {1, 36, 2}, {1, 37, 2}, {1, 38, 2}, {1, 39, 2}, {1, 40, 2}, {1, 41, 2}, {1, 42, 2}, {1, 43, 2}, {1, 44, 2}, {1, 45, 2}, {1, 46, 2}, {1, 47, 2}, {0, 48, 2}, {0, 49, 2}, {0, 50, 2}, {0, 51, 2}, {0, 52, 2}, {0, 53, 2}, {0, 54, 2}, {0, 55, 2}, {0, 56, 2}, {0, 57, 2}, {0, 58, 21, {0, 59, 2}, {0, 60, 2}, {0, 61, 2}, {0, 62, 2}, {0, 63, 2}
};
{{2, 0, 3}, {2, 1, 3}, {2, 2, 3}, {2, 3, 3}, {3, 4, 3}, {3, 5, 3}, {3, 6, 3}, {3, 7, 3}, {5, 8, 4}, {5, 9, 4}, {6, 10, 5}, {7, 11, 5}, {4, 12, 3}, {4, 13, 3}, {4, 14, 3}, {4, 15, 3}, {1, 16, 2}, {1, 17, 2}, {1, 18, 2}, {1, 19, 2}, {1, 20, 2}, {1, 21, 2}, {1, 22, 2}, {1, 23, 2}, {0, 24, 2}, {0, 25, 2}, {0, 26, 2}, {0, 27, 2}, {0, 28, 2}, {0, 29, 2}, {0, 30, 2}, {0, 31, 2}
};
{{0, 0, 1}, {0, 1, 1}, {0, 2, 1}, {0, 3, 1}, {0, 4, 1}, {0, 5, 1}, {0, 6, 1}, {0, 7, 1}, {0, 8, 1}, {0, 9, 1}, {0, 10, 1}, {0, 11, 1}, {0, 12, 1}, {0, 13, 1}, {0, 14, 1}, {0, 15, 1}, {0, 16, 1}, {0, 17, 1}, {0, 18, 1}, {0, 19, 1}, {0, 20, 1}, {0, 21, 1}, {0, 22, 1}, {0, 23, 1}, {0, 24, 1}, {0, 25, 1}, {0, 26, 1}, {0, 27, 1}, {0, 28, 1}, {0, 29, 1}, {0, 30, 1}, {0, 31, 1}, {5, 32, 5}, {5, 33, 5}, {6, 34, 6}, {7, 35, 6}, {4, 36, 4}, {4, 37, 4}, {4, 38, 4}, {4, 39, 4}, {1, 40, 3}, {1, 41, 3}, {1, 42, 3}, {1, 43, 3}, {1, 44, 3}, {1, 45, 3}, {1, 46, 3}, {1, 47, 3}, {2, 48, 3}, {2, 49, 3}, {2, 50, 3}, {2, 51, 3}, {2, 52, 3}, {2, 53, 3}, {2, 54, 3}, {2, 55, 3}, {3, 56, 3}, {3, 57, 3}, {3, 58, 3}, {3, 59, 3}, {3, 60, 3}, {3, 61, 3}, {3, 62, 3}, {3, 63, 3}
}; and
{{0, 0, 3}, {1, 1, 3}, {2, 2, 3}, {3, 3, 3}, {4, 4, 3}, {5, 5, 3}, {6, 6, 3}, {7, 7, 3}
}.

8. An audio encoding method, wherein the method comprises:
if a to-be-encoded audio signal meets a first condition, encoding left-channel data of the audio signal into a bitstream, and encoding right-channel data of the audio signal into the bitstream, wherein the first condition comprises that the audio signal is a dual-channel signal, an encoding bit rate of the audio signal is not less than a bit rate threshold, and a sampling rate of the audio signal is not less than a sampling rate threshold.

9. The method according to claim 8, wherein the method further comprises:
if the audio signal does not meet the first condition, when the audio signal is a dual-channel signal, encoding the left-channel data and the right-channel data into the bitstream in a dual-channel interleaving encoding scheme.

10. The method according to claim 8 or 9, wherein the method further comprises:
if the audio signal does not meet the first condition, when the audio signal is a mono-channel signal, encoding mono-channel data of the audio signal into the bitstream.

11. The method according to any one of claims 8 to 10, wherein the encoding the left-channel data of the audio signal into the bitstream comprises:
obtaining a quantization level measurement factor of each of a plurality of sub-bands, wherein the quantization level measurement factor indicates an average number of bits for encoding each spectral value in a corresponding subband, and the plurality of sub-bands are a plurality of sub-bands to which quantized spectrum data comprised in the left-channel data is allocated;
grouping the plurality of sub-bands into a plurality of groups of sub-bands based on the quantization level measurement factors of the plurality of sub-bands, wherein quantization level measurement factors of sub-bands in a same group are the same;
determining, from a plurality of encoding codebooks based on a quantization level measurement factor of each group of sub-bands, a target encoding codebook corresponding to each group of sub-bands, and determining a bitstream of spectral values in each group of sub-bands, wherein the target encoding codebook is an encoding codebook used to encode spectral values in a corresponding group of sub-bands; and
encoding, as a type of side information of the left-channel data, an identifier of the target encoding codebook corresponding to each group of sub-bands into the bitstream.

12. The method according to claim 11, wherein the determining, from a plurality of encoding codebooks based on a quantization level measurement factor of each group of sub-bands, a target encoding codebook corresponding to each group of sub-bands, and determining a bitstream of spectral values in each group of sub-bands comprises:
for any one of the plurality of groups of sub-bands, if a quantization level measurement factor of the any group of sub-bands is a first value, separately encoding spectral values in the any group of sub-bands by using a plurality of first encoding codebooks in the plurality of encoding codebooks, to obtain a plurality of first candidate spectral bitstreams that one-to-one correspond to the plurality of first encoding codebooks; and
determining, as a bitstream of the spectral values in the any group of sub-bands, a first candidate spectral bitstream with a minimum total number of bits in the plurality of first candidate spectral bitstreams, and determining, as a target encoding codebook corresponding to the any group of sub-bands, a first encoding codebook corresponding to the first candidate spectral bitstream with the minimum total number of bits.

13. The method according to claim 12, wherein the first value is 1; and
the separately encoding spectral values in the any group of sub-bands by using a plurality of first encoding codebooks in the plurality of encoding codebooks comprises:
combining every four spectral values in the any group of sub-bands into a binary number; and
separately encoding, by using the plurality of first encoding codebooks, a decimal number represented by the binary number, wherein
the plurality of first encoding codebooks comprise at least parts of decoding codebooks as follows:
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4} };
{{0, 1, 3}, {1, 13, 4}, {2, 12, 4}, {3, 9, 4}, {4, 15, 4}, {5, 5, 4}, {6, 8, 4}, {7, 7, 4},
{8, 14, 4}, {9, 4, 4}, {10, 10, 4}, {11, 0, 5}, {12, 11, 4}, {13, 1, 4}, {14, 6, 4}, {15, 1, 5}
};
{{0, 1, 2}, {1, 1, 4}, {2, 0, 4}, {3, 12, 4}, {4, 3, 4}, {5, 13, 4}, {6, 11, 4}, {7, 18, 5},
{8, 2, 4}, {9, 15, 4}, {10, 14, 4}, {11, 32, 6}, {12, 10, 4}, {13, 19, 5}, {14, 17, 5}, {15, 33, 6}
}; and
{{0, 1, 1}, {1, 5, 4}, {2, 4, 4}, {3, 4, 5}, {4, 7, 4}, {5, 5, 5}, {6, 3, 5}, {7, 2, 6},
{8, 6, 4}, {9, 7, 5}, {10, 6, 5}, {11, 0, 7}, {12, 2, 5}, {13, 3, 6}, {14, 1, 6}, {15, 1, 7}
}.

14. The method according to any one of claims 11 to 13, wherein the determining, from a plurality of encoding codebooks based on a quantization level measurement factor of each group of sub-bands, a target encoding codebook corresponding to each group of sub-bands, and determining a bitstream of spectral values in each group of sub-bands comprises:
for any one of the plurality of groups of sub-bands, if a quantization level measurement factor of the any group of sub-bands is a second value, separately encoding spectral values in the any group of sub-bands by using a plurality of second encoding codebooks in the plurality of encoding codebooks, to obtain a plurality of second candidate spectral bitstreams that one-to-one correspond to the plurality of second encoding codebooks; and
determining, as a bitstream of the spectral values in the any group of sub-bands, a second candidate spectral bitstream with a minimum total number of bits in the plurality of second candidate spectral bitstreams, and determining, as a target encoding codebook corresponding to the any group of sub-bands, a second encoding codebook corresponding to the second candidate spectral bitstream with the minimum total number of bits.

15. A device, wherein the device comprises a memory and a processor;
the memory is configured to store a computer program, wherein the computer program comprises program instructions; and
the processor is configured to invoke the computer program, to implement the audio decoding method according to any one of claims 1 to 7 or to implement the audio encoding method according to any one of claims 8 to 14.

## Patentansprüche

1. Audiodecodierungsverfahren, wobei das Verfahren umfasst:
falls ein zu decodierendes Audiosignal eine erste Bedingung erfüllt, Erhalten eines Kanaldecodiermodus, wobei die erste Bedingung umfasst, dass das Audiosignal ein Zweikanal-Signal ist, eine Codierbitrate des Audiosignals nicht kleiner als ein Bitratenschwellenwert ist und eine Abtastrate des Audiosignals nicht kleiner als ein Abtastratenschwellenwert ist;
falls der Kanaldecodiermodus ein Linkskanal-Decodiermodus ist, Decodieren eines Linkskanal-Bitstroms in einem Bitstrom, um Linkskanal-Daten des Audiosignals zu erhalten; und Duplizieren der Linkskanal-Daten auf einen rechten Kanal; und
falls der Kanaldecodiermodus ein Rechtskanal-Decodiermodus ist, Decodieren eines Rechtskanal-Bitstroms in dem Bitstrom, um Rechtskanal-Daten des Audiosignals zu erhalten; und Duplizieren der Rechtskanal-Daten auf einen linken Kanal.

2. Verfahren nach Anspruch 1, wobei das Verfahren ferner umfasst:
falls der Kanaldecodiermodus weder der Linkskanal-Decodiermodus noch der Rechtskanal-Decodiermodus ist, Decodieren des Linkskanal-Bitstroms und des Rechtskanal-Bitstroms, um die Linkskanal-Daten und die Rechtskanal-Daten zu erhalten.

3. Verfahren nach Anspruch 1 oder 2, wobei das Verfahren ferner umfasst:
falls das Audiosignal die erste Bedingung nicht erfüllt, wenn das Audiosignal ein Zweikanal-Signal ist, Decodieren eines Zweikanal-Interleaving-Bitstroms in dem Bitstrom, um die Linkskanal-Daten und die Rechtskanal-Daten zu erhalten.

4. Verfahren nach einem der Ansprüche 1 bis 3, wobei das Verfahren ferner umfasst:
falls das Audiosignal die erste Bedingung nicht erfüllt, wenn das Audiosignal ein Einkanal-Signal ist, Decodieren eines Einkanal-Bitstroms in dem Bitstrom, um Einkanal-Daten des Audiosignals zu erhalten.

5. Verfahren nach einem der Ansprüche 1 bis 4, wobei das Verfahren ferner umfasst:
Erhalten einer Gesamtdatenmenge des Bitstroms;
Decodieren eines Paket-Headers des Bitstroms, um eine Kanalzahl, die Abtastrate und eine Frame-Länge des Audiosignals zu erhalten; und
Bestimmen, basierend auf der Gesamtdatenmenge, der Kanalzahl, der Abtastrate und der Frame-Länge, ob das Audiosignal die erste Bedingung erfüllt.

6. Verfahren nach einem der Ansprüche 1 bis 5, wobei das Verfahren ferner umfasst:
Decodieren eines Bitstroms von Seiteninformationen in dem Bitstrom, um die Seiteninformationen zu erhalten, wobei die Seiteninformationen eine Codierungscodebuch-Kennung umfassen; und
Bestimmen, basierend auf der Codierungscodebuch-Kennung, eines Ziel-Decodierungscodebuchs zum Decodieren aus einer Vielzahl von Decodierungscodebüchern.

7. Verfahren nach Anspruch 6, wobei die Vielzahl von Decodierungscodebüchern mindestens Teile von Decodierungscodebüchern wie folgt umfasst:
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
};
{{11, 0, 5}, {15, 1, 5}, {13, 2, 4}, {13, 3, 4}, {0, 4, 3}, {0, 5, 3}, {0, 6, 3}, {0, 7, 3}, {9, 8, 4}, {9, 9, 4}, {5, 10, 4}, {5, 11, 4}, {14, 12, 4}, {14, 13, 4}, {7, 14, 4}, {7, 15, 4}, {6, 16, 4}, {6, 17, 4}, {3, 18, 4}, {3, 19, 4}, {10, 20, 4}, {10, 21, 4}, {12, 22, 4}, {12, 23, 4}, {2, 24, 4}, {2, 25, 4}, {1, 26, 4}, {1, 27, 4}, {8, 28, 4}, {8, 29, 4}, {4, 30, 4}, {4, 31, 4}
};
{{2, 0, 4}, {2, 1, 4}, {2, 2, 4}, {2, 3, 4}, {1, 4, 4}, {1, 5, 4}, {1, 6, 4}, {1, 7, 4},
{8, 8, 4}, {8, 9, 4}, {8, 10, 4}, {8, 11, 4}, {4, 12, 4}, {4, 13, 4}, {4, 14, 4}, {4, 15, 4}, {0, 16, 2}, {0, 17, 2}, {0, 18, 2}, {0, 19, 2}, {0, 20, 2}, {0, 21, 2}, {0, 22, 2}, {0, 23, 2}, {0, 24, 2}, {0, 25, 2}, {0, 26, 2}, {0, 27, 2}, {0, 28, 2}, {0, 29, 2}, {0, 30, 2}, {0, 31, 2}, {11, 32, 6}, {15, 33, 6}, {14, 34, 5}, {14, 35, 5}, {7, 36, 5}, {7, 37, 5}, {13, 38, 5}, {13, 39, 5}, {12, 40, 4}, {12, 41, 4}, {12, 42, 4}, {12, 43, 4}, {6, 44, 4}, {6, 45, 4}, {6, 46, 4}, {6, 47, 4}, {3, 48, 4}, {3, 49, 4}, {3, 50, 4}, {3, 51, 4}, {5, 52, 4}, {5, 53, 4}, {5, 54, 4}, {5, 55, 4}, {10, 56, 4}, {10, 57, 4}, {10, 58, 4}, {10, 59, 4}, {9, 60, 4}, {9, 61, 4}, {9, 62, 4}, {9, 63, 4}
};
{{11, 0, 7}, {15, 1, 7}, {14, 2, 6}, {14, 3, 6}, {7, 4, 6}, {7, 5, 6}, {13, 6, 6}, {13, 7, 6}, {12, 8, 5}, {12, 9, 5}, {12, 10, 5}, {12, 11, 5}, {6, 12, 5}, {6, 13, 5}, {6, 14, 5}, {6, 15, 5}, {3, 16, 5}, {3, 17, 5}, {3, 18, 5}, {3, 19, 5}, {5, 20, 5}, {5, 21, 5}, {5, 22, 5}, {5, 23, 5}, {10, 24, 5}, {10, 25, 5}, {10, 26, 5}, {10, 27, 5}, {9, 28, 5}, {9, 29, 5}, {9, 30, 5}, {9, 31, 5}, {2, 32, 4}, {2, 33, 4}, {2, 34, 4}, {2, 35, 4}, {2, 36, 4}, {2, 37, 4}, {2, 38, 4}, {2, 39, 4}, {1, 40, 4}, {1, 41, 4}, {1, 42, 4}, {1, 43, 4}, {1, 44, 4}, {1, 45, 4}, {1, 46, 4}, {1, 47, 4}, {8, 48, 4}, {8, 49, 4}, {8, 50, 4}, {8, 51, 4}, {8, 52, 4}, {8, 53, 4}, {8, 54, 4}, {8, 55, 4}, {4, 56, 4}, {4, 57, 4}, {4, 58, 4}, {4, 59, 4}, {4, 60, 4}, {4, 61, 4}, {4, 62, 4}, {4, 63, 4}, {0, 64, 1}, {0, 65, 1}, {0, 66, 1}, {0, 67, 1}, {0, 68, 1}, {0, 69, 1}, {0, 70, 1}, {0, 71, 1}, {0, 72, 1}, {0, 73, 1}, {0, 74, 1}, {0, 75, 1}, {0, 76, 1}, {0, 77, 1}, {0, 78, 1}, {0, 79, 1}, {0, 80, 1}, {0, 81, 1}, {0, 82, 1}, {0, 83, 1}, {0, 84, 1}, {0, 85, 1}, {0, 86, 1}, {0, 87, 1}, {0, 88, 1}, {0, 89, 1}, {0, 90, 1}, {0, 91, 1}, {0, 92, 1}, {0, 93, 1}, {0, 94, 1}, {0, 95, 1}, {0, 96, 1}, {0, 97, 1}, {0, 98, 1}, {0, 99, 1}, {0, 100, 1}, {0, 101, 1}, {0, 102, 1}, {0, 103, 1}, {0, 104, 1}, {0, 105, 1}, {0, 106, 1}, {0, 107, 1}, {0, 108, 1}, {0, 109, 1}, {0, 110, 1}, {0, 111, 1}, {0, 112, 1}, {0, 113, 1}, {0, 114, 1}, {0, 115, 1}, {0, 116, 1}, {0, 117, 1}, {0, 118, 1}, {0, 119, 1}, {0, 120, 1}, {0, 121, 1}, {0, 122, 1}, {0, 123, 1}, {0, 124, 1},
{0, 125, 1}, {0, 126, 1}, {0, 127, 1}
};
{{11, 0, 5}, {15, 1, 5}, {14, 2, 4}, {14, 3, 4}, {0, 4, 3}, {0, 5, 3}, {0, 6, 3}, {0, 7, 3}, {7, 8, 4}, {7, 9, 4}, {9, 10, 4}, {9, 11, 4}, {10, 12, 4}, {10, 13, 4}, {13, 14, 4}, {13, 15, 4}, {3, 16, 4}, {3, 17, 4}, {8, 18, 4}, {8, 19, 4}, {6, 20, 4}, {6, 21, 4}, {12, 22, 4}, {12, 23, 4}, {4, 24, 4}, {4, 25, 4}, {1, 26, 4}, {1, 27, 4}, {2, 28, 4}, {2, 29, 4}, {5, 30, 4}, {5, 31, 4}
};
{{2, 0, 4}, {2, 1, 4}, {5, 2, 4}, {5, 3, 4}, {0, 4, 3}, {0, 5, 3}, {0, 6, 3}, {0, 7, 3}, {10, 8, 5}, {13, 9, 5}, {7, 10, 5}, {14, 11, 5}, {12, 12, 4}, {12, 13, 4}, {3, 14, 4}, {3, 15, 4}, {8, 16, 4}, {8, 17, 4}, {9, 18, 4}, {9, 19, 4}, {6, 20, 4}, {6, 21, 4}, {11, 22, 5}, {15, 23, 5}, {4, 24, 3}, {4, 25, 3}, {4, 26, 3}, {4, 27, 3}, {1, 28, 3}, {1, 29, 3}, {1, 30, 3}, {1, 31, 3}
};
{{4, 0, 4}, {4, 1, 4}, {1, 2, 4}, {1, 3, 4}, {2, 4, 4}, {2, 5, 4}, {5, 6, 4}, {5, 7, 4}, {0, 8, 2}, {0, 9, 2}, {0, 10, 2}, {0, 11, 2}, {0, 12, 2}, {0, 13, 2}, {0, 14, 2}, {0, 15, 2}, {10, 16, 5}, {13, 17, 5}, {7, 18, 5}, {14, 19, 5}, {12, 20, 4}, {12, 21, 4}, {3, 22, 4}, {3, 23, 4}, {8, 24, 4}, {8, 25, 4}, {9, 26, 4}, {9, 27, 4}, {6, 28, 4}, {6, 29, 4}, {11, 30, 5}, {15, 31, 5},
};
{{10, 0, 6}, {13, 1, 6}, {7, 2, 6}, {14, 3, 6}, {12, 4, 5}, {12, 5, 5}, {3, 6, 5}, {3, 7, 5}, {8, 8, 5}, {8, 9, 5}, {9, 10, 5}, {9, 11, 5}, {6, 12, 5}, {6, 13, 5}, {11, 14, 6}, {15, 15, 6}, {4, 16, 4}, {4, 17, 4}, {4, 18, 4}, {4, 19, 4}, {1, 20, 4}, {1, 21, 4}, {1, 22, 4}, {1, 23, 4}, {2, 24, 4}, {2, 25, 4}, {2, 26, 4}, {2, 27, 4}, {5, 28, 4}, {5, 29, 4}, {5, 30, 4}, {5, 31 4}, {0, 32, 1}, {0, 33, 1}, {0, 34, 1}, {0, 35, 1}, {0, 36, 1}, {0, 37, 1}, {0, 38, 1}, {0, 39, 1}, {0, 40, 1}, {0, 41, 1}, {0, 42, 1}, {0, 43, 1}, {0, 44, 1}, {0, 45, 1}, {0, 46, 1}, {0, 47, 1}, {0, 48, 1}, {0, 49, 1}, {0, 50, 1}, {0, 51, 1}, {0, 52, 1}, {0, 53, 1}, {0, 54, 1}, {0, 55, 1}, {0, 56, 1}, {0, 57, 1}, {0, 58, 1}, {0, 59, 1}, {0, 60, 1}, {0, 61, 1}, {0, 62, l},{0, 63, 1}
};
{{4, 0, 4}, {4, 1, 4}, {4, 2, 4}, {4, 3, 4}, {6, 4, 6}, {7, 5, 6}, {5, 6, 5}, {5, 7, 5}, {3, 8, 3}, {3, 9, 3}, {3, 10, 3}, {3, 11, 3}, {3, 12, 3}, {3, 13, 3}, {3, 14, 3}, {3, 15, 3}, {2, 16, 2}, {2, 17, 2}, {2, 18, 2}, {2, 19, 2}, {2, 20, 2}, {2, 21, 2}, {2, 22, 2}, {2, 23, 2}, {2, 24, 2}, {2, 25, 2}, {2, 26, 2}, {2, 27, 2}, {2, 28, 2}, {2, 29, 2}, {2, 30, 2}, {2, 31, 2}, {1, 32, 2}, {1, 33, 2}, {1, 34, 2}, {1, 35, 2}, {1, 36, 2}, {1, 37, 2}, {1, 38, 2}, {1, 39, 2}, {1, 40, 2}, {1, 41, 2}, {1, 42, 2}, {1, 43, 2}, {1, 44, 2}, {1, 45, 2}, {1, 46, 2}, {1, 47, 2}, {0, 48, 2}, {0, 49, 2}, {0, 50, 2}, {0, 51, 2}, {0, 52, 2}, {0, 53, 2}, {0, 54, 2}, {0, 55, 2}, {0, 56, 2}, {0, 57, 2}, {0, 58, 2}, {0, 59, 2}, {0, 60, 2}, {0, 61, 2}, {0, 62, 2}, {0, 63, 2}
};
{{2, 0, 3}, {2, 1, 3}, {2, 2, 3}, {2, 3, 3}, {3, 4, 3}, {3, 5, 3}, {3, 6, 3}, {3, 7, 3}, {5, 8, 4}, {5, 9, 4}, {6, 10, 5}, {7, 11, 5}, {4, 12, 3}, {4, 13, 3}, {4, 14, 3}, {4, 15, 3}, {1, 16, 2}, {1, 17, 2}, {1, 18, 2}, {1, 19, 2}, {1, 20, 2}, {1, 21, 2}, {1, 22, 2}, {1, 23, 2}, {0, 24, 2}, {0, 25, 2}, {0, 26, 2}, {0, 27, 2}, {0, 28, 2}, {0, 29, 2}, {0, 30, 2}, {0, 31, 2}
};
{{0, 0, 1}, {0, 1, 1}, {0, 2, 1}, {0, 3, 1}, {0, 4, 1}, {0, 5, 1}, {0, 6, 1}, {0, 7, 1}, {0, 8, 1}, {0, 9, 1}, {0, 10, 1}, {0, 11, 1}, {0, 12, 1}, {0, 13, 1}, {0, 14, 1}, {0, 15, 1}, {0, 16, 1}, {0, 17, 1}, {0, 18, 1}, {0, 19, 1}, {0, 20, 1}, {0, 21, 1}, {0, 22, 1}, {0, 23, 1}, {0, 24, 1}, {0, 25, 1}, {0, 26, 1}, {0, 27, 1}, {0, 28, 1}, {0, 29, 1}, {0, 30, 1}, {0, 31, 1}, {5, 32, 5}, {5, 33, 5}, {6, 34, 6}, {7, 35, 6}, {4, 36, 4}, {4, 37, 4}, {4, 38, 4}, {4, 39, 4}, {1, 40, 3}, {1, 41, 3}, {1, 42, 3}, {1, 43, 3}, {1, 44, 3}, {1, 45, 3}, {1, 46, 3}, {1, 47, 3}, {2, 48, 3}, {2, 49, 3}, {2, 50, 3}, {2, 51, 3}, {2, 52, 3}, {2, 53, 3}, {2, 54, 3}, {2, 55, 3}, {3, 56, 3}, {3, 57, 3}, {3, 58, 3}, {3, 59, 3}, {3, 60, 3}, {3, 61, 3}, {3, 62, 3}, {3, 63, 3}
}; und
{{0, 0, 3}, {1, 1, 3}, {2, 2, 3}, {3, 3, 3}, {4, 4, 3}, {5, 5, 3}, {6, 6, 3}, {7, 7, 3}
}.

8. Audiocodierungsverfahren, wobei das Verfahren umfasst:
falls ein zu codierendes Audiosignal eine erste Bedingung erfüllt, Codieren von Linkskanal-Daten des Audiosignals in einen Bitstrom und Codieren von Rechtskanal-Daten des Audiosignals in den Bitstrom, wobei die erste Bedingung umfasst, dass das Audiosignal ein Zweikanal-Signal ist, eine Codierbitrate des Audiosignals nicht kleiner als ein Bitratenschwellenwert ist und eine Abtastrate des Audiosignals nicht kleiner als ein Abtastratenschwellenwert ist.

9. Verfahren nach Anspruch 8, wobei das Verfahren ferner umfasst:
falls das Audiosignal die erste Bedingung nicht erfüllt, wenn das Audiosignal ein Zweikanal-Signal ist, Codieren der Linkskanal-Daten und der Rechtskanal-Daten in den Bitstrom in einem verschachtelten Zweikanal-Interleaving-Codierungsschema.

10. Verfahren nach Anspruch 8 oder 9, wobei das Verfahren ferner umfasst:
falls das Audiosignal die erste Bedingung nicht erfüllt, wenn das Audiosignal ein Einkanal-Signal ist, Codieren von Einkanal-Daten des Audiosignals in den Bitstrom.

11. Verfahren nach einem der Ansprüche 8 bis 10, wobei das Codieren der Linkskanal-Daten des Audiosignals in den Bitstrom umfasst:
Erhalten eines Quantisierungsstufen-Messfaktors jedes aus einer Vielzahl von Teilbändern, wobei der Quantisierungsstufen-Messfaktor eine durchschnittliche Anzahl von Bits zum Codieren jedes Spektralwerts in einem entsprechenden Teilband angibt, und die Vielzahl von Teilbändern eine Vielzahl von Teilbändern ist, denen in den Linkskanal-Daten enthaltene quantisierte Spektraldaten zugewiesen sind;
Gruppieren der Vielzahl von Teilbändern in eine Vielzahl von Gruppen von Teilbändern basierend auf den Quantisierungsstufen-Messfaktoren der Vielzahl von Teilbändern, wobei Quantisierungsstufen-Messfaktoren von Teilbändern in einer gleichen Gruppe gleich sind;
Bestimmen, aus einer Vielzahl von Codierungscodebüchern basierend auf einem Quantisierungsstufen-Messfaktor jeder Gruppe von Teilbändern, eines Ziel-Codierungscodebuchs, das jeder Gruppe von Teilbändern entspricht, und Bestimmen eines Bitstroms von Spektralwerten in jeder Gruppe von Teilbändern, wobei das Ziel-Codierungscodebuch ein Codierungscodebuch ist, das zum Codieren von Spektralwerten in einer entsprechenden Gruppe von Teilbändern verwendet wird; und
Codieren, als eine Art von Seiteninformationen der Linkskanal-Daten, einer Kennung des Ziel-Codierungscodebuchs, das jeder Gruppe von Teilbändern entspricht, in den Bitstrom.

12. Verfahren nach Anspruch 11, wobei das Bestimmen, aus einer Vielzahl von Codierungscodebüchern basierend auf einem Quantisierungsstufen-Messfaktor jeder Gruppe von Teilbändern, eines Ziel-Codierungscodebuchs, das jeder Gruppe von Teilbändern entspricht, und das Bestimmen eines Bitstroms von Spektralwerten in jeder Gruppe von Teilbändern umfasst:
für eine beliebige aus der Vielzahl von Gruppen von Teilbändern, falls ein Quantisierungsstufen-Messfaktor der beliebigen Gruppe von Teilbändern ein erster Wert ist, separates Codieren von Spektralwerten in der beliebigen Gruppe von Teilbändern unter Verwendung einer Vielzahl von ersten Codierungscodebüchern in der Vielzahl von Codierungscodebüchern, um eine Vielzahl von ersten Kandidaten-Spektralbitströmen zu erhalten, die eins zu eins der Vielzahl von ersten Codierungscodebüchern entsprechen; und
Bestimmen, als einen Bitstrom der Spektralwerte in der beliebigen Gruppe von Teilbändern, eines ersten Kandidaten-Spektralbitstroms mit einer minimalen Gesamtanzahl von Bits in der Vielzahl von ersten Kandidaten-Spektralbitströmen, und Bestimmen, als ein Ziel-Codierungscodebuch, das der beliebigen Gruppe von Teilbändern entspricht, eines ersten Codierungscodebuchs, das dem ersten Kandidaten-Spektralbitstrom mit der minimalen Gesamtanzahl von Bits entspricht.

13. Verfahren nach Anspruch 12, wobei der erste Wert 1 beträgt; und
das separate Codieren von Spektralwerten in der beliebigen Gruppe von Teilbändern unter Verwendung einer Vielzahl von ersten Codierungscodebüchern in der Vielzahl von Codierungscodebüchern umfasst:
Kombinieren von jeweils vier Spektralwerten in der beliebigen Gruppe von Teilbändern zu einer Binärzahl; und
separates Codieren einer durch die Binärzahl dargestellten Dezimalzahl unter Verwendung der Vielzahl von ersten Codierungscodebüchern, wobei die Vielzahl von ersten Codierungscodebüchern mindestens Teile von Decodierungscodebüchern wie folgt umfasst:
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
};
{{0, 1, 3}, {1, 13, 4}, {2, 12, 4}, {3, 9, 4}, {4, 15, 4}, {5, 5, 4}, {6, 8, 4}, {7, 7, 4}, {8, 14, 4}, {9, 4, 4}, {10, 10, 4}, {11, 0, 5}, {12, 11, 4}, {13, 1, 4}, {14, 6, 4}, {15, 1, 5} };
{{0, 1, 2}, {1, 1, 4}, {2, 0, 4}, {3, 12, 4}, {4, 3, 4}, {5, 13, 4}, {6, 11, 4}, {7, 18, 5}, {8, 2, 4}, {9, 15, 4}, {10, 14, 4}, {11, 32, 6}, {12, 10, 4}, {13, 19, 5}, {14, 17, 5}, {15, 33, 6} }; und
{{0, 1, 1}, {1, 5, 4}, {2, 4, 4}, {3, 4, 5}, {4, 7, 4}, {5, 5, 5}, {6, 3, 5}, {7, 2, 6}, {8, 6, 4}, {9, 7, 5}, {10, 6, 5}, {11, 0, 7}, {12, 2, 5}, {13, 3, 6}, {14, 1, 6}, {15, 1, 7}
}.

14. Verfahren nach einem der Ansprüche 11 bis 13, wobei das Bestimmen, aus einer Vielzahl von Codierungscodebüchern basierend auf einem Quantisierungsstufen-Messfaktor jeder Gruppe von Teilbändern, eines Ziel-Codierungscodebuchs, das jeder Gruppe von Teilbändern entspricht, und das Bestimmen eines Bitstroms von Spektralwerten in jeder Gruppe von Teilbändern umfasst:
für eine beliebige aus der Vielzahl von Gruppen von Teilbändern, falls ein Quantisierungsstufen-Messfaktor der beliebigen Gruppe von Teilbändern ein zweiter Wert ist, separates Codieren von Spektralwerten in der beliebigen Gruppe von Teilbändern unter Verwendung einer Vielzahl von zweiten Codierungscodebüchern in der Vielzahl von Codierungscodebüchern, um eine Vielzahl von zweiten Kandidaten-Spektralbitströmen zu erhalten, die eins zu eins der Vielzahl von zweiten Codierungscodebüchern entsprechen; und
Bestimmen, als einen Bitstrom der Spektralwerte in der beliebigen Gruppe von Teilbändern, eines zweiten Kandidaten-Spektralbitstroms mit einer minimalen Gesamtanzahl von Bits in der Vielzahl von zweiten Kandidaten-Spektralbitströmen, und Bestimmen, als ein Ziel-Codierungscodebuch, das der beliebigen Gruppe von Teilbändern entspricht, eines zweiten Codierungscodebuchs, das dem zweiten Kandidaten-Spektralbitstrom mit der minimalen Gesamtanzahl von Bits entspricht.

15. Vorrichtung, wobei die Vorrichtung einen Speicher und einen Prozessor umfasst;
der Speicher konfiguriert ist, um ein Computerprogramm zu speichern, wobei das Computerprogramm Programmanweisungen umfasst; und
der Prozessor konfiguriert ist, um das Computerprogramm aufzurufen, um das Audiodecodierungsverfahren nach einem der Ansprüche 1 bis 7 zu implementieren oder um das Audiocodierungsverfahren nach einem der Ansprüche 8 bis 14 zu implementieren.

## Revendications

1. Procédé de décodage audio, dans lequel le procédé comprend :
si un signal audio à décoder remplit une première condition, l'obtention d'un mode de décodage de canal, dans lequel la première condition comprend le fait que le signal audio est un signal à double canal, qu'un débit binaire de codage du signal audio n'est pas inférieur à un seuil de débit binaire, et qu'un taux d'échantillonnage du signal audio n'est pas inférieur à un seuil de taux d'échantillonnage ;
si le mode de décodage de canal est un mode de décodage de canal gauche, le décodage d'un flux binaire de canal gauche dans un flux binaire, pour obtenir des données de canal gauche du signal audio ; et la duplication des données de canal gauche vers un canal droit ; et
si le mode de décodage de canal est un mode de décodage de canal droit, le décodage d'un flux binaire de canal droit dans le flux binaire, pour obtenir des données de canal droit du signal audio ; et la duplication des données de canal droit vers un canal gauche.

2. Procédé selon la revendication 1, dans lequel le procédé comprend en outre :
si le mode de décodage de canal n'est ni le mode de décodage de canal gauche, ni le mode de décodage de canal droit, le décodage du flux binaire de canal gauche et du flux binaire de canal droit, pour obtenir les données de canal gauche et les données de canal droit.

3. Procédé selon la revendication 1 ou 2, dans lequel le procédé comprend en outre : si le signal audio ne remplit pas la première condition, lorsque le signal audio est un signal à double canal, le décodage d'un flux binaire entrelacé à double canal dans le flux binaire, pour obtenir les données de canal gauche et les données de canal droit.

4. Procédé selon l'une quelconque des revendications 1 à 3, dans lequel le procédé comprend en outre :
si le signal audio ne remplit pas la première condition, lorsque le signal audio est un signal monocanal, le décodage d'un flux binaire monocanal dans le flux binaire, pour obtenir des données monocanales du signal audio.

5. Procédé selon l'une quelconque des revendications 1 à 4, dans lequel le procédé comprend en outre :
l'obtention d'une quantité totale de données du flux binaire ;
le décodage d'un en-tête de paquet du flux binaire, pour obtenir un numéro de canal, le taux d'échantillonnage, et une longueur de trame du signal audio ; et le fait de déterminer, en fonction de la quantité totale de données, du numéro de canal, du taux d'échantillonnage, et de la longueur de trame, si le signal audio remplit la première condition.

6. Procédé selon l'une quelconque des revendications 1 à 5, dans lequel le procédé comprend en outre :
le décodage d'un flux binaire d'informations secondaires dans le flux binaire, pour obtenir les informations secondaires, dans lequel les informations secondaires comprennent un identifiant de livre de codes de codage ; et
la détermination, en fonction de l'identifiant de livre de codes de codage, d'un livre de codes de décodage cible pour le décodage parmi une pluralité de livres de codes de décodage.

7. Procédé selon la revendication 6, dans lequel la pluralité de livres de codes de décodage comprend au moins des parties de livres de codes de décodage comme suit :
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
} ;
{{11, 0, 5}, {15, 1, 5}, {13, 2, 4}, {13, 3, 4}, {0, 4, 3}, {0, 5, 3}, {0, 6, 3}, {0, 7, 3}, {9, 8, 4}, {9, 9, 4}, {5, 10, 4}, {5, 11, 4}, {14, 12, 4}, {14, 13, 4}, {7, 14, 4}, {7, 15, 4}, {6, 16, 4}, {6, 17, 4}, {3, 18, 4}, {3, 19, 4}, {10, 20, 4}, {10, 21, 4}, {12, 22, 4}, {12, 23, 4}, {2, 24, 4}, {2, 25, 4}, {1, 26, 4}, {1, 27, 4}, {8, 28, 4}, {8, 29, 4}, {4, 30, 4}, {4, 31, 4}
} ;
{{2, 0, 4}, {2, 1, 4}, {2, 2, 4}, {2, 3, 4}, {1, 4, 4}, {1, 5, 4}, {1, 6, 4}, {1, 7, 4},
{8, 8, 4}, {8, 9, 4}, {8, 10, 4}, {8, 11, 4}, {4, 12, 4}, {4, 13, 4}, {4, 14, 4}, {4, 15, 4}, {0, 16, 2}, {0, 17, 2}, {0, 18, 2}, {0, 19, 2}, {0, 20, 2}, {0, 21, 2}, {0, 22, 2}, {0, 23, 2}, {0, 24, 2}, {0, 25, 2}, {0, 26, 2}, {0, 27, 2}, {0, 28, 2}, {0, 29, 2}, {0, 30, 2}, {0, 31, 2}, {11, 32, 6}, {15, 33, 6}, {14, 34, 5}, {14, 35, 5}, {7, 36, 5}, {7, 37, 5}, {13, 38, 5}, {13, 39, 5}, {12, 40, 4}, {12, 41, 4}, {12, 42, 4}, {12, 43, 4}, {6, 44, 4}, {6, 45, 4}, {6, 46, 4}, {6, 47, 4}, {3, 48, 4}, {3, 49, 4}, {3, 50, 4}, {3, 51, 4}, {5, 52, 4}, {5, 53, 4}, {5, 54, 4}, {5, 55, 4}, {10, 56, 4}, {10, 57, 4}, {10, 58, 4}, {10, 59, 4}, {9, 60, 4}, {9, 61, 4}, {9, 62, 4}, {9, 63, 4}
} ;
{{11, 0, 7}, {15, 1, 7}, {14, 2, 6}, {14, 3, 6}, {7, 4, 6}, {7, 5, 6}, {13, 6, 6}, {13, 7, 6}, {12, 8, 5}, {12, 9, 5}, {12, 10, 5}, {12, 11, 5}, {6, 12, 5}, {6, 13, 5}, {6, 14, 5}, {6, 15, 5}, {3, 16, 5}, {3, 17, 5}, {3, 18, 5}, {3, 19, 5}, {5, 20, 5}, {5, 21, 5}, {5, 22, 5}, {5, 23, 5}, {10, 24, 5}, {10, 25, 5}, {10, 26, 5}, {10, 27, 5}, {9, 28, 5}, {9, 29, 5}, {9, 30, 5}, {9, 31, 5}, {2, 32, 4}, {2, 33, 4}, {2, 34, 4}, {2, 35, 4}, {2, 36, 4}, {2, 37, 4}, {2, 38, 4}, {2, 39, 4}, {1, 40, 4}, {1, 41, 4}, {1, 42, 4}, {1, 43, 4}, {1, 44, 4}, {1, 45, 4}, {1, 46, 4}, {1, 47, 4}, {8, 48, 4}, {8, 49, 4}, {8, 50, 4}, {8, 51, 4}, {8, 52, 4}, {8, 53, 4}, {8, 54, 4}, {8, 55, 4}, {4, 56, 4}, {4, 57, 4}, {4, 58, 4}, {4, 59, 4}, {4, 60, 4}, {4, 61, 4}, {4, 62, 4}, {4, 63, 4}, {0, 64, 1}, {0, 65, 1}, {0, 66, 1}, {0, 67, 1}, {0, 68, 1}, {0, 69, 1}, {0, 70, 1}, {0, 71, 1}, {0, 72, 1}, {0, 73, 1}, {0, 74, 1}, {0, 75, 1}, {0, 76, 1}, {0, 77, 1}, {0, 78, 1}, {0, 79, 1}, {0, 80, 1}, {0, 81, 1}, {0, 82, 1}, {0, 83, 1}, {0, 84, 1}, {0, 85, 1}, {0, 86, 1}, {0, 87, 1}, {0, 88, 1}, {0, 89, 1}, {0, 90, 1}, {0, 91, 1}, {0, 92, 1}, {0, 93, 1}, {0, 94, 1}, {0, 95, 1}, {0, 96, 1}, {0, 97, 1}, {0, 98, 1}, {0, 99, 1}, {0, 100, 1}, {0, 101, 1}, {0, 102, 1}, {0, 103, 1}, {0, 104, 1}, {0, 105, 1}, {0, 106, 1}, {0, 107, 1}, {0, 108, 1}, {0, 109, 1}, {0, 110, 1}, {0, 111, 1}, {0, 112, 1}, {0, 113, 1}, {0, 114, 1}, {0, 115, 1}, {0, 116, 1}, {0, 117, 1}, {0, 118, 1}, {0, 119, 1}, {0, 120, 1}, {0, 121, 1}, {0, 122, 1}, {0, 123, 1}, {0, 124, 1},
{0, 125, 1}, {0, 126, 1}, {0, 127, 1}
} ;
{{11, 0, 5}, {15, 1, 5}, {14, 2, 4}, {14, 3, 4}, {0, 4, 3}, {0, 5, 3}, {0, 6, 3}, {0, 7, 3}, {7, 8, 4}, {7, 9, 4}, {9, 10, 4}, {9, 11, 4}, {10, 12, 4}, {10, 13, 4}, {13, 14, 4}, {13, 15, 4}, {3, 16, 4}, {3, 17, 4}, {8, 18, 4}, {8, 19, 4}, {6, 20, 4}, {6, 21, 4}, {12, 22, 4}, {12, 23, 4}, {4, 24, 4}, {4, 25, 4}, {1, 26, 4}, {1, 27, 4}, {2, 28, 4}, {2, 29, 4}, {5, 30, 4}, {5, 31, 4}
} ;
{{2, 0, 4}, {2, 1, 4}, {5, 2, 4}, {5, 3, 4}, {0, 4, 3}, {0, 5, 3}, {0, 6, 3}, {0, 7, 3}, {10, 8, 5}, {13, 9, 5}, {7, 10, 5}, {14, 11, 5}, {12, 12, 4}, {12, 13, 4}, {3, 14, 4}, {3, 15, 4}, {8, 16, 4}, {8, 17, 4}, {9, 18, 4}, {9, 19, 4}, {6, 20, 4}, {6, 21, 4}, {11, 22, 5}, {15, 23, 5}, {4, 24, 3}, {4, 25, 3}, {4, 26, 3}, {4, 27, 3}, {1, 28, 3}, {1, 29, 3}, {1, 30, 3}, {1, 31, 3}
} ;
{{4, 0, 4}, {4, 1, 4}, {1, 2, 4}, {1, 3, 4}, {2, 4, 4}, {2, 5, 4}, {5, 6, 4}, {5, 7, 4}, {0, 8, 2}, {0, 9, 2}, {0, 10, 2}, {0, 11, 2}, {0, 12, 2}, {0, 13, 2}, {0, 14, 2}, {0, 15, 2}, {10, 16, 5}, {13, 17, 5}, {7, 18, 5}, {14, 19, 5}, {12, 20, 4}, {12, 21, 4}, {3, 22, 4}, {3, 23, 4}, {8, 24, 4}, {8, 25, 4}, {9, 26, 4}, {9, 27, 4}, {6, 28, 4}, {6, 29, 4}, {11, 30, 5}, {15, 31, 5},
} ;
{{10, 0, 6}, {13, 1, 6}, {7, 2, 6}, {14, 3, 6}, {12, 4, 5}, {12, 5, 5}, {3, 6, 5}, {3, 7, 5}, {8, 8, 5}, {8, 9, 5}, {9, 10, 5}, {9, 11, 5}, {6, 12, 5}, {6, 13, 5}, {11, 14, 6}, {15, 15, 6}, {4, 16, 4}, {4, 17, 4}, {4, 18, 4}, {4, 19, 4}, {1, 20, 4}, {1, 21, 4}, {1, 22, 4}, {1, 23, 4}, {2, 24, 4}, {2, 25, 4}, {2, 26, 4}, {2, 27, 4}, {5, 28, 4}, {5, 29, 4}, {5, 30, 4}, {5, 31, 4}, {0, 32, 1}, {0, 33, 1}, {0, 34, 1}, {0, 35, 1}, {0, 36, 1}, {0, 37, 1}, {0, 38, 1}, {0, 39, 1}, {0, 40, 1}, {0, 41, 1}, {0, 42, 1}, {0, 43, 1}, {0, 44, 1}, {0, 45, 1}, {0, 46, 1}, {0, 47, 1}, {0, 48, 1}, {0, 49, 1}, {0, 50, 1}, {0, 51, 1}, {0, 52, 1}, {0, 53, 1}, {0, 54, 1}, {0, 55, 1}, {0, 56, 1}, {0, 57, 1}, {0, 58, 1}, {0, 59, 1}, {0, 60, 1}, {0, 61, 1}, {0, 62, 1}, {0, 63, 1}
} ;
{{4, 0, 4}, {4, 1, 4}, {4, 2, 4}, {4, 3, 4}, {6, 4, 6}, {7, 5, 6}, {5, 6, 5}, {5, 7, 5}, {3, 8, 3}, {3, 9, 3}, {3, 10, 3}, {3, 11, 3}, {3, 12, 3}, {3, 13, 3}, {3, 14, 3}, {3, 15, 3}, {2, 16, 2}, {2, 17, 2}, {2, 18, 2}, {2, 19, 2}, {2, 20, 2}, {2, 21, 2}, {2, 22, 2}, {2, 23, 2}, {2, 24, 2}, {2, 25, 2}, {2, 26, 2}, {2, 27, 2}, {2, 28, 2}, {2, 29, 2}, {2, 30, 2}, {2, 31, 2}, {1, 32, 2}, {1, 33, 2}, {1, 34, 2}, {1, 35, 2}, {1, 36, 2}, {1, 37, 2}, {1, 38, 2}, {1, 39, 2}, {1, 40, 2}, {1, 41, 2}, {1, 42, 2}, {1, 43, 2}, {1, 44, 2}, {1, 45, 2}, {1, 46, 2}, {1, 47, 2}, {0, 48, 2}, {0, 49, 2}, {0, 50, 2}, {0, 51, 2}, {0, 52, 2}, {0, 53, 2}, {0, 54, 2}, {0, 55, 2}, {0, 56, 2}, {0, 57, 2}, {0, 58, 2}, {0, 59, 2}, {0, 60, 2}, {0, 61, 2}, {0, 62, 2}, {0, 63, 2}
} ;
{{2, 0, 3}, {2, 1, 3}, {2, 2, 3}, {2, 3, 3}, {3, 4, 3}, {3, 5, 3}, {3, 6, 3}, {3, 7, 3}, {5, 8, 4}, {5, 9, 4}, {6, 10, 5}, {7, 11, 5}, {4, 12, 3}, {4, 13, 3}, {4, 14, 3}, {4, 15, 3}, {1, 16, 2}, {1, 17, 2}, {1, 18, 2}, {1, 19, 2}, {1, 20, 2}, {1, 21, 2}, {1, 22, 2}, {1, 23, 2}, {0, 24, 2}, {0, 25, 2}, {0, 26, 2}, {0, 27, 2}, {0, 28, 2}, {0, 29, 2}, {0, 30, 2}, {0, 31, 2}
} ;
{{0, 0, 1}, {0, 1, 1}, {0, 2, 1}, {0, 3, 1}, {0, 4, 1}, {0, 5, 1}, {0, 6, 1}, {0, 7, 1}, {0, 8, 1}, {0, 9, 1}, {0, 10, 1}, {0, 11, 1}, {0, 12, 1}, {0, 13, 1}, {0, 14, 1}, {0, 15, 1}, {0, 16, 1}, {0, 17, 1}, {0, 18, 1}, {0, 19, 1}, {0, 20, 1}, {0, 21, 1}, {0, 22, 1}, {0, 23, 1}, {0, 24, 1}, {0, 25, 1}, {0, 26, 1}, {0, 27, 1}, {0, 28, 1}, {0, 29, 1}, {0, 30, 1}, {0, 31, 1}, {5, 32, 5}, {5, 33, 5}, {6, 34, 6}, {7, 35, 6}, {4, 36, 4}, {4, 37, 4}, {4, 38, 4}, {4, 39, 4}, {1, 40, 3}, {1, 41, 3}, {1, 42, 3}, {1, 43, 3}, {1, 44, 3}, {1, 45, 3}, {1, 46, 3}, {1, 47, 3}, {2, 48, 3}, {2, 49, 3}, {2, 50, 3}, {2, 51, 3}, {2, 52, 3}, {2, 53, 3}, {2, 54, 3}, {2, 55, 3}, {3, 56, 3}, {3, 57, 3}, {3, 58, 3}, {3, 59, 3}, {3, 60, 3}, {3, 61, 3}, {3, 62, 3}, {3, 63, 3}
} ; et
{{0, 0, 3}, {1, 1, 3}, {2, 2, 3}, {3, 3, 3}, {4, 4, 3}, {5, 5, 3}, {6, 6, 3}, {7, 7, 3}
}.

8. Procédé de codage audio, dans lequel le procédé comprend :
si un signal audio à coder remplit une première condition, le codage de données de canal gauche du signal audio dans un flux binaire, et le codage de données de canal droit du signal audio dans le flux binaire, dans lequel la première condition comprend le fait que le signal audio est un signal à double canal, qu'un débit binaire de codage du signal audio n'est pas inférieur à un seuil de débit binaire, et qu'un taux d'échantillonnage du signal audio n'est pas inférieur à un seuil de taux d'échantillonnage.

9. Procédé selon la revendication 8, dans lequel le procédé comprend en outre : si le signal audio ne remplit pas la première condition, lorsque le signal audio est un signal à double canal, le codage des données de canal gauche et des données de canal droit dans le flux binaire dans un schéma de codage d'entrelacement à double canal.

10. Procédé selon la revendication 8 ou 9, dans lequel le procédé comprend en outre : si le signal audio ne remplit pas la première condition, lorsque le signal audio est un signal monocanal, le codage de données monocanales du signal audio dans le flux binaire.

11. Procédé selon l'une quelconque des revendications 8 à 10, dans lequel le codage des données de canal gauche du signal audio dans le flux binaire comprend :
l'obtention d'un facteur de mesure de niveau de quantification de chacune parmi une pluralité de sous-bandes, dans lequel le facteur de mesure de niveau de quantification indique un nombre moyen de bits permettant de coder chaque valeur spectrale dans une sous-bande correspondante, et la pluralité de sous-bandes est une pluralité de sous-bandes auxquelles des données de spectre quantifiées comprises dans les données de canal gauche sont attribuées ;
le regroupement de la pluralité de sous-bandes dans une pluralité de groupes de sous-bandes en fonction des facteurs de mesure de niveau de quantification de la pluralité de sous-bandes, dans lequel des facteurs de mesure de niveau de quantification de sous-bandes dans un même groupe sont les mêmes ;
la détermination, parmi une pluralité de livres de codes de codage en fonction d'un facteur de mesure de niveau de quantification de chaque groupe de sous-bandes, d'un livre de codes de codage cible correspondant à chaque groupe de sous-bandes, et la détermination d'un flux binaire de valeurs spectrales dans chaque groupe de sous-bandes, dans lequel le livre de codes de codage cible est un livre de codes de codage utilisé pour coder des valeurs spectrales dans un groupe correspondant de sous-bandes ; et
le codage, en tant que type d'informations secondaires des données de canal gauche, d'un identifiant du livre de codes de codage cible correspondant à chaque groupe de sous-bandes dans le flux binaire.

12. Procédé selon la revendication 11, dans lequel la détermination, parmi une pluralité de livres de codes de codage en fonction d'un facteur de mesure de niveau de quantification de chaque groupe de sous-bandes, d'un livre de codes de codage cible correspondant à chaque groupe de sous-bandes, et la détermination d'un flux binaire de valeurs spectrales dans chaque groupe de sous-bandes comprend :
pour l'un quelconque parmi la pluralité de groupes de sous-bandes, si un facteur de mesure de niveau de quantification du groupe quelconque de sous-bandes est une première valeur, le codage séparé de valeurs spectrales dans le groupe quelconque de sous-bandes en utilisant une pluralité de premiers livres de codes de codage dans la pluralité de livres de codes de codage, pour obtenir une pluralité de premiers flux binaires spectraux candidats qui sont en correspondance biunivoque avec la pluralité de premiers livres de codes de codage ; et
la détermination, en tant que flux binaire des valeurs spectrales dans le groupe quelconque de sous-bandes, d'un premier flux binaire spectral candidat avec un nombre total minimal de bits dans la pluralité de premiers flux binaires spectraux candidats, et la détermination, en tant que livre de codes de codage cible correspondant au groupe quelconque de sous-bandes, d'un premier livre de codes de codage correspondant au premier flux binaire spectral candidat avec le nombre total minimal de bits.

13. Procédé selon la revendication 12, dans lequel la première valeur vaut 1 ; et
le codage de manière séparée de valeurs spectrales dans le groupe quelconque de sous-bandes en utilisant une pluralité de premiers livres de codes de codage dans la pluralité de livres de codes de codage comprend :
la combinaison de toutes les quatre valeurs spectrales dans le groupe quelconque de sous-bandes en un nombre binaire ; et
le codage de manière séparée, en utilisant la pluralité de premiers livres de codes de codage, d'un nombre décimal représenté par le nombre binaire, dans lequel la pluralité de premiers livres de codes de codage comprend au moins des parties de livres de codes de décodage comme suit :
{{0, 0, 4}, {1, 1, 4}, {2, 2, 4}, {3, 3, 4}, {4, 4, 4}, {5, 5, 4}, {6, 6, 4}, {7, 7, 4},
{8, 8, 4}, {9, 9, 4}, {10, 10, 4}, {11, 11, 4}, {12, 12, 4}, {13, 13, 4}, {14, 14, 4}, {15, 15, 4}
} ;
{{0, 1, 3}, {1, 13, 4}, {2, 12, 4}, {3, 9, 4}, {4, 15, 4}, {5, 5, 4}, {6, 8, 4}, {7, 7, 4}, {8, 14, 4}, {9, 4, 4}, {10, 10, 4}, {11, 0, 5}, {12, 11, 4}, {13, 1, 4}, {14, 6, 4}, {15, 1, 5} } ;
{{0, 1, 2}, {1, 1, 4}, {2, 0, 4}, {3, 12, 4}, {4, 3, 4}, {5, 13, 4}, {6, 11, 4}, {7, 18, 5}, {8, 2, 4}, {9, 15, 4}, {10, 14, 4}, {11, 32, 6}, {12, 10, 4}, {13, 19, 5}, {14, 17, 5}, {15, 33, 6}
} ; et
{{0, 1, 1}, {1, 5, 4}, {2, 4, 4}, {3, 4, 5}, {4, 7, 4}, {5, 5, 5}, {6, 3, 5}, {7, 2, 6},
{8, 6, 4}, {9, 7, 5}, {10, 6, 5}, {11, 0, 7}, {12, 2, 5}, {13, 3, 6}, {14, 1, 6}, {15, 1, 7} }.

14. Procédé selon l'une quelconque des revendications 11 à 13, dans lequel la détermination, parmi une pluralité de livres de codes de codage en fonction d'un facteur de mesure de niveau de quantification de chaque groupe de sous-bandes, d'un livre de codes de codage cible correspondant à chaque groupe de sous-bandes, et la détermination d'un flux binaire de valeurs spectrales dans chaque groupe de sous-bandes comprennent :
pour l'un quelconque parmi la pluralité de groupes de sous-bandes, si un facteur de mesure de niveau de quantification du groupe quelconque de sous-bandes est une seconde valeur, le codage de manière séparée de valeurs spectrales dans le groupe quelconque de sous-bandes en utilisant une pluralité de seconds livres de codes de codage dans la pluralité de livres de codes de codage, pour obtenir une pluralité de seconds flux binaires spectraux candidats qui sont en correspondance biunivoque avec la pluralité de seconds livres de codes de codage ; et
la détermination, en tant que flux binaire des valeurs spectrales dans le groupe quelconque de sous-bandes, d'un second flux binaire spectral candidat avec un nombre total minimal de bits dans la pluralité de seconds flux binaires spectraux candidats, et la détermination, en tant que livre de codes de codage cible correspondant au groupe quelconque de sous-bandes, d'un second livre de codes de codage correspondant au second flux binaire spectral candidat avec le nombre total minimal de bits.

15. Dispositif, dans lequel le dispositif comprend une mémoire et un processeur ;
la mémoire est configurée pour stocker un programme informatique, dans lequel le programme informatique comprend des instructions de programme ; et
le processeur est configuré pour appeler le programme informatique, pour mettre en œuvre le procédé de décodage audio selon l'une quelconque des revendications 1 à 7 ou pour mettre en œuvre le procédé de codage audio selon l'une quelconque des revendications 8 à 14.
